(19) Europäisches Patentamt
European Patent Office
Office européen des brevets

(11) **EP 4 418 309 A1**

(12) **EUROPEAN PATENT APPLICATION**
published in accordance with Art. 153(4) EPC

(43) Date of publication:
**21.08.2024 Bulletin 2024/34**

(21) Application number: **22881047.9**

(22) Date of filing: **12.10.2022**

(51) International Patent Classification (IPC):
*H01L 21/363* (2006.01)   *C23C 14/08* (2006.01)
*H01L 21/20* (2006.01)   *H01L 21/336* (2006.01)
*H01L 21/66* (2006.01)   *H01L 29/786* (2006.01)

(52) Cooperative Patent Classification (CPC):
**C23C 14/08; H01L 21/02107; H01L 21/20;**
**H01L 22/00; H01L 29/66477; H01L 29/786**

(86) International application number:
**PCT/JP2022/038044**

(87) International publication number:
**WO 2023/063352 (20.04.2023 Gazette 2023/16)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **14.10.2021   JP 2021169157**
**29.03.2022   JP 2022053861**

(71) Applicant: **Idemitsu Kosan Co., Ltd.**
**Tokyo 100-8321 (JP)**

(72) Inventors:
• **YAMAGUCHI, Koji**
**1008321 Tokyo (JP)**
• **TSURUMA, Yuki**
**1008321 Tokyo (JP)**
• **KAWASHIMA, Emi**
**1008321 Tokyo (JP)**
• **INOUE, Kazuyoshi**
**1008321 Tokyo (JP)**

(74) Representative: **Gille Hrabal**
**Partnerschaftsgesellschaft mbB**
**Patentanwälte**
**Brucknerstraße 20**
**40593 Düsseldorf (DE)**

(54) **CRYSTALLINE OXIDE THIN FILM, METHOD FOR PRODUCING SAME, THIN FILM TRANSISTOR, AND METHOD FOR PRODUCING SAME**

(57)     Provided is a crystalline oxide thin film including In as a main component, wherein 50% or more of Fourier transform images obtained by subjecting each of lattice images in a plurality of image regions extracted from a transmission electron microscope (TEM) image of a cross-section of the crystalline oxide thin film to two-dimensional Fourier transform (FFT) processing exhibit any one of plane orientations selected from (100), (110), (111), (211), (411), (125), (210), (310), and (320).

Fig. 1

**Description**

Technical Field

The present invention relates to a crystalline oxide thin film and a method for producing the same, and a thin film transistor and a method for producing the same.

Background Art

A thin film transistor (TFT) using a crystalline oxide thin film as a channel layer is known (see Patent Literatures 1 and 2).

For example, in Patent Literature 1, when an oxide semiconductor including an In element as a main component is sputtered to form a film while water is introduced, a high mobility characteristic is obtained in a TFT using the oxide semiconductor.

In addition, in Patent Literature 2, when the composition of a crystalline oxide thin film including an In element as a main component is set to include a Ga element and a Sm element, a satisfactory mobility is obtained in a TFT device even without introduction of water at the time of the formation of the thin film.

Related Art Documents

Patent Documents

[Patent Document 1] JP 5491258 B2
[Patent Document 2] JP 6853421 B2

Summary of the Invention

However, even with the technologies of Patent Literatures 1 and 2, the improvement in TFT characteristics is not necessarily sufficient, and there is room for improvement.

In the technology of Patent Literature 1, a threshold voltage (Vth) is liable to be fluctuated when a voltage is applied for a predetermined period of time, which may cause problems in terms of reliability.

In addition, in the technologies of Patent Literatures 1 and 2, crystallization progresses in an oxide thin film before an annealing step, which hinders satisfactory crystal growth in the annealing step, and the improving effect on the mobility may not be sufficiently obtained.

An object of the present invention is to provide a crystalline oxide thin film, which exhibits a satisfactory mobility and provides high reliability when applied to a TFT. In addition, another object of the present invention is to provide a thin film transistor including the crystalline oxide thin film and a method for producing the same.

According to the present invention, the following crystalline oxide thin film is provided.

1. A crystalline oxide thin film including In as a main component,
wherein 50% or more of Fourier transform images obtained by subjecting each of lattice images in a plurality of image regions extracted from a transmission electron microscope (TEM) image of a cross-section of the crystalline oxide thin film to two-dimensional Fourier transform (FFT) processing exhibit any one of plane orientations selected from (100), (110), (111), (211), (411), (125), (210), (310), and (320).
2. The crystalline oxide thin film according to 1,

wherein, in each of the Fourier transform images exhibiting any one of the plane orientations selected from (100), (110), (111), (211), (411), (125), (210), (310), and (320) acquired in the plurality of image regions,
when a size of a frequency region from central coordinates of the Fourier transform image of a reciprocal lattice point P1 selected from bright spots located on a coordinate axis extending from the central coordinates in a normal direction with respect to a principal surface of the crystalline oxide thin film is represented by an interplanar spacing d1 in the normal direction,
when a size of a frequency region from the central coordinates of the Fourier transform image of a reciprocal lattice point P2 selected from bright spots located on a coordinate axis extending from the central coordinates in a direction parallel to the principal surface of the crystalline oxide thin film is represented by an interplanar spacing d2 in a plane direction, and

when Miller indices of the reciprocal lattice point P1 are represented by $(h_1, k_1, l_1)$ and Miller indices of the reciprocal lattice point P2 are represented by $(h_2, k_2, l_2)$,

an average $\varepsilon_{aver}$ of each of lattice distortions $\varepsilon$ in the plurality of image regions calculated by the following formula (3) from a lattice constant "a" in the normal direction calculated by the following formula (1) and a lattice constant "b" in the plane direction calculated by the following formula (2) satisfies $1.0 < \varepsilon_{aver} < 1.1$.

$$\text{Lattice constant "a" in normal direction} = \sqrt{(h_1^2 + k_1^2 + h_1^2)} \times d1 \cdots \text{(Formula (1))}$$

$$\text{Lattice constant "b" in plane direction} = \sqrt{(h_2^2 + k_2^2 + h_2^2)} \times d2 \cdots \text{(Formula (2))}$$

$$\varepsilon = \frac{b}{a} \qquad \cdots \text{(Formula (3))}$$

3. The crystalline oxide thin film according to 1 or 2, wherein the crystalline oxide thin film has a thickness of 3 nm or more and less than 50 nm.

4. The crystalline oxide thin film according to any one of 1 to 3, wherein the crystalline oxide thin film has a short-side length of less than 50 $\mu$m.

5. The crystalline oxide thin film according to any one of 1 to 4, wherein the crystalline oxide thin film has an average spacing D between crystal grain boundaries of 0.01 $\mu$m or more and 2 $\mu$m or less.

6. The crystalline oxide thin film according to any one of 1 to 5, wherein the crystalline oxide thin film includes In in an amount of 62 at% or more.

7. The crystalline oxide thin film according to any one of 1 to 6, which further includes one or more kinds of elements selected from the group consisting of H, B, C, N, O, F, Mg, Al, Si, O, S, Cl, Ar, Ca, Sc, Ti, V, Cr, Mn, Fe, Co, Ni, Cu, Zn, Ga, Ge, Y, Zr, Nb, Mo, Tc, Ru, Rh, Pd, Ag, Cd, Sn, Sb, Cs, Ba, Ln, Hf, Ta, W, Re, Os, Ir, Pt, Au, Pb, and Bi.

8. A method for producing the crystalline oxide thin film according to any one of 1 to 7, including subjecting an oxide thin film formed on a support to annealing treatment at a temperature of more than 300°C under an atmospheric atmosphere.

9. The method for producing the crystalline oxide thin film according to 8, wherein the oxide thin film subjected to the annealing treatment has a thickness of 3 nm or more and less than 50 nm.

10. The method for producing the crystalline oxide thin film according to 8 or 9, wherein the oxide thin film subjected to the annealing treatment has a short-side length of less than 50 $\mu$m.

11. A thin film transistor including the crystalline oxide thin film according to any one of 1 to 7.

12. The thin film transistor according to 11, wherein the thin film transistor includes a buffer layer and a channel layer, wherein the channel layer is the crystalline oxide thin film, and wherein the thin film transistor includes a gate insulating film and a gate electrode on a side opposite to the buffer layer when seen from the channel layer in this order from the channel layer side.

13. A method for producing the thin film transistor according to 11 or 12, including the steps of: forming an oxide thin film on a substrate; subjecting the oxide thin film to annealing treatment at a temperature of more than 300°C under an atmospheric atmosphere to form a crystalline oxide thin film; and forming a gate insulating film and a gate electrode on the crystalline oxide thin film in this order.

14. The method for producing the thin film transistor according to 13, wherein the method includes forming a buffer layer on the substrate, followed by formation of the oxide thin film on the buffer layer.

15. The method for producing the thin film transistor of 11 or 12, including the steps of: forming an oxide thin film on a substrate; subjecting the oxide thin film to annealing treatment at a temperature of more than 300°C under an atmospheric atmosphere to form a crystalline oxide thin film; and forming an interlayer insulating film on the crystalline oxide thin film in this order.

16. The method for producing the thin film transistor according to 15, wherein the method includes forming a gate electrode and a gate insulating film on the substrate in this order, followed by formation of the oxide thin film on the gate insulating film.

According to the present invention, the crystalline oxide thin film, which exhibits a satisfactory mobility and provides high reliability when applied to a TFT, can be provided. In addition, the thin film transistor including the crystalline oxide thin film and the method for producing the same can be provided.

Brief Description of the Drawings

Fig. 1 is a schematic sectional view of an example of a TFT of an embodiment of the present invention.
Fig. 2 is a schematic sectional view of another example of the TFT of this embodiment.
Fig. 3 is a schematic sectional view of another example of the TFT of this embodiment.
Fig. 4 shows FFT images of a bixbyite structure of $In_2O_3$.
Fig. 5 is a diagram for illustrating a method for calculating a lattice constant "a" and a lattice constant "b".
Fig. 6 shows results of reciprocal lattice simulation of the bixbyite structure of $In_2O_3$.

Mode for Carrying out the Invention

The ordinal numbers "first", "second", and "third" as used herein are attached for avoiding confusion between constituents. Constituents without descriptions for numerical specification, that is, a description for specifying a singular form or a plural form and a description for specifying an order are not numerically limited.
As used herein, the term "film" or "thin film" and the term "layer" are sometimes interchangeable with each other.
In a sintered body and an oxide thin film as used herein, the term "compound" and the term "crystalline phase" are sometimes interchangeable with each other.
As used herein, the term "oxide sintered body" is sometimes simply referred to as "sintered body".
As used herein, the term "sputtering target" is sometimes simply referred to as "target".
As used herein, the term "electrically connected" encompasses a connection via "an object of some electric action". The "object of some electric action" is not particularly limited as long as the object allows communication of electric signals between connected components. Examples of the "object of some electric action" include an electrode, a line, a switching device (e.g., a transistor), a resistor, an inductor, a capacitor, and other devices having various functions.
As used herein, the functions of the source and drain of a transistor may be interchanged when, for example, a transistor of different polarity is used or the direction of a current is changed during the operation of a circuit. Accordingly, the terms "source" and "drain" as used herein may be interchangeably used.
As used herein, the term "x to y" refers to a numerical range of "x or more and y or less". An upper limit value and a lower limit value described regarding the numerical range may be arbitrarily combined.
In addition, the present invention also encompasses modes obtained by combining two or more individual modes of the present invention described below.
In addition, as used herein, the term "principal surface of a thin film" refers to a surface having the widest area among the surfaces of the thin film.
As used herein, a certain plane of a crystal or a plane parallel thereto is referred to as "crystal plane".
In addition, a direction perpendicular to the crystal plane is referred to as "plane orientation".

1. Crystalline Oxide Thin Film

A crystalline oxide thin film according to an embodiment of the present invention is a crystalline oxide thin film including In as a main component.
In addition, 50% or more of Fourier transform images (hereinafter referred to as "FFT images") obtained by subjecting each of lattice images in a plurality of image regions extracted from a transmission electron microscope image of a cross-section (hereinafter sometimes referred to as "cross-sectional TEM image") of the crystalline oxide thin film to two-dimensional Fourier transform (FFT) processing exhibit any one of plane orientations selected from (100), (110), (111), (211), (411), (125), (210), (310), and (320).
The plurality of image regions refers to 10 image regions in the following description. However, the number of the image regions is not limited to 10 and may be more than 10. For example, 50 or more image regions may be extracted.
The crystalline oxide thin film having the above-mentioned characteristics may be obtained by adjusting the crystal state of the crystalline oxide thin film to a columnar shape, as well as a method described in a method for producing a crystalline oxide thin film described later.
The crystalline oxide thin film according to this embodiment includes an In element as a main component.
The phrase "include an In element as a main component" means that the composition ratio (atomic%: at%) of In is 50 at% or more with respect to all metal elements in the crystalline oxide thin film.
The composition ratio of In is preferably 62 at% or more, more preferably 70 at% or more, still more preferably 80 at% or more, yet still more preferably 85 at% or more. When the composition ratio of the In element is 50 at% or more in the total number of atoms of metal elements for forming the crystalline oxide thin film, crystallization easily progresses in a formed amorphous film, and a sufficiently high mobility can be exhibited when the crystalline oxide thin film according to this embodiment is adopted in a TFT.

The crystalline oxide thin film may include, in addition to In, one or more elements selected from the group consisting of H, B, C, N, O, F, Mg, Al, Si, O, S, Cl, Ar, Ca, Sc, Ti, V, Cr, Mn, Fe, Co, Ni, Cu, Zn, Ga, Ge, Y, Zr, Nb, Mo, Tc, Ru, Rh, Pd, Ag, Cd, Sn, Sb, Cs, Ba, Ln, Hf, Ta, W, Re, Os, Ir, Pt, Au, Pb and Bi.

In this embodiment, the crystalline oxide thin film may consist essentially of elements selected from In, Mg, Al, Si, Zn, Ga, Mo, Sn, Ln elements (lanthanoid elements), and O. As used herein, the term "essentially" means that the crystalline oxide thin film according to this embodiment may include any other component to the extent that the effects of the present invention attributed to the combination of In, Mg, Al, Si, Zn, Ga, Mo, Sn, Ln, and O described above are exhibited.

In the crystalline oxide thin film according to a more preferred first mode of this embodiment, the metal elements consist of In and Ga, and the atomic ratio therebetween satisfies the following formula (11).

$$[Ga]/([In]+[Ga])] < 22 \text{ at}\% \qquad (11)$$

The crystalline oxide thin film may include inevitable impurities as the metal elements, and further F or H in addition to O. When the above-mentioned composition range is satisfied, the In ratio is increased, and crystallization to a bixbyite structure in which an In site is substituted by Ga can be achieved even by annealing at a low temperature such as 300°C. Further, when Ga having a strong bonding force with oxygen is added, oxygen deficiency after annealing is suppressed, and a film that is stable as a semiconductor can be formed.

The crystalline oxide thin film according to a more preferred second mode of this embodiment consists of In and one or more elements X selected from B, Al, Sc, Mg, Zn, Ti, Y, Zr, Mo, Sn, Hf, W, Nb, Ta, Ge, Si, La, Ce, Pr, Nd, Sm, Dy, Ho, Er, Tm, Yb and Lu as metal elements, and when a metal element except In is represented by X, the atomic ratio satisfies the following formula (12).

$$[X]/([In]+[X])] < 15 \text{ at}\% \qquad (12)$$

The crystalline oxide thin film may include inevitable impurities as the metal elements, and further F or H in addition to O. When the above-mentioned composition range is satisfied, the In ratio is increased, and crystallization to a bixbyite structure in which an In site is substituted by X can be achieved even by annealing at a low temperature such as 300°C. Further, when an element X having a strong bonding force with oxygen is added, oxygen deficiency after annealing is suppressed, and a film that is stable as a semiconductor can be formed.

The crystalline oxide thin film according to a more preferred third mode of this embodiment consists of In, Ga, and one or more elements X selected from B, Al, Sc, Mg, Zn, Ti, Y, Zr, Mo, Sn, Hf, W, Nb, Ta, Ge, Si, La, Ce, Pr, Nd, Sm, Dy, Ho, Er, Tm, Yb and Lu as metal elements, and when a metal element except In and Ga is defined as an additive element X, the atomic ratios satisfy the following formulae (13) and (14).

$$[Ga]/([In]+[Ga]+[X])] < 22.5 \text{ at}\% \qquad (13)$$

$$[X]/([In]+[Ga]+[X])] < 8.0 \text{ at}\% \qquad (14)$$

The crystalline oxide thin film may include inevitable impurities as the metal elements, and further F or H in addition to O.

When the above-mentioned composition range is satisfied, the In ratio is increased, and crystallization to a bixbyite structure in which an In site is substituted by Ga can be achieved even by annealing at a low temperature such as 300°C. In addition, when the additive element X having a strong bonding force with oxygen is added, oxygen deficiency after annealing is further suppressed, and a film that is stable as a semiconductor can be formed.

The crystalline oxide thin film according to a more preferred fourth mode of this embodiment consists of In, Sn, and one or more elements X selected from B, Al, Sc, Mg, Zn, Ti, Y, Zr, Mo, Hf, W, Nb, Ta, Ge, Si, La, Ce, Pr, Nd, Sm, Dy, Ho, Er, Tm, Yb and Lu as metal elements, and when a metal element except In and Sn is defined as an element X, the atomic ratios satisfy the following formulae (15) and (16).

$$[Sn]/([In]+[Sn]+[X])] < 20 \text{ at\%} \quad (15)$$

$$[X]/([In]+[Sn]+[X])] < 8.0 \text{ at\%} \quad (16)$$

The crystalline oxide thin film may include inevitable impurities as the metal elements, and further F or H in addition to O.

When the composition range as described above is satisfied, the In ratio is increased, and crystallization to a bixbyite structure in which an In site is substituted by Sn can be achieved even by annealing at a low temperature such as 300°C. Sn has a large ion radius and a large orbital overlap with In, and hence a high mobility can be held. In addition, when the additive element X having a strong bonding force with oxygen is added, oxygen deficiency after annealing is further suppressed, and a film that is stable as a semiconductor can be formed.

The crystalline oxide thin film according to a more preferred fifth mode of this embodiment consists of In, Zn, and one or more elements X selected from B, Al, Sc, Mg, Ti, Y, Zr, Mo, Hf, W, Nb, Ta, Ge, Si, La, Ce, Pr, Nd, Sm, Dy, Ho, Er, Tm, Yb and Lu as metal elements, and when a metal element except In and Zn is defined as an element X, the atomic ratios satisfy the following formulae (17) and (18).

$$[Zn]/([In]+[Zn]+[X])] < 12 \text{ at\%} \quad (17)$$

$$[X]/([In]+[Zn]+[X])] < 8.0 \text{ at\%} \quad (18)$$

The crystalline oxide thin film may include inevitable impurities as the metal elements, and further F or H in addition to O.

When the above-mentioned composition range is satisfied, the In ratio is increased, and crystallization to a bixbyite structure in which an In site is substituted by Zn can be achieved even by annealing at a low temperature such as 300°C. When Zn is added, the film immediately after film formation can be set to an amorphous state, and the film can be processed without residue at the time of semiconductor patterning with an acid during production of a TFT. Further, when the additive element X having a strong bonding force with oxygen is added, oxygen deficiency after annealing is suppressed, and a film that is stable as a semiconductor can be formed.

The content (atomic ratio) of each metal element in the crystalline oxide thin film may be determined by measuring the abundance of each element by inductively coupled plasma (ICP) measurement or X-ray fluorescence (XRF) measurement. An inductively coupled plasma optical emission spectrometer (ICP-OES manufactured by Agilent) may be used for the ICP measurement. A thin film X-ray fluorescence analyzer (AZX400 manufactured by Rigaku Corporation) may be used for the XRF measurement.

In addition, the content (atomic ratio) of each metal element in the crystalline oxide thin film may be analyzed with an error accuracy of 2 atomic% or less by TEM-EDS measurement using an electron microscope, ICP measurement using an inductively coupled plasma optical emission spectrometer, and SIMS analysis using a sector-type dynamic secondary ion mass spectrometer. First, the cross-sectional TEM-EDS is used to identify the metal elements in the crystalline oxide thin film, and semi-quantitative analysis is used to identify composition percentages within an error range of about 10 atomic%. Next, a standard oxide thin film is prepared having an atomic ratio of metal elements defined by 10 known kinds of composition percentages of metal elements in the range of 20 atomic% from the semi-quantitative analysis results. For the standard oxide thin film, a value measured by an inductively coupled plasma optical emission spectrometer or a thin film fluorescent X-ray analyzer is used as an absolute value of the composition percentage. Further, source and drain electrodes formed of the same material and the same channel length as the TFT device are prepared on the upper surface of the standard oxide thin film, and are used as a standard material for analysis of an oxide semiconductor layer by a sector-type dynamic secondary ion mass spectrometer SIMS (IMS 7f-Auto manufactured by AMETEK) to obtain a mass spectrometric intensity of each metal element, thereby preparing a calibration line of a known concentration of each metal element and the mass spectrometric intensity. Next, the atomic ratios of the oxide thin film of the actual TFT device taken out from a panel are calculated from the spectral intensity by the SIMS analysis using a sector-type dynamic secondary ion mass spectrometer using the above-mentioned calibration line. The calculated atomic ratios can be confirmed separately with an accuracy of 2 atomic% or less of an atomic ratio of the oxide thin film measured by a thin film fluorescent X-ray analyzer or the inductively coupled plasma emission analyzer.

In the crystalline oxide thin film according to this embodiment, 50% or more of FFT images obtained by subjecting each of lattice images in a plurality of image regions extracted from a cross-sectional TEM image of a cross-section of the crystalline oxide thin film to two-dimensional Fourier transform (FFT) processing exhibit any one of plane orientations selected from (100), (110), (111), (211), (411), (125), (210), (310), and (320).

Each of (100), (110), (111), (211), (411), (125), (210), (310), and (320) is a crystal plane of a bixbyite structure of $In_2O_3$, and the case corresponding to any one of these crystal planes refers to "exhibiting a FFT specific plane orientation".

When 50% or more of the plurality of FFT images obtained from the each of lattice images in the image regions correspond to any one of the above-mentioned plane orientations, it can be determined that the crystalline oxide thin film has a satisfactory bixbyite structure suitable for a channel layer of FFT.

Thus, the crystalline oxide thin film can exhibit high mobility when used as a channel layer of a TFT and is also excellent in reliability with less fluctuation in threshold voltage (Vth).

A method for determining a FFT specific plane orientation is described in detail in Examples.

It is preferred that 60% or more, 70% or more, 80% or more, 90% or more, 95% or more, or 99% or more of the FFT images of lattice images of a plurality of image regions extracted from the cross-sectional TEM image of the cross-section of the crystalline oxide thin film exhibit any one of plane orientations selected from (100), (110), (111), (211), (411), (125), (210), (310), and (320).

It is more preferred that 100% of the FFT images of the lattice images of the plurality of image regions exhibit any one of the plane orientations selected from (100), (110), (111), (211), (411), (125), (210), (310), and (320).

In the crystalline oxide thin film according to one embodiment, regarding each of the Fourier transform images exhibiting FFT specific plane orientations, an arithmetic average $\varepsilon_{aver}$ of lattice distortions $\varepsilon_1, \cdots \varepsilon_x$ calculated by the following formula (3) from a lattice constant "a" in a direction normal to a principal surface of the crystalline oxide thin film (hereinafter referred to as "normal direction") and a lattice constant "b" in a direction parallel to the principal surface of the crystalline oxide thin film (hereinafter referred to as "plane direction") satisfies $1.0 < \varepsilon_{aver} < 1.1$.

$$\varepsilon = \frac{b}{a}$$

$$\cdots \quad (\text{Formula (3)})$$

The lattice distortion $\varepsilon$ indicates the degree of distortion of a crystal lattice. The case in which the value of $\varepsilon$ is more than 1.0 leads to a state in which the lattice constant "b" in the plane direction is larger than the lattice constant "a" in the normal direction, and a tensile stress occurs in the crystal lattice. As a result, the crystalline oxide thin film has a crystal state in which defects in crystal grains are reduced and a satisfactory conduction characteristic is achieved with less electron traps. Thus, the crystalline oxide thin film can exhibit high mobility when used as a channel layer of a TFT and is also excellent in reliability with less fluctuation in threshold voltage (Vth). In addition, when the value of $\varepsilon$ is less than 1.1, film properties are satisfactory because the peeling of the crystalline oxide thin film and the occurrence of cracks are suppressed.

The $\varepsilon_{aver}$ is preferably from 1.01 to 1.09, more preferably from 1.02 to 1.08.

A method for calculating the lattice constant "a" in the normal direction and the lattice constant "b" in the plane direction is described in detail in Examples.

In one embodiment, the crystalline oxide thin film has a thickness of 3 nm or more and 130 nm or less. When the thickness is 130 nm or less, the crystal of the crystalline oxide thin film easily becomes a columnar single-layer crystal. The reason for the foregoing is as described below. When the thickness is set to 130 nm or less, the progress of crystallization in a stage before annealing treatment can be suppressed in an oxide thin film formed on a support, and the inhibition of crystal growth caused by the presence of a fine crystal can be suppressed in the subsequent annealing treatment step. Thus, the crystalline oxide thin film can exhibit high mobility when used as a channel layer of a TFT and is also excellent in reliability.

In addition, the fine crystallization in the oxide thin film can be suppressed, and hence the occurrence of faults, such as the inability to remove the film to be peeled caused by residues generated in the patterning step, can be suppressed, and the film properties are excellent.

The thickness of the crystalline oxide thin film is preferably less than 50 nm, more preferably 45 nm or less, particularly preferably 40 nm or less. Meanwhile, the thickness of the crystalline oxide thin film may be, for example, 5 nm or more or may be 10 nm or more. When the thickness of the crystalline oxide thin film is set to 3 nm or more, the crystal of the crystalline oxide thin film is less influenced by an underlying portion and easily becomes a high-quality columnar single-layer crystal.

As used herein, the thickness is measured based on a cross-sectional TEM image.

In one embodiment, the crystalline oxide thin film has a short-side length of less than 50 $\mu$m. When the short-side length is less than 50 $\mu$m, the percentage at which the FFT image of a cross-sectional TEM image exhibits a FFT specific plane orientation tends to be increased.

The short-side length of the crystalline oxide thin film is preferably 45 μm or less, more preferably 35 μm or less, still more preferably 25 μm or less, particularly preferably 22 μm or less. Meanwhile, the short-side length of the crystalline oxide thin film is, for example, 0.1 μm or more, 0.3 μm or more, or 1 μm or more. When the short side is set to 1 μm or more, the positioning of a patterning mask can be accurately performed when a TFT using the crystalline oxide thin film is produced, and stable production can be performed. However, in a production process of an integrated circuit or the like, the positioning accuracy of the patterning mask varies, and hence the short side may be less than 1 μm in such case.

In one embodiment, an average spacing D between crystal grain boundaries in the crystalline oxide thin film is preferably 0.01 μm or more and 2.0 μm or less.

Thus, the crystalline oxide thin film can exhibit high mobility when used as a channel layer of a TFT and is also excellent in reliability with less fluctuation in threshold voltage (Vth).

The average spacing D between crystal grain boundaries in the thin film is measured based on a cross-sectional TEM observation image. The average spacing D is calculated by extracting a field of view centered at a center portion in a channel length direction in a TFT, which is 5 μm in the channel direction and has a size of the thickness of the crystalline oxide, in an image observed at a magnification of 20,000 times through use of a transmission electron microscope and analyzing the spacing between the crystal particles observed in a cross-sectional TEM image. When the length of the oxide thin film in the channel direction is as short as less than 5 μm, it is only required that a field of view matched with the length in the channel direction be extracted and calculated in the same manner.

In one embodiment, the crystalline oxide thin film contains crystal grains each having a bixbyite structure in the FFT image of a TEM image. The crystal grain having a bixbyite structure has a cubic crystal shape with satisfactory symmetry, and hence a reduction in TFT characteristic (mobility) can be suppressed even when the crystal grain boundaries are crossed.

2. Method of producing Crystalline Oxide Thin Film

The crystalline oxide thin film of this embodiment may be produced, for example, by using, as a support, a lower layer or the like for forming a TFT, such as a substrate, a buffer layer and an insulating layer, forming a thin film including an oxide of In as a main component on the support, and subjecting the resultant to annealing treatment (heat treatment) at a predetermined temperature. A method for the film formation is not particularly limited, but examples thereof include DC sputtering, AC sputtering, RF sputtering, ICP sputtering, reactive sputtering, ion plating, ALD, PLD, MO-CVD, ICP-CVD, a sol-gel method, a coating method, and mist CVD.

When the film formation is performed by sputtering, film formation may be performed by a device with a planar sputtering cathode or may be performed by a device with a rotary sputtering cathode.

As an example of the film formation method, a film can be produced by performing film formation by DC sputtering through use of a sputtering target including an oxide sintered body including an oxide of In as a main component.

The atomic composition ratio of the crystalline oxide thin film obtained by the sputtering method reflects the atomic composition ratio of the oxide sintered body in the sputtering target. Therefore, it is preferable to form a film using the sputtering target containing the oxide sintered body having the atomic composition ratio same as that of the desired oxide thin film.

The amount of an impurity metal in the target used in the sputtering method is 500 ppm or less, more preferably 100 ppm or less. The content of the impurity metal in the target can be measured by ICP or SIMS as in the crystalline oxide thin film. The "impurity" contained in the target is an element that is mixed in the raw material or during a manufacturing process and is not intentionally added, and means a trace element that does not substantially affect the performance of the target and the semiconductor. The "impurity metal" means a metal element among elements as an "impurity".

The method for the annealing treatment (heat treatment) is not particularly limited, but there may be used, for example, an air-heating furnace, an IR furnace, a lamp annealing apparatus, a laser annealing apparatus, or a heat plasma apparatus.

In this embodiment, the sputtering target may consist essentially of In and an element selected from Mg, Al, Si, Zn, Ga, Mo, Sn, Ln (lanthanoid) elements and O. Here, the term "essentially" means that the sputtering target may contain another component in addition to In described above to the extent that the effects of the present invention brought by a combination of Mg, Al, Si, Zn, Ga, Mo, Sn, Ln, and O are exhibited.

In the same manner as in the crystalline oxide thin film of the present invention described above, the sputtering target according to a more preferred first mode of this embodiment is an oxide consisting of In and Ga as metal elements, and the atomic ratio satisfies the following formula (11).

$$[Ga]/([In]+[Ga]) < 22 \text{ at\%} \qquad (11)$$

The sputtering target according to a more preferred second mode is an oxide consisting of In and one or more elements X selected from B, Al, Sc, Mg, Zn, Ti, Y, Zr, Mo, Sn, Hf, W, Nb, Ta, Ge, Si, La, Ce, Pr, Nd, Sm, Dy, Ho, Er, Tm, Yb, and Lu as metal elements, and when a metal element except In is represented by X, the atomic ratio satisfies the following formula (12).

$$[X]/([In]+[X])] < 15 \text{ at\%} \qquad (12)$$

The sputtering target according to a more preferred third mode is an oxide consisting of In, Ga, and one or more elements X selected from B, Al, Sc, Mg, Zn, Ti, Y, Zr, Mo, Sn, Hf, W, Nb, Ta, Ge, Si, La, Ce, Pr, Nd, Sm, Dy, Ho, Er, Tm, Yb, and Lu as metal elements, and when a metal element except In and Ga is defined as an additive element X, the atomic ratios satisfy the following formulae (13) and (14).

$$[Ga]/([In]+[Ga]+[X])] < 22.5 \text{ at\%} \qquad (13)$$

$$[X]/([In]+[Ga]+[X])] < 8.0 \text{ at\%} \qquad (14)$$

The sputtering target according to a more preferred fourth mode is an oxide consisting of In, Sn, and one or more elements X selected from B, Al, Sc, Mg, Zn, Ti, Y, Zr, Mo, Hf, W, Nb, Ta, Ge, Si, La, Ce, Pr, Nd, Sm, Dy, Ho, Er, Tm, Yb, and Lu as metal elements, and when a metal element except In and Sn is defined as an element X, the atomic ratios satisfy the following formulae (15) and (16).

$$[Sn]/([In]+[Sn]+[X])] < 20 \text{ at\%} \qquad (15)$$

$$[X]/([In]+[Sn]+[X])] < 8.0 \text{ at\%} \qquad (16)$$

The sputtering target according to a more preferred fifth mode is an oxide consisting of In, Zn, and one or more elements X selected from B, Al, Sc, Mg, Ti, Y, Zr, Mo, Hf, W, Nb, Ta, Ge, Si, La, Ce, Pr, Nd, Sm, Dy, Ho, Er, Tm, Yb, and Lu as metal elements, and when a metal element except In and Zn is defined as an element X, the atomic ratios satisfy the following formulae (17) and (18).

$$[Zn]/([In]+[Zn]+[X])] < 12 \text{ at\%} \qquad (17)$$

$$[X]/([In]+[Zn]+[X])] < 8.0 \text{ at\%} \qquad (18)$$

The oxide thin film obtained by forming a thin film by sputtering with use of a sputtering target containing indium oxide as a main component and with use of one or more kinds of gases, as a sputtering gas, selected from the group consisting of: argon; and oxygen which are substantially free of impurities is an amorphous oxide thin film. By patterning this oxide thin film in an island shape by photolithography and heating to crystallize the oxide thin film before forming the protective film, the crystalline oxide thin film having a single plane orientation as a surface crystal can be obtained.

Each of steps is described below.

(Oxide Thin Film Formation Step)

In an oxide thin film formation step, an oxide thin film is formed by sputtering through use of the above-mentioned sputtering target.

In one embodiment, in the oxide thin film formation step, a substrate such as a glass substrate is used as a support, and a crystalline oxide thin film is directly formed on a buffer layer formed on the support or a laminated film including a buffer layer and a layer except the buffer layer, for example, a metal layer. In the case of the laminated film, it is preferred that the laminated film be formed on the support so that the buffer layer included in the film is directly brought into contact with the crystalline oxide thin film.

Examples of a material for the buffer layer include $SiO_2$, $SiN_x$, $Al_2O_3$, and the like. Of those, $SiO_2$ is preferred.

When an oxide thin film is directly formed on a buffer layer or a laminated film including SiOz or the like as a main component, and is further subjected to annealing treatment described later, in a crystalline oxide thin film to be finally obtained, the percentage at which the FFT image of a cross-sectional TEM image exhibits a FFT specific plane orientation tends to be increased, and the crystalline oxide thin film has a satisfactory crystal structure.

A gas to be introduced at the time of the film formation by sputtering is not particularly limited, but examples thereof include argon, nitrogen, oxygen, water, hydrogen, and a mixed gas containing two or more kinds of those gases.

As one example, the flow rate ratio ($(O_2$ flow rate)/(Ar flow rate)+$(O_2$ flow rate))) of oxygen in a mixed gas in the case of using argon and oxygen is preferably more than 0% and 50% or less, more preferably more than 0% and 20% or less. When the flow rate ratio of oxygen is more than 0% and 50% or less, the oxide thin film is easily crystallized to become a semiconductor at the time of heating. When the flow rate ratio of oxygen is changed, the oxidation degree of the oxide thin film, that is, the crystallization degree thereof can be regulated. The flow rate ratio of oxygen only needs to be appropriately selected as required.

As one example, the flow rate ratio (($H_2O$ flow rate)/(Ar flow rate)+$(H_2O$ flow rate)) of water in a mixed gas in the case of using argon and water is preferably more than 0.03% and 10% or less, more preferably more than 0.03% and 5% or less. When the flow rate ratio of water is more than 0.03% and 5% or less, the oxide thin film is easily crystallized to become a semiconductor at the time of heating. In addition, a mixed gas of hydrogen and oxygen may be used instead of water.

In one embodiment, an oxide thin film is formed by using, as a sputtering gas, one or more kinds of gases selected from the group consisting of: argon; and oxygen, which are substantially free of impurity gases.

The phrase "the sputtering gas is "substantially free of impurity gases"" means that impurity gases other than argon and oxygen are not positively loaded, except for the introduction of adsorbed water due to the insertion of gases, and inevitable gases (inevitable impurity gases), such as chamber leak and adsorbed gases. In this embodiment, for example, a commercially available mixed gas of high-purity argon and high-purity oxygen may be used as the sputtering gas. If possible, impurities are preferably removed from the sputtering gas.

The ratio of the impurity gas in the sputtering gas is preferably 0.1 vol% or less, more preferably 0.05 vol% or less. When the ratio of the impurity gas is 0.1 vol% or less, the crystallization of the oxide thin film proceeds without any difficulty.

The purity of each of high-purity argon and high-purity oxygen is preferably 99 vol% or more, more preferably 99.9 vol% or more, still more preferably 99.99 vol% or more.

A sputtering pressure at the time of the film formation is not particularly limited as long as the sputtering pressure falls within a range in which plasma can be stably discharged. The sputtering pressure is generally from 0.1 to 5 Pa, preferably from 0.2 to 2 Pa.

Thus, in a crystalline oxide thin film to be finally obtained, the percentage at which the FFT image of a cross-sectional TEM image exhibits a FFT specific plane orientation is increased, and the crystalline oxide thin film has a satisfactory crystal structure.

In the oxide thin film formation step, the sputtering target is preferably mounted on a RF magnetron sputtering apparatus or a DC magnetron sputtering apparatus for sputtering.

In the crystalline oxide thin film according to this embodiment, an oxide thin film before heat treatment preferably includes an In element as main component. When the oxide thin film is heated through a heat treatment step described later, columnar crystals can be grown on the support.

When the crystalline oxide thin film formed as described above is applied to a TFT, the injection property of an electron carrier at the time of drive is excellent. As a result, the TFT exhibits a high mobility, and is excellent in reliability with less fluctuation in threshold voltage (Vth).

In one embodiment, in the oxide thin film formation step, the oxide thin film is formed to a thickness of 3 nm or more and less than 50 nm.

The reason for setting the thickness of the oxide thin film to the above-mentioned range is the same as the reason for setting the thickness of the crystalline oxide thin film to 3 nm or more and less than 50 nm. The preferred range of the thickness of the oxide thin film is also the same as the preferred range of the thickness of the crystalline oxide thin film.

In one embodiment, in the oxide thin film formation step, the short-side length of the oxide thin film is set to less than 50 μm.

The reason for setting the short-side length of the oxide thin film to the above-mentioned range is the same as the reason for setting the short-side length of the crystalline oxide thin film to less than 50 μm. The preferred range of the short-side length of the oxide thin film is also the same as the preferred range of the short-side length of the crystalline oxide thin film.

(Heat Treatment Step)

After the formation of the oxide thin film, the heat treatment is performed. This heat treatment is sometimes referred to as "annealing".

The temperature of the heat treatment is preferably more than 300°C and less than 500°C, more preferably 320°C or more and 480°C or less, still more preferably 330°C or more and 450°C or less.

When the heat treatment temperature after the formation of the oxide thin film is more than 300°C, the oxide thin film is easily crystallized, and in a crystalline oxide thin film to be finally obtained, the percentage at which the FFT image of a cross-sectional TEM image exhibits a FFT specific plane orientation is increased, and the crystalline oxide thin film has a satisfactory crystal structure. In addition, the crystalline oxide thin film can be formed so that the average spacing D between crystal particle diameters falls within an appropriate range.

When the heat treatment temperature after the formation of the oxide thin film is less than 500°C, the occurrence of cracks and peeling can be suppressed.

A heating time in the heat treatment step is preferably 0.1 hour or more and 5 hours or less, more preferably 0.3 hour or more and 3 hours or less, still more preferably 0.5 hour or more and 2 hours or less.

When the heating time in the heat treatment step is 0.1 hour or more, such a situation that the oxide thin film is not crystallized hardly occurs, and the oxide thin film is easily crystallized.

When the heating time in the heat treatment step is 5 hours or less, the heat treatment step is excellent in economic efficiency.

The "heating time" means a time (retention time) for which a predetermined highest temperature is maintained during the heat treatment.

A rate of temperature increase in the heat treatment step is preferably 2°C/min or more and 1,000°C/min or less, more preferably 3°C/min or more and 600°C/min or less.

When the rate of temperature increase in the heat treatment step is 2°C/min or more, the production efficiency of the oxide thin film is improved as compared to a case where the rate of temperature increase is less than 1°C/min.

When the rate of temperature increase in the heat treatment step is 1,000°C/min or less, at the time of the crystallization, the metal elements are uniformly diffused, and crystals in which no metal is segregated at the grain boundaries can be formed.

In addition, the rate of temperature increase in the heat treatment step is different from a value calculated from the set temperature and set time of a furnace, and is a value obtained by dividing the actual temperature of the oxide thin film by a time. The actual temperature of the oxide thin film may be determined, for example, by measuring an area within 1 cm from the oxide thin film in the furnace with a thermocouple.

The heat treatment step is performed under an atmospheric atmosphere having preferably a humidity of 10% or more, more preferably a humidity of 40% or more at 25°C. When the heat treatment step is performed in the atmosphere having a humidity of 10% or more, hydrogen and oxygen are diffused into the film at the time of the annealing, and thus the crystallization can be accelerated. The upper limit of the humidity is not particularly limited, but is about 80% or less.

The heat treatment step is preferably performed after the patterning of the oxide thin film. When the heat treatment is performed after the patterning, the crystallization of the oxide thin film can be accelerated while excess oxygen existing in the film during the film formation and organic substances adhering during the patterning are desorbed. As a result, a film having no organic substances or excess oxygen and having few crystal defects in the crystal grains can be formed, and an oxide thin film having few electron traps and a satisfactory conduction characteristic can be formed.

The heat treatment step may be performed a plurality of times. For example, the heat treatment step described above (first heat treatment step) may be performed after the patterning of the oxide thin film, and further a heat treatment step (second heat treatment step) may be performed as a final step after the production of a TFT device. The second heat treatment step is preferably performed at an annealing temperature higher than that in the first heat treatment step.

A region having resistance lower than that of any other region may be formed on part of the crystalline oxide thin film obtained in the heat treatment step. A method for forming the low-resistance region is not particularly limited, but the low-resistance region may be formed, for example, by causing a target portion of the crystalline oxide thin film to have low resistance by a method involving heat treatment (annealing) through use of a gate insulating film and/or a gate electrode instead of a mask (self-alignment) in the presence of indium tin oxide (ITO), aluminum, or the like.

3. Thin Film Transistor (TFT) and Production Method therefor

A TFT according to an embodiment of the present invention includes the crystalline oxide thin film of the present invention described above. The crystalline oxide thin film of the present invention is preferably used as a channel layer of the TFT.

In addition, the TFT according to this embodiment includes a buffer layer and a channel layer, the channel layer is the crystalline oxide thin film, and the TFT includes a gate insulating film and a gate electrode on the side opposite to the buffer layer when seen from the channel layer in this order from the channel layer side.

In one embodiment, the TFT includes a substrate, a buffer layer, and a channel layer in this order. In addition, the TFT includes the channel layer, a source electrode and a drain electrode that are each connected to both end sides of the channel layer, and a gate electrode laminated on the channel layer via a gate insulating film, and the channel layer is the crystalline oxide thin film.

Specifically, the gate insulating film and the gate electrode are arranged on the side opposite to the buffer layer when seen from the channel layer.

For example, a configuration known as the related art may be adopted as the configuration of the TFT according to this embodiment.

The TFT according to this embodiment may be produced by a method for producing a thin film transistor, including the steps of: forming an oxide thin film on a substrate; subjecting the oxide thin film to annealing treatment at a temperature of more than 300°C under an atmospheric atmosphere to form a crystalline oxide thin film; and forming a gate insulating film and a gate electrode on the crystalline oxide thin film in this order.

In one embodiment, a buffer layer is formed on the substrate, followed by the formation of the oxide thin film on the buffer layer.

In addition, the TFT according to this embodiment may be produced by a method for producing a thin film transistor, including the steps of: forming an oxide thin film on a substrate; subjecting the oxide thin film to annealing treatment at a temperature of more than 300°C under an atmospheric atmosphere to form a crystalline oxide thin film; and forming an interlayer insulating film on the crystalline oxide thin film in this order.

In one embodiment, a gate electrode and a gate insulating film are formed on the substrate in this order, followed by the formation of the oxide thin film on the gate insulating film.

Here, the method for producing a crystalline oxide thin film described above may be adopted as the step of subjecting an oxide thin film to annealing treatment to form a crystalline oxide thin film. Specifically, the TFT of this embodiment may be produced by a production method including the steps of: forming an oxide thin film by sputtering through use of a sputtering target (sometimes referred to as "film formation step"); and subjecting the oxide thin film to heat treatment (sometimes referred to as "heat treatment step"). Conditions and the like of the film formation step and the heat treatment step are the same as those of the method for producing a crystalline oxide thin film described above. The source electrode, the drain electrode, the gate electrode, and the gate insulating film may be formed by using known materials and known formation methods.

A method for forming each layer other than the crystalline oxide thin film in the method for producing a thin film transistor of this embodiment is not particularly limited, and a known method may be used.

(Step of forming Constituent Layer of TFT)

When a constituent layer of the TFT, such as an insulating layer, is formed on a crystalline oxide thin film, it is preferred that, after the resultant oxide thin film is subjected to heat treatment, the constituent layer be formed on the oxide thin film. When annealing is performed before the formation of the constituent layer of the TFT, oxygen and hydrogen are diffused at the time of the annealing. Thus, high-quality columnar crystals are obtained, and a small TFT with a low interfacial electron trap level and a high mobility is obtained after the formation of the constituent layer.

The shape of the thin film transistor according to this embodiment is not particularly limited, but the thin film transistor is preferably a top-gate type transistor, a back channel etch type transistor, an etch stopper type transistor, or the like. In addition, those transistors may each be a self-alignment type.

Embodiments of the present invention are described below with reference to the attached drawings. It should be easily understood by a person skilled in the art that the embodiments may be carried out in various manners, and their forms and details may be variously modified without departing from the gist and scope of the present invention. Accordingly, the present invention is not interpreted to be limited to the descriptions in the embodiments below.

In the drawings, a size, a layer thickness, a region, and the like are sometimes exaggerated for clarification. Accordingly, the present invention is not limited to the size, the layer thickness, the region, and the like shown in the drawings. The drawings include schematic illustrations of an ideal example, and the present invention is not limited to shapes, values, and the like shown in the drawings.

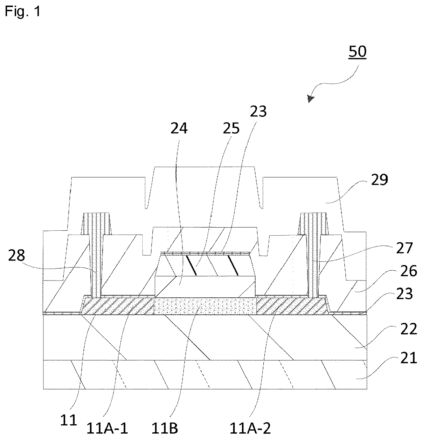

Fig. 1 is a schematic sectional view of an example of the TFT of this embodiment.

A TFT 50 is a top-gate type TFT, and includes a substrate 21, a buffer layer 22, a channel layer (crystalline oxide thin film) 11, an ITO layer 23, a gate insulating film 24, a gate electrode 25, an interlayer insulating film 26, a source electrode 27, a drain electrode 28, and a protective film 29.

The TFT 50 has a structure in which the substrate 21, the buffer layer 22, and the channel layer (crystalline oxide thin film) 11 are laminated in this order. A high-resistance region 11B is present in the center portion of the channel layer 11, and the gate insulating film 24 and the gate electrode 25 are laminated on the high-resistance region 11B in this order. The gate insulating film 24 is an insulating film that interrupts conduction between the gate electrode 25 and the channel layer (crystalline oxide thin film) 11. Low-resistance regions 11A-1 and 11A-2 of the channel layer 11 are present on both sides of the high-resistance region 11B. The low-resistance regions 11A-1 and 11A-2 and the gate electrode 25 are covered with the ITO layer 23 and the interlayer insulating film 26. The ITO layer 23 is used at the time of the formation of the low-resistance regions of the channel layer 11. The source electrode 27 and the drain electrode 28 are each connected to the low-resistance regions 11A-1 and 11A-2 via contact holes formed in the ITO layer 23 and interlayer insulating film 26. The source electrode 27 and drain electrode 28 are conductive terminals for allowing a source current and a drain current to flow to the channel layer 11. The protective film 29 is formed so as to cover the TFT constituent layers, such as the interlayer insulating film 26, the source electrode 27, and the drain electrode 28.

The buffer layer 22 may be formed of a single layer or have a laminate structure of two or more layers. In addition, a metal layer may be present between the buffer layer 22 and the substrate 21.

However, it is preferred that the channel layer 11 and the buffer layer 22 be in direct contact with each other as illustrated in Fig. 1.

Materials for forming the buffer layer 22 are described later.

The thickness of the buffer layer 22 is not particularly limited, but is, for example, from 50 to 600 nm.

In addition, in Fig. 1, the interlayer insulating film 26 is a single layer, but the interlayer insulating film 26 may have a two-layer structure.

The TFT of this embodiment may be modified with a known configuration.

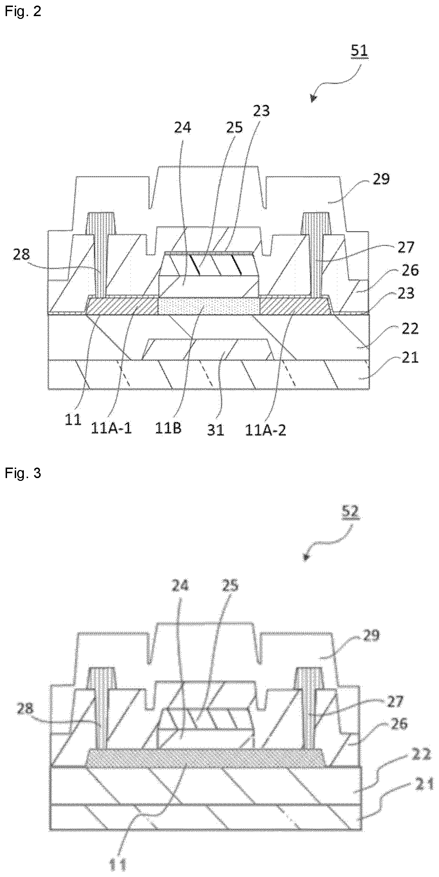

For example, although not shown in Fig. 1, in the TFT 50, a light shield layer 31 may be formed between the substrate 21 and the buffer layer 22 as illustrated in Fig. 2, or the light shield layer 31 may be formed in the intermediate layer of the buffer layer 22 in which a plurality of layers is laminated.

Fig. 2 is a schematic sectional view of another example of the TFT of this embodiment.

A TFT 51 has the same configuration as that of the TFT 50 except that the light shield layer 31 is formed between the substrate 21 and the buffer layer 22. The light shield layer 31 is formed in order to suppress the malfunction of the TFT caused by light. The light shield layer may be connected to the source electrode 27 or may be connected to the gate electrode 25.

In addition, in Fig. 1, such a configuration example that both end sides of the channel layer 11, that is, the vicinities of the regions thereof to which the source electrode 27 and the drain electrode 28 are connected are the low-resistance regions 11A of the crystalline oxide thin film, and the region of the channel layer 11 that is in contact with the lower surface of the gate insulating film 24 is the high-resistance region 11B is illustrated as an example of the TFT of the present invention, but the TFT of the present invention is not limited to this configuration. That is, the TFT of the present invention may use, as the channel layer 11, a crystalline oxide thin film having a resistance value that is uniform in a plane direction. In this case, as illustrated in Fig. 3, the ITO layer 23 may not be formed.

Fig. 3 is a schematic sectional view of another example of the TFT of this embodiment.

A TFT 52 has the same configuration as that of the TFT 50 except that: the channel layer (crystalline oxide thin film) 11 is a layer having no boundaries of a resistance value (the channel layer (crystalline oxide thin film) 11 is not divided into the low-resistance regions 11A and the high-resistance region 11B); and the ITO layer 23 is not formed.

In this embodiment, when the TFT is a small TFT, the crystalline oxide thin film serving as the channel layer for the source electrode and the drain electrode has a channel length (L length; in Fig. 1, the length in the source electrode 27-drain electrode 28 direction in a contact region between the channel layer 11 and the gate insulating layer 24) of 1 $\mu$m or more and 50 $\mu$m or less, and a channel width (W length; in Fig. 1, the length in a direction perpendicular to the source electrode 27-drain electrode 28 direction in the contact region between the channel layer 11 and the gate insulating layer 24) of 1 $\mu$m or more and 80 $\mu$m or less.

A material for forming the substrate is not particularly limited, and any material that is generally used may be selected. There may be used, for example, a glass substrate, a ceramic substrate, a quartz substrate, or a sapphire substrate. In addition, for example, a single crystal semiconductor substrate, such as silicon or silicon carbide, a polycrystal semiconductor substrate, a compound semiconductor substrate such as silicon germanium, or a silicon in insulator (SIO) substrate may be applied, or those substrates each having a semiconductor device arranged thereon may be used as the substrate.

In addition, a flexible substrate may be used as the substrate. As a method for arranging the TFT on the flexible substrate, there is given a method for directly producing the TFT on the flexible substrate, and there is also given a method involving producing the TFT on a non-flexible substrate, then peeling the TFT, and setting the TFT on the flexible substrate. In this case, a release layer may be arranged between the non-flexible substrate and the TFT.

A material for forming the buffer layer is also not particularly limited, and any material that is generally used may be selected. In addition, a laminated film may be used as the buffer layer. There may be used, for example, $SiO_2$, $SiO_x$, $SiN_x$, silicon oxynitride, $Al_2O_3$, $TazOs$, $TiO_2$, $MgO$, $ZrO_2$, $Ga_2O_3$, $GeO_2$, $Nd_2O_3$, $La_2O_3$, $CeO_2$, $K_2O$, $Li_2O$, $Na_2O$, $Rb_2O$, $Sc_2O_3$, $Y_2O_3$, $HfO_2$, $CaHfO_3$, $PbTiO_3$, $BaTa_2O_6$, $SrTiOs$, $Sm_2O_3$, or $AIN$. The oxidation number of each of the materials may be varied.

The buffer layer 22 may be appropriately designed in accordance with the kind of the substrate (e.g., a glass substrate or a resin substrate such as polyimide). Of the materials described above, $SiO_2$ is preferred as a material for the buffer layer 22 that is in contact with the channel layer 11.

When the material for the buffer layer 22 that is in contact with the channel layer 11 is $SiO_2$, the percentage at which the FFT image of a cross-sectional TEM image exhibits a FFT specific plane orientation tends to be increased in the channel layer (crystalline oxide thin film) 11, and the crystalline oxide thin film has a satisfactory crystal structure.

In Fig. 2, a second buffer layer may be arranged between the light shield layer 31 and the substrate 21. A material for forming the second buffer layer is also not particularly limited, and any material that is generally used may be selected. In addition, a laminated film may be used as the second buffer layer. For example, $SiO_2$, $SiN_x$, silicon oxynitride, $Al_2O_3$, TazOs, TiOz, MgO, $ZrO_2$, $Ga_2O_3$, $GeO_2$, $Nd_2O_3$, $La_2O_3$, $CeO_2$, $K_2O$, LizO, $Na_2O$, $Rb_2O$, $Sc_2O_3$, $Y_2O_3$, $HfO_2$, CaHfOs, PbTiOs, $BaTa_2O_6$, SrTiOs, $Sm_2O_3$, or AlN may be used as the material of the second buffer layer. The oxidation number of each of the materials may be varied.

A material for forming the gate insulating film is also not particularly limited, and any material that is generally used may be selected. In addition, a laminated film may be used as the gate insulating film. For example, $SiO_2$, $SiN_x$, silicon oxynitride, $Al_2O_3$, TazOs, TiOz, MgO, $ZrO_2$, $Ga_2O_3$, $GeO_2$, $Nd_2O_3$, $La_2O_3$, $CeO_2$, $K_2O$, LizO, $Na_2O$, $Rb_2O$, $Sc_2O_3$, $Y_2O_3$, $HfO_2$, CaHfOs, PbTiOs, $BaTa_2O_6$, SrTiOs, $Sm_2O_3$, or AlN may be used. The oxidation number of each of the materials may be varied.

Materials for forming the drain electrode, the source electrode, and the gate electrode are not particularly limited, and any materials that are generally used may be selected. For example, transparent electrodes, such as ITO, IZO, ZnO, and $SnO_2$, metal electrodes, such as Al, Ag, Cu, Cr, Ni, Co, Mo, Au, Ti, Zr, Ru, Y, Nb, W, and Ta, or metal electrodes consisting of alloys containing those metals may be used. In addition, a laminated electrode of two or more layers may be used.

A material for each interlayer insulating film is also not particularly limited, and any material that is generally used may be selected. In addition, a laminated film may be used as the interlayer insulating film. For example, $SiO_2$, $SiN_x$, silicon oxynitride, $Al_2O_3$, TazOs, TiOz, MgO, $ZrO_2$, $Ga_2O_3$, $GeO_2$, $Nd_2O_3$, $La_2O_3$, $CeO_2$, $K_2O$, $Li_2O$, $Na_2O$, $Rb_2O$, $Sc_2O_3$, Y2O3, $HfO_2$, CaHfOs, PbTiOs, $BaTa_2O_6$, SrTiOs, $Sm_2O_3$, and AlN may be used. The oxidation number of each of the materials may be varied.

A material for forming the light shield layer is not particularly limited, and any material that is generally used may be selected. Specifically, for example, a metal electrode, such as Al, Ag, Cu, Cr, Ni, Co, Mo, Au, Ti, Zr, Ru, Y, Nb, Ta, or W, an alloy thereof, or a laminate thereof may be used.

Irrespective of the structure of the TFT, a protective film is preferably arranged on the drain electrode, the source electrode, and a conductive region. The arrangement of the protective film is likely to improve the durability of the TFT even when the TFT is driven for a long period of time.

A method for producing the insulating film, such as the buffer layer, the gate insulating film, the interlayer insulating film, or the protective film, is not particularly limited. Examples of the production method include PE-CVD, ALD, PLD, MO-CVD, RF sputtering, ICP sputtering, reactive sputtering, ICP-CVD, ion plating, a sol-gel method, a coating method, mist CVD, and the like. Tetraethoxysilane (TEOS) may be used as the kind of a gas in the PE-CVD in addition to silane ($SiH_4$).

For example, when the insulating film is formed by the PE-CVD, the process may become a high-temperature process. In addition, the insulating film, such as the buffer layer, the gate insulating film, the interlayer insulating film, or the protective film, often contains an impurity gas immediately after the film formation, and is hence preferably subjected to the heat treatment (annealing treatment). When the impurity gas is removed by the heat treatment, a stable insulating film is obtained, which makes it easy to form a highly durable TFT. In addition, when the annealing is performed after the formation of the gate insulating film, hydrogen contained in the gate insulating film diffuses to the oxide thin film, and crystal defects existing on the surface of the oxide thin film are terminated by a hydroxy group. As a result, an oxide thin film having few electron traps and a satisfactory conduction characteristic can be formed.

Of the methods described above, for example RF sputtering, reactive sputtering, PE-CVD, a coating method, or the like is suitably used as the method for producing the buffer layer. In particular, the PE-CVD method is a method that has high productivity and is widely used, and hence may be suitably used.

The saturation mobility of the TFT is preferably 10.0 $cm^2/V·s$ or more and 200.0 $cm^2/V·s$ or less, more preferably 20.0 $cm^2/V·s$ or more and 150.0 $cm^2/V·s$ or less.

When the saturation mobility of the TFT is set to 10.0 $cm^2/V·s$ or more, a higher resolution, a higher frame rate, and a larger area of a display can be achieved.

The saturation mobility of the TFT is determined from a transmission characteristic when a drain voltage of 20 V is applied. A method for measuring the saturation mobility of the TFT is described in detail in Examples.

The threshold voltage (Vth) is preferably -3.0 V or more and 3.0 V or less, more preferably -2.0 V or more and 2.0 V or less, still more preferably -1.0 V or more and 1.0 V or less. When the threshold voltage (Vth) is -3.0 V or more and 3.0 V or less, the threshold voltage (Vth) can be corrected to Vth=0 V by installing a Vth correction circuit on the TFT. When the TFT thus obtained is installed to a panel, a display can be driven without uneven brightness and burn-in.

A method for measuring the threshold voltage (Vth) is described in detail in Examples.

An on-off ratio is preferably $10^6$ or more and $10^{12}$ or less, more preferably $10^7$ or more and $10^{11}$ or less, still more preferably $10^8$ or more and $10^{10}$ or less. When the on-off ratio is $10^6$ or more, a liquid crystal display can be driven. When the on-off ratio is $10^{12}$ or less, an organic EL device having a large contrast can be driven. In addition, when the on-off ratio is $10^{12}$ or less, an off current can be reduced to $10^{-12}$ A or less. Thus, when the TFT is used as a transfer transistor or a reset transistor for a CMOS image sensor, the retention time of an image can be lengthened, and sensitivity can be improved.

The on-off ratio may be determined by setting an off-current value to a value of Id when Vg=-10 V and setting an on-current value to a value of Id when Vg=20 V to determine a ratio [on-current value/off-current value].

The off current value is preferably $10^{-10}$ A or less, more preferably $10^{-11}$ A or less, still more preferably $10^{-12}$ A or less. When the off-current value is $10^{-10}$ A or less, an organic EL device having a large contrast can be driven. In addition, when the TFT is used as a transfer transistor or a reset transistor for a CMOS image sensor, the retention time of an image can be lengthened, and sensitivity can be improved.

A leakage current is preferably $1 \times 10^{-10}$ A or less, more preferably $1 \times 10^{-11}$ A or less, still more preferably $1 \times 10^{-12}$ A or less.

The TFT of this embodiment can exhibit satisfactory TFT characteristics in which the leakage current is suppressed as described above because the percentage at which the crystalline oxide thin film of the channel layer exhibits a FFT specific plane orientation is high, and the crystalline oxide thin film has a satisfactory crystal state in which two-layer crystallization, for example, in a thickness direction is suppressed and a large number of columnar single-layer crystals are present.

When the leakage current is $1 \times 10^{-10}$ A or less, an organic EL device having a large contrast can be driven. In addition, when the TFT is used as a transfer transistor or a reset transistor for a CMOS image sensor, the retention time of an image can be lengthened, and sensitivity can be improved.

A method for measuring the leakage current is described in detail in Examples.

The TFT according to this embodiment may be suitably used for solar cells, liquid crystal devices, organic electroluminescence devices, inorganic electroluminescence devices, and other display devices, and power semiconductor devices, touch panels, and other electronic devices.

The thin film transistor according to this embodiment may be applied to various integrated circuits including a field effect transistor, a logic circuit, a memory circuit, and a differential amplification circuit, and the various integrated circuits may be applied to electronic devices and the like. Further, the thin film transistor according to this embodiment may be applied not only to the field effect transistor but also to an electrostatic induction transistor and a Schottky barrier transistor.

The thin film transistor according to this embodiment may be suitably used for a display device such as a portable or in-vehicle display device, a solid-state image sensor, and the like. Further, the thin film transistor according to this embodiment may also be suitably used as a transistor for a flat panel detector for an X-ray image sensor for medical use.

In addition, the crystalline oxide thin film according to this embodiment may be applied to a Schottky diode, a resistance change type memory, and a resistor.

Examples

The present invention is specifically described by way of Examples. The present invention is not limited to Examples.

[Production of Self-Aligned Top-Gate Structure (Self-Aligned Top-Gate (SA-TG) Small TFT]

Example 1

A thin film transistor 50 illustrated in Fig. 1 was produced through the following steps.

(1-1) Formation of Buffer Layer (SiO$_x$ Layer) (Sputtering)

A SiO$_x$ layer (buffer layer) having a thickness of 300 nm was formed by sputtering on an alkali-free glass substrate (support) 21 (EAGLE XG manufactured by Corning Incorporated) having a diameter of 4 inches through use of a sputtering target of SiO$_2$. Sputtering conditions are as described below.

Substrate temperature: 25°C
Ultimate pressure: $8.5 \times 10^{-5}$ Pa

Atmospheric gas: Ar
Sputtering pressure (total pressure): 0.4 Pa
Input voltage: RF 300 W
Distance between substrate (S) and target (T): 70 mm

(2) Formation of Oxide Thin Film

Next, an oxide thin film was formed by sputtering through use of an oxide sputtering target obtained from a raw material mixture having a loaded composition ratio shown in Table 1. The loaded composition ratio (unit: mass%) and the metal composition ratio (unit: at%) in the oxide sputtering target are shown in Table 1.
Film formation conditions in the sputtering and the thickness of a channel layer are shown in Table 1. The sputtering conditions except those shown in Table 1 are as described below.

Substrate temperature: 25°C
Ultimate pressure: $1.0 \times 10^{-4}$ Pa
Input voltage: DC 300 W
Distance between substrate (S) and target (T): 70 mm

(3) Formation of Channel Layer

Next, the oxide thin film was patterned in an island shape by photolithography to form a channel layer. First, a film of a photoresist was formed on the oxide thin film. AZ1500 (manufactured by AZ Electronic Materials SA) was used as the photoresist. The oxide thin film was exposed to light through a photomask in which a pattern was formed into sizes of a long side and a short side shown in Table 1. After the exposure, the resultant was developed with tetramethylammonium hydroxide (TMAH). After the development, the oxide thin film was etched with oxalic acid (ITO-06N manufactured by Kanto Chemical Co., Inc.). After the etching, the photoresist was peeled off. Thus, a substrate with a patterned oxide thin film (channel layer) was obtained. The sizes of the long side and the short side of the resultant channel layer are shown in Table 1.

(4) Annealing

Next, the substrate having the channel layer formed thereon was placed in a furnace. The temperature inside the furnace was increased to 350°C at 10°C/min in the atmosphere, and was then held for 1 hour. After the temperature inside the furnace was held at 350°C for 1 hour, the furnace was allowed to cool naturally. After the temperature inside the furnace returned to room temperature, the substrate was removed from the furnace.

(5) Formation of First Gate Insulating Film

Next, a SiO$_x$ layer (first gate insulating film) having a thickness of 10 nm was formed by sputtering through use of a sputtering target of SiO$_2$. Sputtering conditions are as described below.

Substrate temperature: 25°C
Ultimate pressure: $8.5 \times 10^{-5}$ Pa
Atmospheric gas: mixed gas of Ar+O$_2$ (O$_2$ flow rate: 30%)
Sputtering pressure (total pressure): 0.4 Pa
Input voltage: RF 100 W
Distance between substrate (S) and target (T): 70 mm

(6) Annealing of First Gate Insulating Film

Next, the substrate was placed in a furnace. The temperature inside the furnace was increased to 400°C at 10°C/min in the atmosphere, and was then held for 1 hour. After the temperature inside the furnace was held at 400°C for 1 hour, the furnace was allowed to cool naturally. After the temperature inside the furnace returned to room temperature, the substrate was removed from the furnace.

(7) Formation of Second Gate Insulating Film

Next, a SiO$_x$ layer (second gate insulating film) having a thickness of 100 nm was formed by sputtering through use of a sputtering target of $SiO_2$. Sputtering conditions are as described below.

Substrate temperature: 25°C
Ultimate pressure: $8.5 \times 10^{-5}$ Pa
Atmospheric gas: mixed gas of Ar+$O_2$ ($O_2$ flow rate: 30%)
Sputtering pressure (total pressure): 0.4 Pa
Input voltage: RF 100 W
Distance between substrate (S) and target (T): 70 mm

Thus, the total thickness of a gate insulating film layer formed of the first and second gate insulating films became 110 nm.

(8) Formation of Gate Electrode

Next, a Mo film having a thickness of 150 nm was formed through use of a sputtering target of Mo. Sputtering conditions are as described below.

Substrate temperature: 25°C
Ultimate pressure: $8.5 \times 10^{-5}$ Pa
Atmospheric gas: Ar
Sputtering pressure (total pressure): 0.4 Pa
Input voltage: DC 100 W
Distance between substrate (S) and target (T): 70 mm

(9) Patterning of Gate Electrode and Gate Insulating Film Layer

Next, the Mo film and the gate insulating film layer were patterned in an island shape by photolithography. First, a film of a photoresist was formed on the channel layer. AZ1500 (manufactured by AZ Electronic Materials SA) was used as the photoresist. The formed photoresist film was exposed to light through a photomask in which a pattern was formed in a size of a width of 10 $\mu$m by a length of 28 $\mu$m. After the exposure, development was performed with tetramethylammonium hydroxide (TMAH). After the development, a gate electrode was formed by etching the Mo film with a mixed acid of phosphoric acid, nitric acid, and acetic acid (phosphoric-acetic-nitric acid (PAN)).
Next, the gate insulating film layer was etched with buffered hydrofluoric acid (BHF) and patterned in an island shape.
Then, after the photoresist was peeled off, a region in which the channel layer was exposed was etched by a thickness of 10 nm through use of oxalic acid (ITO-06N manufactured by Kanto Chemical Co., Inc.), followed by cleaning.
The dimensions of the resultant gate electrode layer and gate insulating layer were a width of 10 $\mu$m by a length (short-side size ($\mu$m) of the channel layer+8 ($\mu$m)).

(10) Low-resistance Treatment

A low-resistance region was formed in the channel layer by self-alignment using the gate electrode. An ITO layer having a thickness of 2 nm was formed through use of a sputtering target of ITO. Sputtering conditions are as described below.

Substrate temperature: 25°C
Ultimate pressure: $8.5 \times 10^{-5}$ Pa
Atmospheric gas: mixed gas of Ar+$O_2$ ($O_2$ flow rate: 2%)
Sputtering pressure (total pressure): 0.4 Pa
Input voltage: DC 100 W
Distance between substrate (S) and target (T): 70 mm

Next, the substrate was placed in a furnace. The temperature inside the furnace was increased to 350°C at 10°C/min in the atmosphere, and was then kept for 1 hour, followed by the annealing of the substrate. After the temperature inside the furnace was kept at 350°C for 1 hour, the substrate was allowed to cool naturally. After the temperature inside the furnace returned to room temperature, the substrate was removed from the furnace.

(11) Formation of Interlayer Insulating Film

Next, a $SiO_x$ layer (interlayer insulating film) having a thickness of 150 nm was formed by sputtering through use of a sputtering target of SiOz. Sputtering conditions are as described below.

Substrate temperature: 25°C
Ultimate pressure: $8.5 \times 10^{-5}$ Pa
Atmosphere gas: Mixed gas of Ar+$O_2$ ($O_2$ flow rate: 30%)
Sputtering pressure (total pressure): 0.4 Pa
Input voltage: RF 100 W
Distance between S (substrate) and T (target): 70 mm

(12) Formation of Contact Hole of Interlayer Insulating Film

The substrate having the interlayer insulating film formed thereon was applied with a photoresist AZ1500 (manufactured by AZ Electronic Materials SA) and exposed to light via a photomask. After that, development was performed with tetramethylammonium hydroxide (TMAH).
After the development, a contact hole measuring a width of 6 μm by a length (short-side size of the channel layer (μm)-4 (μm)) was formed with buffered hydrofluoric acid (BHF).

(13) Formation of Source Electrode and Drain Electrode

Source electrode and drain electrode layers were patterned by a lift-off process using an image reversal resist AZ5214 and a photomask.
The image reversal resist AZ5214 was exposed to light via a photomask formed such that the resist was able to be patterned into a final device shape in Fig. 1. After the reversal baking step, it was overall exposed to light and developed with TMAH. A Mo layer having a thickness of 150 nm was formed on the substrate with the patterned resist under the following sputtering conditions.

Substrate temperature: 25°C
Ultimate Pressure: $8.5 \times 10^{-5}$ Pa
Atmosphere gas: Ar
Sputtering pressure (total pressure): 0.4 Pa
Input voltage: DC 100 W
Distance between S (substrate) and T (target): 70 mm

After that, the substrate having the Mo layer formed thereon was lifted off in acetone. Thus, the source electrode and drain electrode layers were patterned.

(14) Final Annealing

Finally, the resultant was annealed at 300°C for 1 hour in a $N_2$ atmosphere to provide a self-aligned top-gate structure small TFT (SA-TG type TFT).
The resultant element (self-aligned top-gate structure small TFT) had a final shape of a channel length (sometimes referred to as "L length"; hereinafter referred to as "channel length") of 10 μm and a channel width that was the same length as the short-side size (μm) of the channel layer shown in Table 1.

Examples 2 to 6

Each TFT was produced in the same manner as in Example 1 except that the thickness and short-side size of the channel layer, and the film formation method for the buffer layer were changed as shown in Table 1.
The buffer layers in Examples 2 and 4 were each formed by the following method.

(1-2) Formation of Buffer Layer ($SiO_x$ film) (Plasma-Enhanced Chemical Vapor Deposition; PE-CVD)

A $SiO_x$ film having a thickness of 300 nm was formed by a PE-CVD method through use of monosilane ($SiH_4$) and nitrous oxide ($N_2O$) as a raw material gas. The film formation was performed under the conditions of a substrate temperature of 350°C, a film formation pressure of 1 Torr, a $N_2O/SiH_4$ gas flow rate ratio of 50, and a RF power of 100 W.

Table 1

| | | | Example 1 | Example 2 | Example 3 | Example 4 | Example 5 | Example 6 |
|---|---|---|---|---|---|---|---|---|
| Sputtering target | Loaded composition ratio [mass%] | $In_2O_3$ | 89.0 | 89.0 | 89.0 | 89.0 | 89.0 | 89.0 |
| | | $Ga_2O_3$ | 9.75 | 9.75 | 9.75 | 9.75 | 9.75 | 9.75 |
| | | $Al_2O_3$ | 1.25 | 1.25 | 1.25 | 1.25 | 1.25 | 1.25 |
| | Metal composition ratio [at%] | In | 83.3 | 83.3 | 83.3 | 83.3 | 83.3 | 83.3 |
| | | Ga | 13.5 | 13.5 | 13.5 | 13.5 | 13.5 | 13.5 |
| | | Al | 3.2 | 3.2 | 3.2 | 3.2 | 3.2 | 3.2 |

|  |  |  |  | Example 1 | Example 2 | Example 3 | Example 4 | Example 5 | Example 6 |
|---|---|---|---|---|---|---|---|---|---|
| TFT production conditions | Film formation of channel layer | Pressure at time of film formation [Pa] |  | 0.5 | 0.5 | 0.5 | 0.5 | 0.5 | 0.5 |
|  |  | Flow rate ratio at time of film formation [%] | $[O_2]/([H_2O]+[Ar]+[O_2])]$ | 10 | 10 | 10 | 10 | 10 | 10 |
|  |  |  | $[H_2O]/([H_2O]^+[Ar]^+[O_2])]$ | - | - | - | - | - | - |
|  |  | Magnetic flux density [G] |  | 1.000 | 1,000 | 1,000 | 1,000 | 1,000 | 1,000 |
|  |  | Thickness [nm] |  | 15 | 30 | 40 | 50 | 30 | 30 |
|  |  | Crystallinity after film formation |  | Amorphous | Amorphous | Amorphous | Amorphous | Amorphous | Amorphous |
|  | Patterning of channel layer | Long side [μm] |  | 50.0 | 50.0 | 50.0 | 50.0 | 50.0 | 50.0 |
|  |  | Short side [μm] |  | 20.0 | 20.0 | 20.0 | 20.0 | 10.0 | 40.0 |
|  | Annealing of channel layer | Temperature increase pattern [°C/min] |  | 10 | 10 | 10 | 10 | 10 | 10 |
|  |  | Highest temperature [°C] |  | 350 | 350 | 350 | 350 | 350 | 350 |
|  |  | Retention time [h] |  | 1 | 1 | 1 | 1 | 1 | 1 |
|  |  | Atmosphere |  | Atmospheric | Atmospheric | Atmospheric | Atmospheric | Atmospheric | Atmospheric |
|  | TFT | Film formation method for buffer layer |  | Sputtering | PE-CVD | Sputtering | PE-CVD | Sputtering | Sputtering |
|  |  | Material for buffer layer |  | $SiO_2$ | $SiO_2$ | $SiO_2$ | $SiO_x$ | $SiO_x$ | $SiO_x$ |
|  |  | TFT structure |  | SA-TG | SA-TG | SA-TG | SA-TG | SA-TG | SA-TG |

EP 4 418 309 A1

Example 7 to 11

Each TFT was produced in the same manner as in Example 1 except that the film formation conditions, thickness, and short-side size of the channel layer, and the film formation method for the buffer layer were cahnged as shown in Table 2.
The buffer layer in Example 8 was formed in the same manner as in Example 2. In addition, the buffer layer in Example 11 was formed by the following method.

(1-3) Formation of Buffer Layer (SiN$_x$ film) (PE-CVD)

A SiN$_x$ film having a thickness of 300 nm was formed by a PE-CVD method through use of monosilane (SiH$_4$) and nitrogen (N$_2$) as a raw material gas. The film formation was performed under the conditions of a substrate temperature of 350°C, a film formation pressure of 0.5 Torr, a N$_2$/SiH$_4$ gas flow rate ratio of 100, and a RF power of 200 W.

Table 2

| | | | Example 7 | Example 8 | Example 9 | Example 10 | Example 11 |
|---|---|---|---|---|---|---|---|
| Sputtering target | Loaded composition ratio [mass%] | $In_2O_3$ | 89.0 | 89.0 | 89.0 | 89.0 | 89.0 |
| | | $Ga_2O_3$ | 9.75 | 9.75 | 9.75 | 9.75 | 9.75 |
| | | $Al_2O_3$ | 1.25 | 1.25 | 1.25 | 1.25 | 1.25 |
| | Metal composition ratio [at%] | In | 83.3 | 83.3 | 83.3 | 83.3 | 83.3 |
| | | Ga | 13.5 | 13.5 | 13.5 | 13.5 | 13.5 |
| | | Al | 3.2 | 3.2 | 3.2 | 3.2 | 3.2 |
| | Film formation of channel layer | Pressure at time of film formation [Pa] | 1.0 | 1.5 | 0.5 | 0.5 | 0.5 |
| | | Flow rate ratio at time of film formation [%] $[O_2]/([H_2O]+[Ar]+[O_2])]$ | 10 | 10 | - | - | - |
| | | Flow rate ratio at time of film formation [%] $[H_2O]/([H_2O]+[Ar]+[O_2])]$ | - | - | 1 | 1 | 1 |
| | | Magnetic flux density [G] | 1,000 | 1,000 | 1,000 | 1,000 | 1,000 |
| | | Thickness [nm] | 30 | 30 | 30 | 50 | 30 |
| | | Crystallinity after film formation | Amorphous | Amorphous | Amorphous | Amorphous | Amorphous |
| TFT production conditions | Patterning of channel layer | Long side [µm] | 50.0 | 50.0 | 50.0 | 50.0 | 50.0 |
| | | Short side [µm] | 20.0 | 20.0 | 20.0 | 20.0 | 40.0 |
| | Annealing of channel layer | Temperature increase pattern [°C/min] | 10 | 10 | 10 | 10 | 10 |
| | | Highest temperature [°C] | 350 | 350 | 350 | 350 | 350 |
| | | Retention time [h] | 1 | 1 | 1 | 1 | 1 |
| | | Atmosphere | Atmospheric | Atmospheric | Atmospheric | Atmospheric | Atmospheric |
| | TFT | Film formation method for buffer layer | Sputtering | PE-CVD | Sputtering | Sputtering | PE-CVD |
| | | Material for buffer layer | $SiO_x$ | $SiO_x$ | $SiO_x$ | $SiO_x$ | $SiN_x$ |
| | | TFT structure | SA-TG | SA-TG | SA-TG | SA-TG | SA-TG |

Examples 12 to 17

Each TFT was produced in the same manner as in Example 1 except that the composition ratio of the sputtering target to be used for the film formation of the channel, the film formation conditions and annealing conditions of the channel layer, the thickness of the channel layer, and the film formation method for the buffer layer were changed as shown in Table 3.

The buffer layers in Examples 13 and 15 were formed in the same manner as in Example 2. In addition, the buffer layer in Example 14 was formed by the following method.

(1-4) Formation of Buffer Layer ($Al_2O_3$ Film) (Atomic Layer Deposition; ALD)

An $Al_2O_3$ film having a thickness of 100 nm was formed by an ALD method under the condition of a substrate temperature of 300°C through use of trimethylaluminum ($Al(CH_3)_3$) and water ($H_2O$) as a raw material gas. The film formation was performed as follows: a step including introducing trimethylaluminum into a film formation chamber, followed by nitrogen purging, and then introducing water into the film formation chamber, followed by nitrogen purging, was defined as one cycle, and the cycle was performed 1,000 times.

Table 3

| | | | Example 12 | Example 13 | Example 14 | Example 15 | Example 16 | Example 17 |
|---|---|---|---|---|---|---|---|---|
| Sputtering target | Loaded composition ratio [mass%] | $In_2O_3$ | 95.0 | 95.0 | 95.0 | 95.0 | 100.0 | 95.0 |
| | | $Ga_2O_3$ | 5.00 | 5.00 | 5.00 | 5.00 | | 5.00 |
| | | $Al_2O_3$ | | | | | | |
| | Metal composition ratio [at%] | In | 92.8 | 92.8 | 92.8 | 92.8 | 100.0 | 92.8 |
| | | Ga | 7.20 | 7.20 | 7.20 | 7.20 | | 7.20 |
| | | Al | | | | | | |
| TFT production conditions | Film formation of channel layer | Pressure at time of film formation [Pa] | 0.5 | 0.5 | 0.5 | 0.5 | 0.5 | 0.5 |
| | | Flow rate ratio at time of film formation [%] $[O_2]/([H_2O]+[Ar]+[O_2])]$ | | | | | | |
| | | Flow rate ratio at time of film formation [%] $[H_2O]/([H_2O]+[Ar]+[O_2])]$ | 1 | 1 | 1 | 1 | 1 | 1 |
| | | Magnetic flux density [G] | 600 | 600 | 600 | 600 | 600 | 600 |
| | | Thickness [nm] | 30 | 30 | 30 | 30 | 30 | 120 |
| | | Crystallinity after film formation | Amorphous | Amorphous | Amorphous | Amorphous | Amorphous | Amorphous |
| | Patterning of channel layer | Long side [μm] | 50.0 | 50.0 | 50.0 | 50.0 | 50.0 | 50.0 |
| | | Short side [μm] | 20.0 | 20.0 | 20.0 | 20.0 | 20.0 | 20.0 |
| | Annealing of channel layer | Temperature increase pattern [°C/min] | 10 | 10 | 10 | 10 | 10 | 10 |
| | | Highest temperature [°C] | 350 | 350 | 350 | 400 | 350 | 350 |
| | | Retention time [h] | 1 | 1 | 1 | 1 | 1 | 1 |
| | | Atmosphere | Atmospheric | Atmospheric | Atmospheric | Atmospheric | Atmospheric | Atmospheric |
| | TFT | Film formation method for buffer layer | Sputtering | PE-CVD | ALD | PE-CVD | Sputtering | Sputtering |
| | | Material for buffer layer | $SiO_x$ | $SiO_x$ | $Al_2O_3$ | $SiO_x$ | $SiO_x$ | $SiO_x$ |
| | | TFT structure | SA-TG | SA-TG | SA-TG | SA-TG | SA-TG | SA-TG |

Comparative Examples 1 to 8

Each TFT was produced in the same manner as in Example 1 except that the composition ratio of the sputtering target to be used for the film formation of the channel, the film formation conditions and annealing conditions of the channel layer, the thickness and long-side or short-side size of the channel layer, and the film formation method for the buffer layer were changed as shown in Table 4.

The buffer layers in Comparative Examples 1 and 3 were formed in the same manner as in Example 2.

In addition, in Comparative Example 6, a Si substrate with a thermal oxide film having a thickness of 100 nm was used as the substrate, and the thermal oxide film (thickness: 100 nm) was used as the buffer layer.

The Si substrate with a thermal oxide film is obtained by placing a Si substrate in a heating furnace set to an oxygen-containing atmosphere, and heating the Si substrate at a temperature inside the furnace of from about 900 to 1,100°C for a predetermined period of time.

Table 4

| | | | Comparative Example 1 | Comparative Example 2 | Comparative Example 3 | Comparative Example 4 | Comparative Exa mole 5 | Comparative Example 6 | Comparative Example 7 | Comparative Example a |
|---|---|---|---|---|---|---|---|---|---|---|
| Sputtering target | Loaded composition ratio [mass%] | $In_2O_3$ | 89.0 | 89.0 | 95.0 | 95.0 | 89.0 | 89.0 | 89.0 | 700 |
| | | $Ga_2O_3$ | 9.75 | 9.75 | 5.00 | 5.00 | 9.75 | 9.75 | 9.75 | 300 |
| | | $Al_2O_3$ | 1.25 | 1.25 | - | - | 1.25 | 1.25 | 1.25 | - |
| | Metal composition ratio [at%] | In | 83.3 | 83.3 | 92.8 | 92.8 | 83.3 | 83.3 | 83.3 | 81.2 |
| | | Ga | 13.5 | 13.5 | 7.20 | 7.20 | 13.5 | 13.5 | 13.5 | 38.8 |
| | | Al | 3.2 | 3.2 | - | - | 3.2 | 3.2 | 3.2 | - |

| | | | Comparative Example 1 | Comparative Example 2 | Comparative Example 3 | Comparative Example 4 | Comparative Exa mole 5 | Comparative Example 6 | Comparative Example 7 | Comparative Example a |
|---|---|---|---|---|---|---|---|---|---|---|
| TFT production conditions | Film formation of channel layer | Pressure attime of film for nation ГPa1 | 0.5 | 0.5 | 0.5 | 0.5 | 2.0 | 0.5 | 0.5 | 0.5 |
| | | Flow rate ratio attime of film formation [%] — $[O_2]/([H_2O]+[Ar]+[O_2])]$ | 10 | - | - | - | 10 | 10 | 10 | 10 |
| | | Flow rate ratio attime of film formation [%] — $[H_2O]([H_2O]+[Ar]+[O_2])]$ | - | 1 | 1 | 1 | - | - | - | 1 |
| | | Magnetic flux density [G] | 1.000 | 1.000 | 1.000 | 1.000 | 1.000 | 1.000 | 1.000 | 1.000 |
| | | Thickness [nm] | 160 | 30 | 50 | 80 | 30 | 30 | 30 | 30 |
| | | Crystallinity after film formation | Crystalline | Amorphous | Amorphous | Amorphous | Amorphous | Amorphous | Amorphous | Amorphous |
| | Patterning of channel layer | Long side [μm] | 50.0 | 50.0 | 50.0 | 120.0 | 50.0 | 50.0 | 50.0 | 50.0 |
| | | Short side [μm] | 20.0 | 20.0 | 20.0 | 100.0 | 20.0 | 20.0 | 50.0 | 20.0 |
| | Annealing of channel layer | Temoerature increase pattern [°C/min] | 10 | 10 | 10 | 10 | 10 | 10 | 10 | 10 |
| | | Highest temperature [°C] | 350 | 300 | 500 | 600 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | PE-CVD | Sputtering | PE-CVD | Sputtering | Sputtering | Thermal oxidation | Sputtering | Sputtering |
| | | Material for buffer layer | $SiO_x$ | $SiO_x$ | $SiO_x$ | $SiO_x$ | $SiO_x$ | $SiO_x$ | $SiO_x$ | $SiO_x$ |
| | | TFT structure | SA-TG | SA-TG | SA-TG | SA-TG | SA-TG | SA-TG | SA-TG | SA-TG |

Examples 18 to 225 and Comparative Example 9

Each TFT was produced in the same manner as in Example 1 except that the composition ratio of the sputtering target to be used for the film formation of the channel layer; the film formation conditions of the channel layer, the thickness, short=side and long-side sizes , and annealing conditions of the chanell layer; and the film formation method for the buffer layer were changed as shown in Tables 5 to 19.

Table 5

| | | | Example 18 | Example 19 | Example 20 | Comparative Example 9 |
|---|---|---|---|---|---|---|
| Sputtering target | Loaded composition ratio [mass%] | $In_2O_3$ | 84.78 | 90.84 | 97.82 | 81.63 |
| | | $Ga_2O_3$ | 15.22 | 9.16 | 2.18 | 18.37 |
| | | $X_2O_3$ | - | - | - | - |
| | | $X_2O_3$ kind | - | - | - | - |
| | Metal composition ratio [at%] | In | 79.00 | 87.00 | 96.80 | 75.00 |
| | | Ga | 21.00 | 13.00 | 3.20 | 25.00 |
| | | X | - | - | - | - |
| | | X element | - | - | - | - |

EP 4 418 309 A1

(continued)

| | | | Example 18 | Example 19 | Example 20 | Comparative Example 9 |
|---|---|---|---|---|---|---|
| TFT production conditions | Film formation of channel layer | Pressure at time of film formation [Pa] | 0.5 | 0.5 | 0.5 | 0.5 |
| | | Flow rate ratio at time of film formation [%] — $[O_2]/([H_2O]+[Ar]+[O_2])$ | 10 | 10 | 0 | 10 |
| | | Flow rate ratio at time of film formation [%] — $[H_2O]/([H_2O]+[Ar]+[O_2])$ | 0 | 0 | 2 | 0 |
| | | Magnetic flux density [G] | 600 | 600 | 600 | 600 |
| | | Thickness [nm] | 30 | 30 | 10 | 30 |
| | | Crystallinity after film formation | Amorphous | Amorphous | Amorphous | Amorphous |
| | Patterning of channel layer | Long side [$\mu$m] | 20 | 20 | 20 | 20 |
| | | Short side [$\mu$m] | 10 | 10 | 10 | 10 |
| | Annealing of channel layer | Temperature increase pattern [°C/min] | 10 | 10 | 10 | 10 |
| | | Highest temperature [°C] | 350 | 350 | 350 | 350 |
| | | Retention time [h] | 1 | 1 | 1 | 1 |
| | | Atmosphere | Atmospheric | Atmospheric | Atmospheric | Atmospheric |
| | TFT | Film formation method for buffer layer | Sputtering | Sputtering | Sputtering | Sputtering |
| | | Material for buffer layer | $SiO_2$ | $SiO_2$ | $SiO_2$ | $SiO_2$ |
| | | TFT structure | SA-TG | SA-TG | SA-TG | SA-TG |

Table 6

| | | | Example 21 | Example 22 | Example 23 | Example 24 | Example 25 | Example 26 | Example 27 | Example 28 |
|---|---|---|---|---|---|---|---|---|---|---|
| Sputtering target | Loaded composition ratio [mass%] | $In_2O_3$ | 96.49 | 99.63 | 89.16 | 97.38 | 85.08 | 96.27 | 84.98 | 96.24 |
| | | $Ga_2O_3$ | - | - | - | - | - | - | - | - |
| | | $X_2O_3$ | 3.51 | 0.37 | 10.84 | 2.62 | 14.92 | 3.73 | 15.02 | 3.76 |
| | | $X_2O_3$ kind | Al | Al | Y | Y | La | La | Ce | Ce |
| | Metal composition ratio [at%] | In | 91.00 | 99.00 | 87.00 | 96.80 | 87.00 | 96.80 | 87.00 | 96.80 |
| | | Ga | - | - | - | - | - | - | - | - |
| | | X | 9.00 | 1.00 | 13.00 | 3.20 | 13.00 | 3.20 | 13.00 | 3.20 |
| | | X element | Al | Al | Y | Y | La | La | Ce | Ce |

| | | | Example 21 | Example 22 | Example 23 | Example 24 | Example 25 | Example 26 | Example 27 | Example 28 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 10 | 0 | 10 | 0 | 10 | 0 | 10 | 0 |
| | | $[H_2O]/([H_2O]+[Ar]+[O_2])$ | 0 | 2 | 0 | 2 | 0 | 2 | 0 | 2 |
| | | Magnetic fluxdensitv [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Lona side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

EP 4 418 309 A1

32

|  |  |  | Example 29 | Example 30 | Example 31 | Example 32 | Example 33 | Example 34 | Example 35 | Example 36 |
|---|---|---|---|---|---|---|---|---|---|---|
| Sputtering target | Loaded composition ratio [mass%] | $In_2O_3$ | 84.92 | 96.22 | 84.67 | 96.15 | 84.20 | 96.01 | 83.28 | 95.75 |
|  |  | $Ga_2O_3$ | - | - | - | - | - | - | - | - |
|  |  | $X_2O_3$ | 15.08 | 3.78 | 15.33 | 3.85 | 15.80 | 3.99 | 16.72 | 4.25 |
|  |  | $X_2O_3$ kind | Pr | Pr | Nd | Nd | Sm | Sm | Dy | Dy |
|  | Metal composition ratio [at%] | In | 87.00 | 96.80 | 87.00 | 96.80 | 87.00 | 96.80 | 87.00 | 96.80 |
|  |  | Ga | - | - | - | - | - | - | - | - |
|  |  | X | 13.00 | 3.20 | 13.00 | 3.20 | 13.00 | 320 | 13.00 | 3.20 |
|  |  | X element | Pr | Pr | Nd | Nd | Sm | Sm | Dv | Dv |

EP 4 418 309 A1

(continued)

| | | | Example 29 | Example 30 | Example 31 | Example 32 | Example 33 | Example 34 | Example 35 | Example 36 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] $[O_2]/([H_2O]+[Ar]+[O_2])$ | 10 | 0 | 10 | 0 | 10 | 0 | 10 | 0 |
| | | Flow rate ratio at time of film formation [%] $[H_2O]/([H_2O]+[Ar]+[O_2])$ | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Long side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

Table 7

| | | | Example 37 | Example 38 | Example 39 | Example 40 | Example 41 | Example 42 | Example 43 | Example 44 |
|---|---|---|---|---|---|---|---|---|---|---|
| Sputtering target | Loaded composition ratio [mass%] | $In_2O_3$ | 83.10 | 95.69 | 82.93 | 95.64 | 82.80 | 95.61 | 82.50 | 95.52 |
| | | $Ga_2O_3$ | - | - | - | - | - | - | - | - |
| | | $X_2O_3$ | 16.90 | 4.31 | 17.07 | 4.36 | 17.20 | 4.39 | 17.50 | 4.48 |
| | | $X_2O_3$ kind | Ho | Ho | Er | Er | Tm | Tm | Yb | Yb |
| | Metal composition ratio [at%] | In | 87.00 | 96.80 | 87.00 | 96.80 | 87.00 | 96.80 | 87.00 | 96.80 |
| | | Ga | - | - | - | - | - | - | - | - |
| | | X | 13.00 | 3.20 | 13.00 | 3.20 | 13.00 | 3.20 | 13.00 | 3.20 |
| | | X element | Ho | Ho | Er | Er | Tm | Tm | Yb | Yb |

35

| | | | Example 37 | Example 38 | Example 39 | Example 40 | Example 41 | Example 42 | Example 43 | Example 44 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 10 | 0 | 10 | 0 | 10 | 0 | 10 | 0 |
| | | $[H_2O]/([H_2O]+[Ar]+[O_2])$ | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Long side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

EP 4 418 309 A1

|  |  |  | Example 45 | Example 46 | Example 47 | Example 48 | Example 49 | Example 50 | Example 51 | Example 52 |
|---|---|---|---|---|---|---|---|---|---|---|
| Sputtering target | Loaded composition ratio [mass%] | $In_2O_3$ | 82.36 | 95.48 | 91.94 | 98.10 | 92.08 | 98.13 | 88.29 | 97.15 |
|  |  | $Ga_2O_3$ | - | - | - | - | - | - | - | - |
|  |  | $X_2O_3$ | 17.64 | 4.52 | 8.06 | 1.90 | 7.92 | 1.87 | 11.71 | 2.85 |
|  |  | $X_2O_3$ kind | Lu | Lu | ZnO | ZnO | $TiO_2$ | $I1O_2$ | $ZrO_2$ | $ZrO_2$ |
|  | Metal composition ratio [at%] | In | 87.00 | 96.80 | 87.00 | 96.80 | 87.00 | 96.80 | 87.00 | 96.80 |
|  |  | Ga | - | - | - | - | - | - | - | - |
|  |  | X | 13.00 | 320 | 13.00 | 3.20 | 13.00 | 3.20 | 13.00 | 3.20 |
|  |  | X element | Lu | Lu | Zn | Zn | 11 | Ti | Zr | Zr |

EP 4 418 309 A1

| | | | Example 45 | Example 46 | Example 47 | Example 48 | Example 49 | Example 50 | Example 51 | Example 52 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] / $[O_2]/([H_2O]+[Ar]+[O_2])$ | 10 | 0 | 10 | 0 | 10 | 0 | 10 | 0 |
| | | $[H_2O]/([H_2O]+[Ar]+[O_2])$ | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Long side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

Table 8

| | | | Example 53 | Example 54 | Example 55 | Example 56 | Example 57 | Example 58 | Example 59 | Example 60 |
|---|---|---|---|---|---|---|---|---|---|---|
| Sputtering target | Loaded composition ratio [mass%] | $In_2O_3$ | 86.58 | 96.69 | 86.04 | 96.53 | 81.53 | 95.23 | 80.03 | 94.77 |
| | | $Ga_2O_3$ | - | - | - | - | - | - | - | - |
| | | $X_2O_3$ | 13.42 | 3.31 | 13.96 | 3.47 | 18.47 | 4.77 | 19.97 | 5.23 |
| | | $X_2O_3$ kind | $MoO_3$ | $MoO_3$ | $SnO_2$ | $SnO_2$ | $HfO_2$ | $HfO_2$ | $WO_3$ | $WO_3$ |
| | Metal composition ratio [at%] | In | 87.00 | 96.80 | 87.00 | 96.80 | 87.00 | 96.80 | 87.00 | 96.80 |
| | | Ga | - | - | - | - | - | - | - | - |
| | | X | 13.00 | 320 | 13.00 | 3.20 | 13.00 | 3.20 | 13.00 | 3.20 |
| | | X element | Mo | Mo | Sn | Sn | Hf | Hf | W | W |

| | | | Example 53 | Example 54 | Example 55 | Example 56 | Example 57 | Example 58 | Example 59 | Example 60 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 10 | 0 | 10 | 0 | 10 | 0 | 10 | 0 |
| | | Flow rate ratio at time of film formation [%] — $[H_2O]/([H_2O]+[Ar]+[O_2])$ | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Lona side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

EP 4 418 309 A1

| | | | Example 61 | Example 62 | Example 63 | Example 64 | Example 65 | Example 66 | Example 67 | Example 68 |
|---|---|---|---|---|---|---|---|---|---|---|
| Sputtering target | Loaded composition ratio [mass%] | $In_2O_3$ | 87.48 | 96.93 | 80.78 | 95.00 | 89.88 | 97.57 | 93.93 | 98.59 |
| | | $Ga_2O_3$ | - | - | - | - | - | - | - | - |
| | | $X_2O_3$ | 12.52 | 3.07 | 19.22 | 5.00 | 10.12 | 2.43 | 6.07 | 1.41 |
| | | $X_2O_3$ kind | $Nb_2O_5$ | $Nb_2O_5$ | $Ta_2O_5$ | $Ta_2O_5$ | $GeO_2$ | $GeO_2$ | $SiO_2$ | $SiO_2$ |
| | Metal composition ratio [at%] | In | 87.00 | 96.80 | 87.00 | 96.80 | 87.00 | 96.80 | 87.00 | 96.80 |
| | | Ga | - | - | - | - | - | - | - | - |
| | | X | 13.00 | 3.20 | 13.00 | 3.20 | 13.00 | 320 | 13.00 | 3.20 |
| | | X element | Nb | Nb | Ta | Ta | Ge | Ge | Si | Si |

| | | | Example 61 | Example 62 | Example 63 | Example 64 | Example 65 | Example 66 | Example 67 | Example 68 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] $[O_2]/([H_2O]+[Ar]+[O_2])$ | 10 | 0 | 10 | 0 | 10 | 0 | 10 | 0 |
| | | $[H_2O]/([H_2O]+[Ar]+[O_2])$ | 0 | 2 | 0 | 2 | 0 | 2 | 0 | 2 |
| | | Magnetic fluxdensitv [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel laver | Lona side [$\mu$m] | 20 | 20 | 20 | 20 | 20 | 20 | 20 | 20 |
| | | Short side [$\mu$m] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

EP 4 418 309 A1

42

Table 9

| Sputtering target | | | Example 69 | Example 70 | Example 71 | Example 72 | Example 73 | Example 74 | Example 75 | Example 76 |
|---|---|---|---|---|---|---|---|---|---|---|
| | Loaded composition ratio [mass%] | $In_2O_3$ | 89.00 | 92.00 | 91.85 | 84.77 | 82.84 | 88.46 | 96.56 | 94.25 |
| | | $Ga_2O_3$ | 7.00 | 6.00 | 3.19 | 13.63 | 13.18 | 3.37 | 2.18 | 4.47 |
| | | $X_2O_3$ | 4.00 | 2.00 | 4.96 | 1.60 | 3.98 | 8.16 | 1.27 | 1.28 |
| | | $X_2O_3$ kind | $Sm_2O_3$ | $Sm_2O_3$ | $Sm_2O_3$ | $Sm_2O_3$ | $Sm_2O_3$ | $Sm_2O_3$ | $Sm_2O_3$ | $Sm_2O_3$ |
| | Metal composition ratio [at%] | In | 86.79 | 89.78 | 91.37 | 79.80 | 78.50 | 88.50 | 95.80 | 92.50 |
| | | Ga | 10.11 | 8.67 | 4.70 | 19.00 | 18.50 | 5.00 | 3.20 | 6.50 |
| | | X | 3.10 | 1.55 | 3.93 | 120 | 3.00 | 6.50 | 1.00 | 1.00 |
| | | X element | Sm | Sm | Sm | Sm | Sm | Sm | Sm | Sm |

EP 4 418 309 A1

| | | | Example 69 | Example 70 | Example 71 | Example 72 | Example 73 | Example 74 | Example 75 | Example 76 |
|---|---|---|---|---|---|---|---|---|---|---|
| TFT production conditions | Film formation of channel layer | Pressure attime of film formation [Pa] | 0.5 | 0.5 | 0.5 | 0.5 | 0.5 | 0.5 | 0.5 | 0.5 |
| | | Flow rate ratio attime of film formation [%] — $[O_2]/([H_2O]+[Ar]+[O_2])$ | 10 | 10 | 10 | 10 | 10 | 10 | 0 | 0 |
| | | Flow rate ratio attime of film formation [%] — $[H_2O]/([H_2O]+[Ar]+[O_2])$ | 0 | 0 | 0 | 0 | 0 | 0 | 2 | 2 |
| | | Magnetic flux density [G] | 1,000 | 1,000 | 1,000 | 1,000 | 1,000 | 1,000 | 1,000 | 1,000 |
| | | Thickness [nm] | 30 | 30 | 30 | 30 | 30 | 30 | 30 | 30 |
| | | Crystallinity after film formation | Amorphous | Amorphous | Amorphous | Amorphous | Amorphous | Amorphous | Amorphous | Amorphous |
| | Patterning of channel layer | Lona side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputterina | Sputtering | Sputtering | Sputterina | Sputterina | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

(continued)

| | | | Example 77 | Example 78 | Example 79 | Example 80 | Example 81 | Example 82 | Example 83 | Example 84 |
|---|---|---|---|---|---|---|---|---|---|---|
| Sputtering target | Loaded composition ratio [mass%] | $In_2O_3$ | 92.81 | 94.00 | 88.00 | 87.50 | 89.62 | 83.00 | 82.00 | 83.20 |
| | | $Ga_2O_3$ | 2.16 | 4.00 | 11.00 | 11.00 | 9.97 | 15.00 | 16.50 | 16.20 |
| | | $X_2O_3$ | 5.03 | 2.00 | 1.00 | 1.50 | 0.41 | 2.00 | 1.50 | 0.60 |
| | | $X_2O_3$ kind | $Sm_2O_3$ | $Al_2O_3$ | $Al_2O_3$ | $Al_2O_3$ | $Al_2O_3$ | $Al_2O_3$ | $Al_2O_3$ | $Al_2O_3$ |
| | Metal composition ratio [at%] | In | 92.80 | 89.21 | 82.23 | 81.11 | 84.95 | 75.00 | 74.19 | 76.45 |
| | | Ga | 3.20 | 5.62 | 15.22 | 15.10 | 14.00 | 20.08 | 22.11 | 22.05 |
| | | X | 4.00 | 5.17 | 2.54 | 3.79 | 1.06 | 4.92 | 3.70 | 1.50 |
| | | X element | Sm | Al | Al | Al | Al | Al | Al | Al |

(continued)

| | | | Example 77 | Example 78 | Example 79 | Example 80 | Example 81 | Example 82 | Example 83 | Example 84 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation $[O_2]/([H_2O]+[Ar]+[O_2])$ | 0 | 10 | 10 | 10 | 50 | 10 | 10 | 10 |
| | | Flow rate ratio at time of film formation $[H_2O]/([H_2O]+[Ar]+[O_2])$ [%] | 2 | 0 | 0 | 0 | 0 | 0 | 0 | 0 |
| | | Magnetic flux density [G] | 1,000 | 1,000 | 1,000 | 1,000 | 1,000 | 1,000 | 1,000 | 1,000 |
| | | Thickness [nm] | 30 | 30 | 30 | 30 | 30 | 30 | 30 | 30 |
| | | Crystallinity after film formation | Amorphous | Amorphous | Amorphous | Amorphous | Amorphous | Amorphous | Amorphous | Amorphous |
| | Patterning of channel layer | Long side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

Table 10

| | | | Example 85 | Example 86 | Example 87 | Example 88 | Example 89 | Example 90 | Example 91 | Example 92 |
|---|---|---|---|---|---|---|---|---|---|---|
| | Loaded composition ratio [mass%] | $In_2O_3$ | 87.80 | 90.70 | 92.60 | 92.10 | 97.43 | 95.11 | 96.24 | 82.96 |
| | | $Ga_2O_3$ | 9.80 | 7.30 | 5.80 | 5.10 | 2.20 | 4.51 | 2.24 | 13.20 |
| | | $X_2O_3$ | 2.40 | 2.00 | 1.60 | 2.80 | 0.37 | 0.38 | 1.52 | 3.84 |
| | | $X_2O_3$ kind | $Al_2O_3$ | $Al_2O_3$ | $Al_2O_3$ | $Al_2O_3$ | $Al_2O_3$ | $Al_2O_3$ | $Al_2O_3$ | $Nd_2O_3$ |
| Sputtering target | Metal composition ratio [at%] | In | 80.66 | 84.80 | 87.73 | 85.85 | 95.80 | 92.50 | 92.80 | 78.50 |
| | | Ga | 13.33 | 10.11 | 8.14 | 7.04 | 3.20 | 6.50 | 3.20 | 18.50 |
| | | X | 600 | 5.09 | 4.13 | 7.11 | 1.00 | 1.00 | 400 | 300 |
| | | X element | Al | Al | Al | Al | Al | Al | Al | Nd |

| | | | Example 85 | Example 86 | Example 87 | Example 88 | Example 89 | Example 90 | Example 91 | Example 92 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 10 | 10 | 50 | 10 | 0 | 0 | 0 | 10 |
| | | $[H_2O]/([H_2O]+[Ar]+[O_2])$ | 0 | 0 | 0 | 0 | 2 | 2 | 2 | 0 |
| | | Magnetic flux density [G] | 1,000 | 1,000 | 1,000 | 1,000 | 1.000 | 1,000 | 1,000 | 600 |
| | | Thickness [nm] | 30 | 30 | 30 | 30 | 30 | 30 | 30 | 30 |
| | | Crystallinity after film formation | Amorphous | Amorphous | Amorphous | Amorphous | Amorphous | Amorphous | Amorphous | Amorphous |
| | Patterning of channel layer | Lona side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

EP 4 418 309 A1

(continued)

| | | | Example 93 | Example 94 | Example 95 | Example 96 | Example 97 | Example 98 | Example 99 | Example 100 |
|---|---|---|---|---|---|---|---|---|---|---|
| Sputtering target | Loaded composition ratio [mass%] | $In_2O_3$ | 96.60 | 82.57 | 96.45 | 83.06 | 96.64 | 83.03 | 96.63 | 83.02 |
| | | $Ga_2O_3$ | 2.18 | 13.14 | 2.18 | 13.22 | 2.18 | 13.21 | 2.18 | 13.21 |
| | | $X_2O_3$ | 1.22 | 4.30 | 1.37 | 3.73 | 1.18 | 3.75 | 1.19 | 3.77 |
| | | $X_2O_3$ kind | Nd2O3 | Ho2O3 | $Ho_2O_3$ | $La_2O_3$ | $La_2O_3$ | Ce2O3 | Ce2O3 | Pr2O3 |
| | Metal composition ratio [at%] | In | 95.80 | 78.50 | 95.80 | 78.50 | 95.80 | 78.50 | 95.80 | 78.50 |
| | | Ga | 3.20 | 18.50 | 3.20 | 18.50 | 3.20 | 18.50 | 3.20 | 18.50 |
| | | X | 1.00 | 300 | 1.00 | 300 | 1.00 | 300 | 1.00 | 300 |
| | | X element | Nd | Ho | Ho | La | La | Ce | Ce | Pr |

| | | | Example 93 | Example 94 | Example 95 | Example 96 | Example 97 | Example 98 | Example 99 | Example 100 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 0 | 10 | 0 | 10 | 0 | 10 | 0 | 10 |
| | | Flow rate ratio at time of film formation [%] — $[H_2O]/([H_2O]+[Ar]+[O_2])$ | 2 | 0 | 2 | 0 | 2 | 0 | 2 | 0 |
| | | Magnetic flux density [G] | 600 | 600 | 600 | 600 | 600 | 600 | 600 | 600 |
| | | Thickness [nm] | 10 | 30 | 10 | 30 | 10 | 30 | 10 | 30 |
| | | Crystallinity after film formation | Amorphous | Amorphous | Amorphous | Amorphous | Amorphous | Amorphous | Amorphous | Amorphous |
| | Patterning of channel layer | Lona side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

EP 4 418 309 A1

Table 11

| | | | Example 101 | Example 102 | Example 103 | Example 104 | Example 105 | Example 106 | Example 107 | Example 108 |
|---|---|---|---|---|---|---|---|---|---|---|
| Sputtering target | Loaded composition ratio [mass%] | $In_2O_3$ | 96.62 | 82.49 | 96.43 | 82.41 | 96.40 | 82.52 | 96.44 | 82.38 |
| | | $Ga_2O_3$ | 2.18 | 13.13 | 2.17 | 13.11 | 2.17 | 13.13 | 2.18 | 13.11 |
| | | $X_2O_3$ | 1.20 | 4.38 | 1.40 | 4.47 | 1.43 | 4.35 | 1.39 | 4.51 |
| | | $X_2O_3$ kind | $Pr_2O_3$ | $Tm_2O_3$ | $Tm_2O_3$ | $Yb_2O_3$ | $Yb_2O_3$ | $Er_2O_3$ | $Er_2O_3$ | $Lu_2O_3$ |
| | Metal composition ratio [at%] | In | 95.80 | 78.50 | 95.80 | 78.50 | 95.80 | 78.50 | 95.80 | 78.50 |
| | | Ga | 3.20 | 18.50 | 3.20 | 18.50 | 3.20 | 18.50 | 3.20 | 18.50 |
| | | X | 1.00 | 3.00 | 1.00 | 3.00 | 1.00 | 3.00 | 1.00 | 3.00 |
| | | X element | Pr | Tm | Tm | Yb | Yb | Er | Er | Lu |

| | | | Example 101 | Example 102 | Example 103 | Example 104 | Example 105 | Example 106 | Example 107 | Example 108 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio attime of film formation [%] — $[O_2]/([H_2O]+[Ar]+[O_2])$ | 0 | 10 | 0 | 10 | 0 | 10 | 0 | 10 |
| | | Flow rate ratio attime of film formation [%] — $[H_2O]/([H_2O]+[Ar]+[O_2])$ | 2 | 0 | 2 | 0 | 2 | 0 | 2 | 0 |
| | | Magnetic flux density [G] | 600 | 600 | 600 | 600 | 600 | 600 | 600 | 600 |
| | | Thickness [nm] | 10 | 30 | 10 | 30 | 10 | 30 | 10 | 30 |
| | | Crystallinity after film formation | Amorphous | Amorphous | Amorphous | Amorphous | Amorphous | Amorphous | Amorphous | Amorphous |
| | Patterning of channel layer | Lona side [$\mu$m] | 20 | 20 | 20 | 20 | 20 | 20 | 20 | 20 |
| | | Short side [$\mu$m] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

(continued)

| | | | Example 109 | Example 110 | Example 111 | Example 112 | Example 113 | Example 114 | Example 115 | Example 116 |
|---|---|---|---|---|---|---|---|---|---|---|
| Sputtering target | Loaded composition ratio [mass%] | $In_2O_3$ | 96.38 | 84.02 | 96.99 | 85.42 | 96.70 | 84.96 | 95.72 | 85.61 |
| | | $Ga_2O_3$ | 2.17 | 13.37 | 219 | 14.04 | 2.25 | 13.96 | 223 | 14.07 |
| | | $X_2O_3$ | 1.44 | 2.61 | 0.82 | 0.55 | 1.05 | 1.08 | 2.05 | 0.32 |
| | | $X_2O_3$ kind | $Lu_2O_3$ | $Y_2O_3$ | $Y_2O_3$ | $B_2O_3$ | $B_2O_3$ | $Sc_2O_3$ | $Sc_2O_3$ | MgO |
| | Metal composition ratio [at%] | In | 95.80 | 78.50 | 95.80 | 78.81 | 92.80 | 78.81 | 92.80 | 78.81 |
| | | Ga | 3.20 | 18.50 | 3.20 | 19.18 | 3.20 | 19.18 | 3.20 | 19.18 |
| | | X | 1.00 | 3.00 | 1.00 | 2.01 | 4.00 | 2.01 | 4.00 | 2.01 |
| | | X element | Lu | Y | Y | B | B | Sc | Sc | Mg |

| | | | Example 109 | Example 110 | Example 111 | Example 112 | Example 113 | Example 114 | Example 115 | Example 116 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 0 | 10 | 0 | 10 | 0 | 10 | 0 | 10 |
| | | Flow rate ratio at time of film formation [%] — $[H_2O]/([H_2O]+[Ar]+[O_2])$ | 2 | 0 | 2 | 0 | 2 | 0 | 2 | 0 |
| | | Magnetic flux density [G] | 600 | 600 | 600 | 600 | 600 | 600 | 600 | 600 |
| | | Thickness [nm] | 10 | 30 | 10 | 30 | 10 | 30 | 10 | 30 |
| | | Crystallinity after film formation | Amorphous | Amorphous | Amorphous | Amorphous | Amorphous | Amorphous | Amorphous | Amorphous |
| | Patterning of channel layer | Lona side [$\mu$m] | 20 | 20 | 20 | 20 | 20 | 20 | 20 | 20 |
| | | Short side [$\mu$m] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

Table 12

| | | | Example 117 | Example 118 | Example 119 | Example 120 | Example 121 | Example 122 | Example 123 | Example 124 |
|---|---|---|---|---|---|---|---|---|---|---|
| Sputtering target | Loaded composition ratio [mass%] | $In_2O_3$ | 97.13 | 84.80 | 95.37 | 85.08 | 95.97 | 84.49 | 94.72 | 84.82 |
| | | $Ga_2O_3$ | 2.26 | 13.93 | 2.22 | 13.98 | 223 | 13.88 | 2.21 | 13.94 |
| | | $X_2O_3$ | 0.61 | 1.27 | 2.41 | 0.94 | 1.79 | 1.63 | 3.08 | 1.25 |
| | | $X_2O_3$ kind | MgO | ZnO | ZnO | $SiO_2$ | $SiO_2$ | $GeO_2$ | $GeO_2$ | $TiO_2$ |
| | Metal composition ratio [at%] | In | 92.80 | 78.81 | 92.80 | 78.81 | 92.80 | 78.81 | 92.80 | 78.81 |
| | | Ga | 3.20 | 19.18 | 3.20 | 19.18 | 3.20 | 19.18 | 3.20 | 19.18 |
| | | X | 4.00 | 2.01 | 4.00 | 2.01 | 4.00 | 2.01 | 4.00 | 2.01 |
| | | X element | Mg | Zn | Zn | Si | Si | Ge | Ge | Ti |

|  |  |  | Example 117 | Example 118 | Example 119 | Example 120 | Example 121 | Example 122 | Example 123 | Example 124 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
|  |  | Flow rate ratio at time of film formation [%] — $[O_2]/([H_2O]+[Ar]+[O_2])$ | 0 | 10 | 0 | 10 | 0 | 10 | 0 | 10 |
|  |  | $[H_2O]/([H_2O]+[Ar]+[O_2])$ | 2 | 0 | 2 | 0 | 2 | 0 | 2 | 0 |
|  |  | Magnetic flux density [G] | 600 | 600 | 600 | 600 | 600 | 600 | 600 | 600 |
|  |  | Thickness [nm] | 10 | 30 | 10 | 30 | 10 | 30 | 10 | 30 |
|  |  | Crystallinity after film formation | Amorphous | Amorphous | Amorphous | Amorphous | Amorphous | Amorphous | Amorphous | Amorphous |
|  | Patterning of channel layer | Lona side [$\mu$m] | 20 | 20 | 20 | 20 | 20 | 20 | 20 | 20 |
|  |  | Short side [$\mu$m] | 10 | 10 | 10 | 10 | 10 | 10 | 10 | 10 |
|  | Annealing of channel layer | Temperature increase pattern [°C/min] | 10 | 10 | 10 | 10 | 10 | 10 | 10 | 10 |
|  |  | Hiohesttemperature [°C] | 350 | 350 | 350 | 350 | 350 | 350 | 350 | 350 |
|  |  | Retention time [h] | 1 | 1 | 1 | 1 | 1 | 1 | 1 | 1 |
|  |  | Atmosphere | Atmospheric | Atmospheric | Atmospheric | Atmospheric | Atmospheric | Atmospheric | Atmospheric | Atmospheric |
|  | TFT | Film formation method for buffer layer | Sputtering | Sputtering | Sputtering | Sputtering | Sputtering | Sputtering | Sputtering | Sputtering |
|  |  | Material for buffer layer | $SiO_2$ | $SiO_2$ | $SiO_2$ | $SiO_2$ | $SiO_2$ | $SiO_2$ | $SiO_2$ | $SiO_2$ |
|  |  | TFT structure | SA-TG | SA-TG | SA-TG | SA-TG | SA-TG | SA-TG | SA-TG | SA-TG |

EP 4 418 309 A1

(continued)

| Sputtering target | | | Example 125 | Example 126 | Example 127 | Example 128 | Example 129 | Example 130 | Example 131 | Example 132 |
|---|---|---|---|---|---|---|---|---|---|---|
| | Loaded composition ratio [mass%] | $In_2O_3$ | 95.41 | 81.77 | 96.15 | 83.82 | 96.92 | 82.16 | 96.30 | 83.42 |
| | | $Ga_2O_3$ | 2.22 | 13.01 | 2.17 | 13.34 | 2.19 | 13.07 | 2.17 | 13.27 |
| | | $X_2O_3$ | 2.37 | 5.22 | 1.68 | 2.84 | 0.90 | 4.76 | 1.52 | 3.31 |
| | | $X_2O_3$ kind | TiO2 | WO3 | WO3 | ZrO2 | ZrO2 | HfO2 | HfO2 | MoO3 |
| | Metal composition ratio [at%] | In | 92.80 | 78.50 | 95.80 | 78.50 | 95.80 | 78.50 | 95.80 | 78.50 |
| | | Ga | 3.20 | 18.50 | 3.20 | 18.50 | 3.20 | 18.50 | 3.20 | 18.50 |
| | | X | 4.00 | 3.00 | 1.00 | 3.00 | 1.00 | 3.00 | 1.00 | 3.00 |
| | | X element | Ti | W | W | Zr | Zr | Hf | Hf | Mo |

| | | | Example 125 | Example 126 | Example 127 | Example 128 | Example 129 | Example 130 | Example 131 | Example 132 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] $[O_2]/([H_2O]+[Ar]+[O_2])$ | 0 | 10 | 0 | 10 | 0 | 10 | 0 | 10 |
| | | Flow rate ratio at time of film formation [%] $[H_2O]/([H_2O]+[Ar]+[O_2])$ | 2 | 0 | 2 | 0 | 2 | 0 | 2 | 0 |
| | | Magnetic flux density [G] | 600 | 600 | 600 | 600 | 600 | 600 | 600 | 600 |
| | | Thickness [nm] | 10 | 30 | 10 | 30 | 10 | 30 | 10 | 30 |
| | | Crystallinity after film formation | Amorphous | Amorphous | Amorphous | Amorphous | Amorphous | Amorphous | Amorphous | Amorphous |
| | Patterning of channel layer | Lona side [$\mu$m] | 20 | 20 | 20 | 20 | 20 | 20 | 20 | 20 |
| | | Short side [$\mu$m] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

Table 13

| | | | Example 133 | Example 134 | Example 135 |
|---|---|---|---|---|---|
| Sputtering target | Loaded composition ratio [mass%] | $In_2O_3$ | 96.77 | 83.29 | 96.72 |
| | | $Ga_2O_3$ | 2.18 | 13.25 | 2.18 |
| | | $X_2O_3$ | 1.05 | 3.46 | 1.10 |
| | | $X_2O_3$ kind | $MoO_3$ | $SnO_2$ | $SnO_2$ |
| | Metal composition ratio [at%] | In | 95.80 | 78.50 | 95.80 |
| | | Ga | 3.20 | 18.50 | 3.20 |
| | | X | 1.00 | 3.00 | 1.00 |
| | | X element | Mo | Sn | Sn |
| TFT production conditions | Film formation of channel layer | Pressure at time of film formation [Pa] | 0.5 | 0.5 | 0.5 |
| | | Flow rate ratio at time of film formation [%] — $[O_2]/([H_2O]+[Ar]+[O_2])$ | 0 | 10 | 0 |
| | | Flow rate ratio at time of film formation [%] — $[H_2O]/([H_2O]+[Ar]+[O_2])$ | 2 | 0 | 2 |
| | | Magnetic flux density [G] | 600 | 600 | 600 |
| | | Thickness [nm] | 10 | 30 | 10 |
| | | Crystallinity after film formation | Amorphous | Amorphous | Amorphous |
| | Patterning of channel layer | Long side [$\mu$m] | 20 | 20 | 20 |
| | | Short side [$\mu$m] | 10 | 10 | 10 |
| | Annealing of channel layer | Temperature increase pattern [°C/min] | 10 | 10 | 10 |
| | | Highest temperature [°C] | 350 | 350 | 350 |
| | | Retention time [h] | 1 | 1 | 1 |
| | | Atmosphere | Atmospheric | Atmospheric | Atmospheric |
| | TFT | Film formation method for buffer layer | Sputtering | Sputtering | Sputtering |
| | | Material for buffer layer | $SiO_2$ | $SiO_2$ | $SiO_2$ |
| | | TFT structure | SA-TG | SA-TG | SA-TG |

Table 14

| | | | Example 136 | Example 137 | Example 138 | Example 139 | Example 140 | Example 141 | Example 142 | Example 143 |
|---|---|---|---|---|---|---|---|---|---|---|
| | Loaded composition ratio [mass%] | $In_2O_3$ | 73.28 | 94.54 | 72.98 | 94.40 | 73.36 | 94.58 | 73.34 | 94.57 |
| | | $SnO_2$ | 23.32 | 4.26 | 23.23 | 4.26 | 23.35 | 4.27 | 23.34 | 4.27 |
| | | $X_2O_3$ | 3.39 | 1.20 | 3.80 | 1.34 | 3.29 | 1.16 | 3.31 | 1.17 |
| | | $X_2O_3$ kind | $Nd_2O_3$ | $Nd_2O_3$ | $Ho_2O_3$ | $Ho_2O_3$ | $La_2O_3$ | $La_2O_3$ | $Ce_2O_3$ | $Ce_2O_3$ |
| Sputtering target | Metal composition ratio [at%] | In | 78.50 | 95.80 | 78.50 | 95.80 | 78.50 | 95.80 | 78.50 | 95.80 |
| | | Sn | 18.50 | 3.20 | 18.50 | 3.20 | 18.50 | 3.20 | 18.50 | 3.20 |
| | | X | 3.00 | 1.00 | 3.00 | 1.00 | 3.00 | 1.00 | 3.00 | 1.00 |
| | | X element | Nd | Nd | Ho | Ho | La | La | Ce | Ce |

(continued)

| | | | Example 136 | Example 137 | Example 138 | Example 139 | Example 140 | Example 141 | Example 142 | Example 143 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 10 | 0 | 10 | 0 | 10 | 0 | 10 | 0 |
| | | Flow rate ratio at time of film formation [%] — $[H_2O]/([H_2O]+[Ar]+[O_2])$ | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Long side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiG_2$ | $SiG_2$ | $SiG_2$ | $SiG_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

(continued)

| Sputtering target | | | Example 144 | Example 145 | Example 146 | Example 147 | Example 148 | Example 149 | Example 150 | Example 151 |
|---|---|---|---|---|---|---|---|---|---|---|
| | Loaded composition ratio [mass%] | $In_2O_3$ | 73.33 | 94.56 | 72.92 | 94.37 | 72.86 | 94.35 | 72.94 | 94.38 |
| | | $SnO_2$ | 23.34 | 4.27 | 23.21 | 4.26 | 23.19 | 4.26 | 23.21 | 4.26 |
| | | $X_2O_3$ | 3.33 | 1.17 | 3.87 | 1.37 | 3.95 | 1.40 | 3.84 | 1.36 |
| | | $X_2O_3$ kind | $Pr_2O_3$ | $Pr_2O_3$ | $Tm_2O_3$ | $Tm_2O_3$ | $Yb_2O_3$ | $Yb_2O_3$ | $Er_2O_3$ | $Er_2O_3$ |
| | Metal composition ratio [at%] | In | 78.50 | 95.80 | 78.50 | 95.80 | 78.50 | 95.80 | 78.50 | 95.80 |
| | | Sn | 18.50 | 3.20 | 18.50 | 3.20 | 18.50 | 3.20 | 18.50 | 3.20 |
| | | X | 3.00 | 1.00 | 3.00 | 1.00 | 3.00 | 1.00 | 3.00 | 1.00 |
| | | X element | Pr | Pr | Tm | Tm | Yb | Yb | Er | Er |

(continued)

| | | | Example 144 | Example 145 | Example 146 | Example 147 | Example 148 | Example 149 | Example 150 | Example 151 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 10 | 0 | 10 | 0 | 10 | 0 | 10 | 0 |
| | | Flow rate ratio at time of film formation [%] — $[H_2O]/([H_2O]+[Ar]+[O_2])$ | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Long side [$\mu$m] | 20 | 20 | 20 | 20 | 20 | 20 | 20 | 20 |
| | | Short side [$\mu$m] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiG_2$ | $SiG_2$ | $SiG_2$ | $SiG_2$ | $SiG_2$ | $SiG_2$ | $SiG_2$ | $SiG_2$ |
| | | TFT structure | SA-TG | SA-TG | SA-TG | SA-TG | SA-TG | SA-TG | SA-TG | SA-TG |

EP 4 418 309 A1

Table 15

| | | | Example 152 | Example 153 | Example 154 | Example 155 | Example 156 | Example 157 | Example 158 | Example 159 |
|---|---|---|---|---|---|---|---|---|---|---|
| Sputtering target | Loaded composition ratio [mass%] | $In_2O_3$ | 72.83 | 94.33 | 74.11 | 94.91 | 78.70 | 95.40 | 78.31 | 94.44 |
| | | $SnO_2$ | 23.18 | 4.26 | 23.59 | 4.28 | 20.80 | 3.57 | 20.69 | 3.54 |
| | | $X_2O_3$ | 3.99 | 1.41 | 2.30 | 0.81 | 0.50 | 1.03 | 0.99 | 2.02 |
| | | $X_2O_3$ kind | $Lu_2O_3$ | $Lu_2O_3$ | $Y_2O_3$ | $Y_2O_3$ | $B_2O_3$ | $B_2O_3$ | $Sc_2O_3$ | $Sc_2O_3$ |
| | Metal composition ratio [at%] | In | 78.50 | 95.80 | 78.50 | 95.80 | 78.81 | 92.80 | 78.81 | 92.80 |
| | | Sn | 18.50 | 3.20 | 18.50 | 3.20 | 19.18 | 3.20 | 19.18 | 3.20 |
| | | X | 3.00 | 1.00 | 3.00 | 1.00 | 2.01 | 4.00 | 2.01 | 4.00 |
| | | X element | Lu | Lu | Y | Y | B | B | Sc | Sc |

| | | | Example 152 | Example 153 | Example 154 | Example 155 | Example 156 | Example 157 | Example 158 | Example 159 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] $[O_2]/([H_2O]+[Ar]+[O_2])$ | 10 | 0 | 10 | 0 | 10 | 0 | 10 | 0 |
| | | $[H_2O]/([H_2O]+[Ar]+[O_2])$ | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Long side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

EP 4 418 309 A1

65

(continued)

| | | Example 160 | Example 161 | Example 162 | Example 163 | Example 164 | Example 165 | Example 166 | Example 167 |
|---|---|---|---|---|---|---|---|---|---|
| Sputtering target | Loaded composition ratio [mass%] | | | | | | | | |
| | $In_2O_3$ | 78.52 | 94.94 | 73.19 | 94.50 | 78.64 | 95.24 | 78.17 | 94.10 |
| | $SnO_2$ | 20.75 | 3.55 | 23.29 | 4.26 | 20.78 | 3.57 | 20.66 | 3.52 |
| | $X_2O_3$ | 0.74 | 1.50 | 3.51 | 1.24 | 0.58 | 1.19 | 1.17 | 2.38 |
| | $X_2O_3$ kind | $Al_2O_3$ | $Al_2O_3$ | $Sm_2O_3$ | $Sm_2O_3$ | MgO | MgO | ZnO | ZnO |
| | Metal composition ratio [at%] | | | | | | | | |
| | In | 78.81 | 92.80 | 78.50 | 95.80 | 78.81 | 92.80 | 78.81 | 92.80 |
| | Sn | 19.18 | 3.20 | 18.50 | 3.20 | 19.18 | 3.20 | 19.18 | 3.20 |
| | X | 2.01 | 4.00 | 3.00 | 1.00 | 2.01 | 4.00 | 2.01 | 4.00 |
| | X element | Al | Al | Sm | Sm | Mg | Mg | Zn | Zn |

(continued)

| | | | Example 160 | Example 161 | Example 162 | Example 163 | Example 164 | Example 165 | Example 166 | Example 167 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 10 | 0 | 10 | 0 | 10 | 0 | 10 | 0 |
| | | Flow rate ratio at time of film formation [%] — $[H_2O]/([H_2O]+[Ar]+[O_2])$ | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Long side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

Table 16

| | | Example 166 | Example 169 | Example 170 | Example 171 | Example 172 | Example 173 | Example 174 | Example 175 |
|---|---|---|---|---|---|---|---|---|---|
| Loaded composition ratio [mass%] | $In_2O_3$ | 76.41 | 94.69 | 77.91 | 93.46 | 78.19 | 94.14 | 72.35 | 94.11 |
| | $SnO_2$ | 20.72 | 3.55 | 20.59 | 3.50 | 20.66 | 3.52 | 23.03 | 4.25 |
| | $X_2O_3$ | 0.87 | 1.77 | 1.50 | 3.04 | 1.15 | 2.33 | 4.62 | 1.64 |
| | $X_2O_3$ kind | $SiO_2$ | $SiO_2$ | $GeO_2$ | $GeO_2$ | $TiO_2$ | $TiO_2$ | $WO_3$ | $WO_3$ |
| Sputtering target | Metal composition ratio [at%] In | 76.61 | 92.80 | 78.81 | 92.80 | 78.81 | 92.80 | 78.50 | 95.80 |
| | Sn | 19.18 | 3.20 | 19.18 | 3.20 | 19.18 | 3.20 | 18.50 | 3.20 |
| | X | 2.01 | 4.00 | 2.01 | 4.00 | 2.01 | 4.00 | 300 | 1.00 |
| | X element | Si | Si | Ge | Ge | Ti | Ti | W | W |

| | | | Example 166 | Example 169 | Example 170 | Example 171 | Example 172 | Example 173 | Example 174 | Example 175 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 10 | 0 | 10 | 0 | 10 | 0 | 10 | 0 |
| | | Flow rate ratio at time of film formation [%] — $[H_2O]/([H_2O]+[Ar]+[O_2])$ | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Lonn side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

| | | Example 181 | Example 160 | Example 179 | Example 176 | Example 177 | Example 176 |
|---|---|---|---|---|---|---|---|
| Sputtering target | Loaded composition ratio F [mass%] | | | | | | |
| | $In_2O_3$ | 94.70 | 73.64 | 94.26 | 72.66 | 94.84 | 73.95 |
| | $SnO_2$ | 4.27 | 23.44 | 4.25 | 23.13 | 4.28 | 23.54 |
| | $X_2O_3$ | 1.03 | 2.92 | 1.49 | 4.21 | 0.88 | 2.51 |
| | $X_2O_3$ kind | $MoO_3$ | $MoO_3$ | $HfO_2$ | $HfO_2$ | $ZrO_2$ | $ZrO_2$ |
| | Metal composition ratio [at%] | | | | | | |
| | In | 95.60 | 78.50 | 95.60 | 78.50 | 95.60 | 78.50 |
| | Sn | 3.20 | 18.50 | 3.20 | 18.50 | 3.20 | 18.50 |
| | X | 1.00 | 3.00 | 1.00 | 3.00 | 1.00 | 3.00 |
| | X element | Mo | Mo | Hf | Hf | Zr | Zr |

| | | | Example 176 | Example 177 | Example 176 | Example 179 | Example 160 | Example 181 |
|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 |
| | | Flow rate ratio at time of film formation [%] — $[O_2]/([H_2O]+[Ar]+[O_2])$ | 10 | 0 | 10 | 0 | 10 | 0 |
| | | Flow rate ratio at time of film formation [%] — $[H_2O]/([H_2O]+[Ar]+[O_2])$ | 0 | 2 | 0 | 2 | 0 | 2 |
| | | Magnetic flux density [G] | 600 | 600 | 600 | 600 | 600 | 600 |
| | | Thickness [nm] | 30 | 10 | 30 | 10 | 30 | 10 |
| | | Crystallinity after film formation | Amorphous | Amorphous | Amorphous | Amorphous | Amorphous | Amorphous |
| | Patterning of channel layer | Lonn side [μm] | 20 | 20 | 20 | 20 | 20 | 20 |
| | | Short side [μm] | 10 | 10 | 10 | 10 | 10 | 10 |
| | Annealing of channel layer | Temperature increase pattern [°C/min] | 10 | 10 | 10 | 10 | 10 | 10 |
| | | Highest temperature [°C] | 350 | 350 | 350 | 350 | 350 | 350 |
| | | Retention time [h] | 1 | 1 | 1 | 1 | 1 | 1 |
| | | Atmosphere | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG |

Table 17

| | | | Example 182 | Example 183 | Example 184 | Example 185 | Example 186 | Example 187 | Example 188 | Example 189 |
|---|---|---|---|---|---|---|---|---|---|---|
| Sputtering target | Loaded composition ratio [mass%] | $In_2O_3$ | 89.45 | 95.78 | 88.78 | 95.50 | 89.63 | 95.86 | 89.59 | 95.84 |
| | | ZnO | 4.37 | 1.77 | 4.33 | 1.77 | 4.37 | 1.78 | 4.37 | 1.77 |
| | | $X_2O_3$ | 6.18 | 2.44 | 6.89 | 2.74 | 6.00 | 2.37 | 6.04 | 2.39 |
| | | $X_2O_3$ kind | $Nd_2O_3$ | $Nd_2O3$ | $Ho_2O_3$ | $Ho_2O_3$ | $La_2O_3$ | $La_2O_3$ | $Ce_2O_3$ | $Ce_2O_3$ |
| | Metal composition ratio [at%] | In | 87.70 | 95.00 | 87.70 | 95.00 | 87.70 | 95.00 | 87.70 | 95.00 |
| | | Zn | 7.30 | 3.00 | 7.30 | 300 | 7.30 | 3.00 | 7.30 | 3.00 |
| | | X | 5.00 | 2.00 | 5.00 | 2.00 | 5.00 | 2.00 | 5.00 | 2.00 |
| | | X element | Nd | Nd | Ho | Ho | La | La | Ce | Ce |

72

| | | | Example 182 | Example 183 | Example 184 | Example 185 | Example 186 | Example 187 | Example 188 | Example 189 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio attime of film formation [%] — [O2]/([H2O]+[Ar]+[O2]) | 10 | 0 | 10 | 0 | 10 | 0 | 10 | 0 |
| | | [H2O]/([H2O]+[Ar]+[O2]) | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel laver | Lona side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

EP 4 418 309 A1

73

(continued)

| Sputtering target | | | Example 190 | Example 191 | Example 192 | Example 193 | Example 194 | Example 195 | Example 196 | Example 197 |
|---|---|---|---|---|---|---|---|---|---|---|
| | Loaded composition ratio [mass%] | $In_2O_3$ | 89.56 | 95.83 | 88.65 | 95.44 | 88.52 | 95.38 | 88.70 | 95.46 |
| | | ZnO | 4.37 | 1.77 | 4.33 | 1.77 | 4.32 | 1.77 | 4.33 | 1.77 |
| | | $X_2O_3$ | 6.07 | 2.40 | 7.03 | 2.79 | 7.16 | 2.85 | 6.97 | 2.77 |
| | | $X_2O_3$ kind | $Pr_2O_3$ | $Pr_2O_3$ | $Tm_2O_3$ | $Tm_2O_3$ | $Yb_2O_3$ | $Yb_2O_3$ | $Er_2O_3$ | $Er_2O_3$ |
| | Metal composition ratio [at%] | In | 87.70 | 95.00 | 87.70 | 95.00 | 87.70 | 95.00 | 87.70 | 95.00 |
| | | Zn | 7.30 | 3.00 | 7.30 | 3.00 | 7.30 | 3.00 | 7.30 | 3.00 |
| | | X | 5.00 | 2.00 | 5.00 | 2.00 | 5.00 | 2.00 | 5.00 | 2.00 |
| | | X element | Pr | Pr | Tm | Tm | Yb | Yb | Er | Er |

EP 4 418 309 A1

| | | | Example 190 | Example 191 | Example 192 | Example 193 | Example 194 | Example 195 | Example 196 | Example 197 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio attime of film formation [%] — [O2]/([H2O]+[Ar]+[O2]) | 10 | 0 | 10 | 0 | 10 | 0 | 10 | 0 |
| | | Flow rate ratio attime of film formation [%] — [H2O]/([H2O]+[Ar]+[O2]) | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel laver | Lona side [$\mu$m] | 20 | 20 | 20 | 20 | 20 | 20 | 20 | 20 |
| | | Short side [$\mu$m] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

Table 18

| | | | Example 198 | Example 199 | Example 200 | Example 201 | Example 202 | Example 203 | Example 204 | Example 205 |
|---|---|---|---|---|---|---|---|---|---|---|
| Sputtering target | Loaded composition ratio [mass %] | $In_2O_3$ | 88.45 | 95.36 | 91.31 | 96.56 | 93.79 | 95.79 | 92.78 | 95.55 |
| | | ZnO | 4.32 | 1.77 | 4.46 | 1.79 | 5.10 | 3.95 | 5.05 | 3.94 |
| | | $X_2O_3$ | 7.23 | 2.88 | 4.23 | 1.65 | 1.11 | 0.26 | 2.17 | 0.51 |
| | | $X_2O_3$ kind | $Lu_2O_3$ | $Lu_2O_3$ | $Y_2O_3$ | $Y_2O_3$ | $B_2O_3$ | $B_2O_3$ | $Sc_2O_3$ | $Sc_2O_3$ |
| | Metal composition ratio [at%] | In | 87.70 | 95.00 | 87.70 | 95.00 | 87.73 | 92.50 | 87.73 | 92.50 |
| | | Zn | 7.30 | 3.00 | 7.30 | 3.00 | 8.14 | 6.50 | 8.14 | 6.50 |
| | | X | 5.00 | 2.00 | 5.00 | 2.00 | 4.13 | 1.00 | 4.13 | 1.00 |
| | | X element | Lu | Lu | Y | Y | B | B | Sc | Sc |

| | | | Example 198 | Example 199 | Example 200 | Example 201 | Example 202 | Example 203 | Example 204 | Example 205 |
|---|---|---|---|---|---|---|---|---|---|---|
| TFT production conditions | Film formation of channel layer | Pressure attime of film formation [Pa] | 0.5 | 0.5 | 0.5 | 0.5 | 0.5 | 0.5 | 0.5 | 0.5 |
| | | Flow rate ratio attime offilm formation [%] | $[O_2]/([H_2O]+[Ar]+[O_2])$ | 10 | 0 | 10 | 0 | 10 | 0 | 10 | 0 |
| | | | $[H_2O]/([H_2O]+[Ar]+[O_2])$ | 0 | 2 | 0 | 2 | 0 | 2 | 0 | 2 |
| | | Magnetic fluxdensitv [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel laver | Lona side [μm] | 20 | 20 | 20 | 20 | 20 | 20 | 20 | 20 |
| | | Short side [μm] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

(continued)

| Sputtering target | | | Example 206 | Example 207 | Example 208 | Example 209 | Example 210 | Example 211 | Example 212 | Example 213 |
|---|---|---|---|---|---|---|---|---|---|---|
| | Loaded composition ratio [mass %] | $In_2O_3$ | 93.31 | 95.68 | 89.25 | 95.70 | 93.63 | 95.75 | 93.04 | 95.61 |
| | | ZnO | 5.08 | 3.94 | 4.36 | 1.77 | 5.09 | 3.95 | 5.06 | 3.94 |
| | | $X_2O_3$ | 1.61 | 0.38 | 6.39 | 2.53 | 1.28 | 0.30 | 1.89 | 0.45 |
| | | $X_2O_3$ kind | $Al_2O_3$ | $Al_2O_3$ | $Sm_2O_3$ | $Sm_2O_3$ | MgO | MgO | $SiO_2$ | $SiO_2$ |
| | Metal composition ratio [at%] | In | 87.73 | 92.50 | 87.70 | 95.00 | 87.73 | 92.50 | 87.73 | 92.50 |
| | | Zn | 8.14 | 6.50 | 7.30 | 3.00 | 8.14 | 6.50 | 8.14 | 6.50 |
| | | X | 4.13 | 1.00 | 5.00 | 2.00 | 4.13 | 1.00 | 4.13 | 1.00 |
| | | X element | Al | Al | Sm | Sm | Mg | Ma | Si | Si |

| | | | Example 206 | Example 207 | Example 208 | Example 209 | Example 210 | Example 211 | Example 212 | Example 213 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio attime offilm formation [%] — $[O_2]/([H_2O]+[Ar]+[O_2])$ | 10 | 0 | 10 | 0 | 10 | 0 | 10 | 0 |
| | | $[H_2O]/([H_2O]+[Ar]+[O_2])$ | 0 | 2 | 0 | 2 | 0 | 2 | 0 | 2 |
| | | Magnetic fluxdensitv [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel laver | Lona side [$\mu$m] | 20 | 20 | 20 | 20 | 20 | 20 | 20 | 20 |
| | | Short side [$\mu$m] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

Table 19

| | | | Example 214 | Example 215 | Example 216 | Example 217 | Example 218 | Example 219 | Example 220 | Example 221 |
|---|---|---|---|---|---|---|---|---|---|---|
| Sputtering target | Loaded composition ratio [mass%] | $In_2O_3$ | 91.75 | 95.30 | 92.47 | 95.47 | 87.41 | 94.91 | 90.96 | 96.41 |
| | | ZnO | 4.99 | 3.93 | 5.03 | 3.93 | 4.27 | 1.76 | 4.44 | 1.79 |
| | | $X_2O_3$ | 3.25 | 0.78 | 2.50 | 0.59 | 8.32 | 3.34 | 4.60 | 1.80 |
| | | $X_2O_3$ kind | $GeO_2$ | $GeO_2$ | $TiO_2$ | $TiO_2$ | $WO_3$ | $WO_3$ | $ZrO_2$ | $ZrO_2$ |
| | Metal composition ratio [at%] | In | 87.73 | 92.50 | 87.73 | 92.50 | 87.70 | 95.00 | 87.70 | 95.00 |
| | | Zn | 8.14 | 650 | 8.14 | 650 | 7.30 | 3.00 | 7.30 | 3.00 |
| | | X | 4.13 | 100 | 4.13 | 100 | 5.00 | 2.00 | 500 | 2.00 |
| | | X element | Ge | Ge | Ti | Ti | W | W | Zr | Zr |

(continued)

| | | | Example 214 | Example 215 | Example 216 | Example 217 | Example 218 | Example 219 | Example 220 | Example 221 |
|---|---|---|---|---|---|---|---|---|---|---|
| TFT production conditions | Film formation of channel layer | Pressure at time of film formation [Pa] | 0.5 | 0.5 | 0.5 | 0.5 | 0.5 | 0.5 | 0.5 | 0.5 |
| | | Flow rate ratio at time of film formation [%] — $[O_2]/([H_2O]+[Ar]+[O_2])$ | 10 | 0 | 10 | 0 | 10 | 0 | 10 | 0 |
| | | Flow rate ratio at time of film formation [%] — $[H_2O]/([H_2O]+[Ar]+[O_2])$ | 0 | 2 | 0 | 2 | 0 | 2 | 0 | 2 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | | Crystallinity after film formation | Amorphous | Amorphous | Amorphous | Amorphous | Amorphous | Amorphous | Amorphous | Amorphous |
| | Patterning of channel layer | Long side [$\mu$m] | 20 | 20 | 20 | 20 | 20 | 20 | 20 | 20 |
| | | Short side [$\mu$m] | 10 | 10 | 10 | 10 | 10 | 10 | 10 | 10 |
| | Annealing of channel layer | Temperature increase pattern [°C/min] | 10 | 10 | 10 | 10 | 10 | 10 | 10 | 10 |
| | | Highest temperature [°C] | 350 | 350 | 350 | 350 | 350 | 350 | 350 | 350 |
| | | Retention time [h] | 1 | 1 | 1 | 1 | 1 | 1 | 1 | 1 |
| | | Atmosphere | Atmospheric | Atmospheric | Atmospheric | Atmospheric | Atmospheric | Atmospheric | Atmospheric | Atmospheric |
| | TFT | Film formation method for buffer layer | Sputtering | Sputtering | Sputtering | Sputtering | Sputtering | Sputtering | Sputtering | Sputtering |
| | | Material for buffer layer | $SiO_2$ | $SiO_2$ | $SiO_2$ | $SiO_2$ | $SiO_2$ | $SiO_2$ | $SiO_2$ | $SiO_2$ |
| | | TFT structure | SA-TG | SA-TG | SA-TG | SA-TG | SA-TG | SA-TG | SA-TG | SA-TG |

| | | | Example 222 | Example 223 | Example 224 | Example 225 |
|---|---|---|---|---|---|---|
| Sputtering target | Loaded composition ratio [mass%] | $In_2O_3$ | 88.08 | 95.20 | 90.26 | 96.12 |
| | | ZnO | 4.30 | 1.76 | 4.41 | 1.78 |
| | | $X_2O_3$ | 7.62 | 304 | 5.34 | 2.10 |
| | | $X_2O_3$ kind | $HfO_2$ | $HfO_2$ | $MoO_3$ | $MoO_3$ |
| | Metal composition ratio [at%] | In | 87.70 | 95.00 | 87.70 | 95.00 |
| | | Zn | 7.30 | 3.00 | 7.30 | 3.00 |
| | | X | 500 | 200 | 5.00 | 200 |
| | | X element | Hf | Hf | Mo | Mo |
| | Film formation of channel layer | Pressure at time of film formation [Pa] | 0.5 | 0.5 | 0.5 | 0.5 |
| | | Flow rate ratio at time of film formation [%] $[O_2]/([H_2O]+[Ar]+[O_2])$ | 10 | 0 | 10 | 0 |
| | | $[H_2O]/([H_2O]+[Ar]+[O_2])$ | 0 | 2 | 0 | 2 |
| | | Magnetic flux density [G] | 600 | 600 | 600 | 600 |
| | | Thickness [nm] | 30 | 10 | 30 | 10 |
| | | Crystallinity after film formation | Amorphous | Amorphous | Amorphous | Amorphous |
| TFT production conditions | Patterning of channel layer | Long side [μm] | 20 | 20 | 20 | 20 |
| | | Short side [μm] | 10 | 10 | 10 | 10 |
| | Annealing of channel layer | Temperature increase pattern [°C/min] | 10 | 10 | 10 | 10 |
| | | Highest temperature [°C] | 350 | 350 | 350 | 350 |
| | | Retention time [h] | 1 | 1 | 1 | 1 |
| | | Atmosphere | Atmospheric | Atmospheric | Atmospheric | Atmospheric |
| | TFT | Film formation method for buffer layer | Sputtering | Sputtering | Sputtering | Sputtering |
| | | Material for buffer layer | $SiO_2$ | $SiO_2$ | $SiO_2$ | $SiO_2$ |
| | | TFT structure | SA-TG | SA-TG | SA-TG | SA-TG |

In Tables 1 to 19 "-" represents "0".

(A) Eavluation of Oxide Thin Film

(a) Crystallinity after Film Formation

In each of Examples and Comparative Examples, crystallinity after film formation was determined by subjecting a substrate with an oxide thin film produced in the same manner as in the substrate with an oxide thin film obtained in the section "(3) Formation of Channel Layer" to X-ray diffraction measurement.

Specifically, a parallel beam of CuKa rays (1.5418 Å) was allowed to enter the oxide thin film with an X-ray diffractometer ("SmartLab model" manufactured by Rigaku Corporation), and a diffraction pattern was measured in the range of 20 of from 10 to 80° by 20/0 measurement. The same measurement was performed also on an alkali-free glass substrate (support) before the formation of the oxide thin film. The diffraction patterns before and after the formation of the oxide thin film were compared to each other, and the oxide thin film in which the diffraction peak was not increased after the formation of the oxide thin film was determined to be "amorphous". Meanwhile, the oxide thin film in which the diffraction peak was increased after the formation of the oxide thin film was determined to be "crystalline". The results are shown in Tables 1 to 19.

The TFTs obtained in Examples and Comparative Examples were evaluated as described below. The results are shown in Tables 20 to 31. In the tables, "E+XX" means "$\times 10^{XX}$".

(B) Evaluation of Channel Layer (Crystalline Oxide Thin Film) of TFT

The crystal state of the cross-section of the channel layer in the TFT was evaluated for (a) an average spacing D between crystal grain boundaries and (b) a crystal state by pretreating the channel layer through use of a focused ion beam (FIB) device and observing the cross-section of the channel layer with a transmission electron microscope (TEM).

Specifically, first, an ion beam was applied in a direction perpendicular to the surface of the channel layer through use of a FIB ("FB2100 model" manufactured by Hitachi High-Technologies Corporation) device, and a test piece having a size of 16 µm×4 µm was sampled at an acceleration voltage of 40 kV. After that, in the sampled test piece, a sample was extracted from a region in which the gate electrode, the gate insulating film, and the oxide thin film overlapped each other in a channel length direction (horizontal direction in the drawings).

The extracted sample was processed at an acceleration voltage of 20 kV through use of a FIB ("JIB-4700F model" manufactured by JEOL Ltd.) device until the thickness of a thin section reached about 100 nm in a channel width direction (depth direction in the drawings) perpendicular to the channel length direction and the thickness direction. Thus, the thickness of the sample was reduced.

A cross-sectional TEM image was observed with a transmission electron microscope ("JEM-F200 model" manufactured by JEOL Ltd.) under the conditions that the substrate was in a flat state and no external force was applied. The acceleration voltage was set to 200 kV, and observation was performed at a magnification described later.

(a) Average Spacing D Between Crystal Grain Boundaries

An average spacing D at the time of the observation of the cross-section of the oxide thin film may be calculated by analyzing spacings between crystal grains observed with the cross-sectional TEM. In the image observed at an observation magnification of 20,000 times, a field of view was extracted so that the center matches the central portion in the channel length direction in the thin film TFT with a size of 5 µm in the channel length direction and an oxide film thickness, and the cross-sectional TEM images were observed. The average spacing D between crystal grain boundaries was calculated by performing image analysis on the field of view of the obtained cross-sectional TEM image with "SPIP, Version 4.3.2.0" manufactured by Image Metrology. Details are as described below.

With respect to the cross-sectional TEM images, lines of color codes H0, S0, V10 were drawn at the crystal grain boundaries. Further, a contrast was quantified with image analysis software, and a height of (maximum concentration-minimum concentration)×¼ was set as a threshold value. Next, a region showing a contrast having a value equal to or less than the threshold value was defined as the crystal grain boundary, and a spacing between each crystal grain boundary and the closest grain was determined and defined as the spacing between crystal grain boundaries. The total of the obtained spacings between crystal grain boundaries was divided by the number of points where the spacings were measured, to thereby determine the average spacing D between crystal grain boundaries.

Those which were determined to be "two-layer crystal" in the evaluation of (b) the crystal state described later were not able to be analyzed for grain boundaries of columnar crystals, and were hence determined to be unmeasurable.

(b) Crystal State

A method for determining the crystal state was performed by observing an electron diffraction pattern on a sample obtained by observing a cross-sectional TEM image.

Specifically, through use of an electron microscope ("JEM-F200 model" manufactured by JEOL Ltd.), the oxide thin film area observed in the cross-sectional TEM image at an observation magnification of 1,000,000 times was irradiated with an electron beam at an irradiation area of about 100 nm$\varphi$ and an acceleration voltage of 200 kV by selected-area aperture, and a diffraction pattern was measured. Ten fields of view were extracted at substantially equal spacings so that the observation points did not overlap in the range of 10 $\mu$m in the channel length direction in the cross-sectional TEM image sample. When the length in the channel length direction was short, and the range to be extracted was limited to less than 10 $\mu$m, 10 fields of view were extracted at substantially equal spacings so that observation points did not overlap each other in a range in accordance with the channel length. The oxide thin film in which clear diffraction spots were not obtained in any of the extracted ten fields of view was determined to be "amorphous". Meanwhile, the case in which diffraction points having symmetry were observed from the diffraction patterns in any one of the fields of view, and the state of two-layer crystallization was not recognized in the thickness direction of the oxide thin film in a cross-sectional TEM image in any of the fields of view was determined to be "columnar crystal".

In addition, the case in which the state of two-layer crystallization was recognized in the thickness direction of the oxide thin film in the cross-sectional TEM image was determined to be "two-layer crystal".

(c) FFT Specific Plane Orientation Percentage

A FFT specific plane orientation percentage was calculated by comparing an image, which was obtained by subjecting a TEM image obtained by observing a cross-sectional TEM image to two-dimensional Fourier transform (fast Fourier transformation: FFT), to reciprocal lattice simulation results. A FFT image was acquired by performing calculation with software imaged (free software ver. 1.451 (2011/07/20)).

For simulation, reciprocal lattice simulation and TEM image simulation about the bixbyite structure of $In_2O_3$ were performed with software ReciPro (free software ver. 4.797 (2021/03/24)). In the simulation, 14388 of Inorganic Crystal Structure Database (ICSD: Japan Association for International Chemical Information) was used as crystal structure data on the bixbyite structure, and a space group of Ia-3 and a lattice constant of a=10.17700 Å were used. In the reciprocal lattice simulation, simulation was performed to the extent that reciprocal lattice points with interplanar spacings of at least 0.8 Å were displayed, and the results were acquired with an image size in which both the vertical and horizontal sizes were the same.

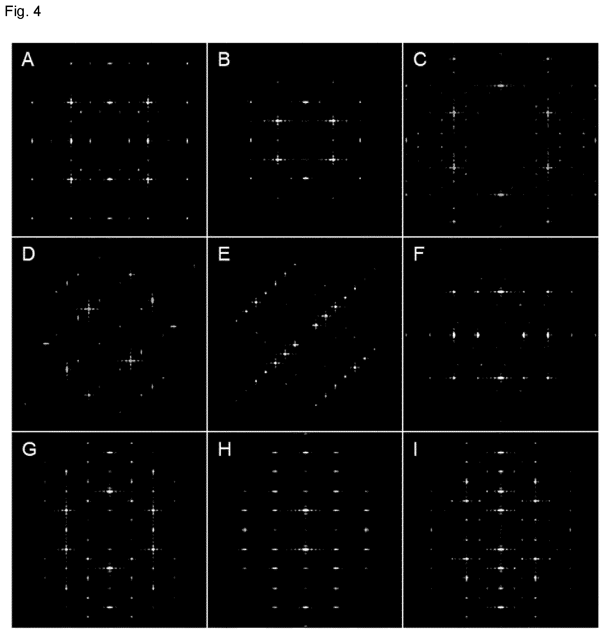

The FFT images obtained by subjecting the TEM image simulation results of the bixbyite structure of $In_2O_3$ to two-dimensional Fourier transform are shown in Fig. 4.

The patterns A, B, C, D, E, F, G, H, and I shown in Fig. 4 each correspond to crystal planes (100), (110), (111), (211), (411), (125), (210), (310), and (320) in this order.

In the TEM image, 10 fields of view were extracted at substantially equal spacings so that observation points did not overlap each other in the range of 10 $\mu$m in the channel length direction at an observation magnification of 1,000,000 times from the oxide thin film area observed in the cross-sectional TEM image. When the length in the channel length direction was short, and the range to be extracted was limited to less than 10 $\mu$m, 10 fields of view were extracted at substantially equal spacings so that observation points did not overlap each other in a range in accordance with the channel length.

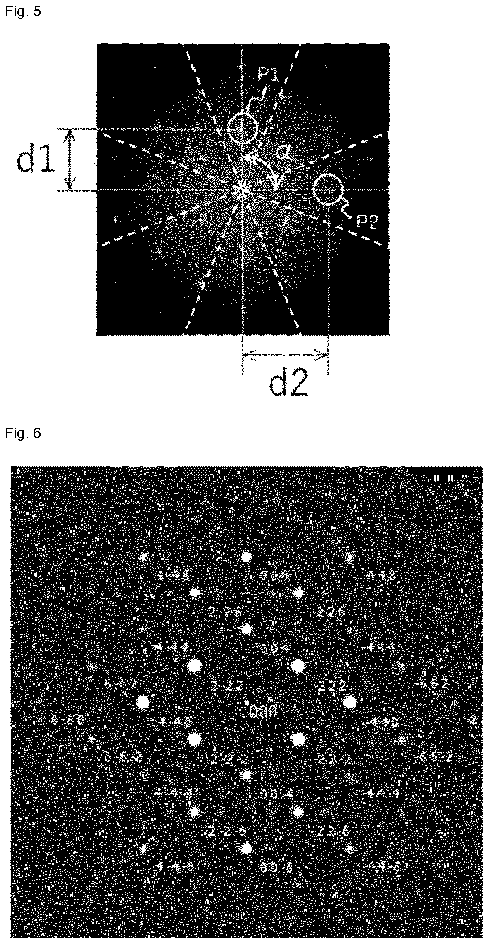

A TEM image of a lattice image in which regular atomic arrangement was able to be recognized was observed in the range of each of the extracted fields of view, which did not include crystal grain boundaries in the channel length direction and which did not include interfaces or crystal grain boundaries in the thickness direction, and whether or not the FFT image corresponded to any one of the plane orientations of the patterns A to I was evaluated by comparison to reciprocal lattice simulation (e.g., Fig. 6) regarding each of the crystal planes corresponding to the patterns of the simulation shown in Fig. 4.

Specifically, the FFT image in each of the extracted fields of view was enlarged and reduced in a range in which the size of a frequency region reached a margin of error of $\pm$10% with respect to the reciprocal lattice simulation so that the aspect ratio of the image was not changed. Then, the FFT image was rotated in a two-dimensional plane direction of the image. The FFT image thus adjusted for dimensions and inclination was superimposed on the reciprocal lattice simulation so that the centers of the images were matched with each other. Then, when eight or more coordinate points were matched in the order from the bright spot having the highest brightness to the bright spot having the lowest brightness of the FFT image in the crystal plane of any one of the patterns A to I, the field of view was determined to be a FFT specific plane orientation.

Here, when the central coordinates of each of bright spots in the FFT image fell within a range in which the number of pixels that was 2% with respect to an image size of the reciprocal lattice simulation from the central coordinates of each of the reciprocal lattice points of the reciprocal lattice simulation was set to a radius, it was determined that the coordinates were matched. A determination method for each of the crystal planes shown in Fig. 4 is described below.

A crystal plane A shown in Fig. 4 is (100), which has the property of four-fold symmetry in which the patterns are matched with each other when the image is rotated by 90° while its central coordinates are fixed. The typical interplanar spacings of the bright spots are 2.53 Å, 1.79 Å, and 1.27 Å, and the bright spots at the same interplanar spacings are located at the 90°-rotated positions. The bright spot of 1.79 Å is located on the coordinate axis rotated by 45.0° from the bright spot of 2.53 Å, and the bright spot of 1.27 Å is located on the same coordinate axis as that of the bright spot of 2.53 Å. It was recognized whether or not coordinates were matched with each other at eight bright spots arbitrarily selected from a total of 12 points: four bright spots at the interplanar spacings of 2.53 Å, four bright spots at the interplanar spacings of 1.79 Å, and four bright spots at the interplanar spacings of 1.27 Å.

A crystal plane B shown in Fig. 4 is (110), which has the property of two-fold symmetry in which the patterns are matched with each other when the image is rotated by 180° while its central coordinates are fixed. The typical interplanar spacings of the bright spots are 2.53 Å, 2.92 Å, 1.79 Å, and 1.27 Å, and the bright spots at the same interplanar spacings are located at the 180°-rotated positions. The bright spot of 2.92 Å is located on the coordinate axis rotated by 54.7° from the bright spot of 2.53 Å, the bright spot of 1.79 Å is located on the coordinate axis rotated by 35.3° from the bright spot of 2.92 Å, and the bright spot of 1.27 Å is located on the same coordinate axis as that of the bright spot of 2.53 Å. It was recognized whether or not coordinates were matched with each other at eight bright spots arbitrarily selected from a total of 10 points: two bright spots at the interplanar spacings of 2.53 Å, four bright spots at the interplanar spacings of 2.92 Å, two bright spots at the interplanar spacings of 1.79 Å, and two bright spots at the interplanar spacings of 1.27 Å.

A crystal plane C shown in Fig. 4 is (111), which has the property of six-fold symmetry in which the patterns are matched with each other when the image is rotated by 60° while its central coordinates are fixed. The typical interplanar spacings of the bright spots are 1.79 Å and 1.03 Å, and the bright spots at the same interplanar spacings are located at the 60°-rotated positions. The bright spot of 1.03 Å is located on the coordinate axis rotated by 30.0° from the bright spot of 1.79 Å. It was recognized whether or not coordinates were matched with each other at eight bright spots arbitrarily selected from a total of 12 points: six bright spots at the interplanar spacings of 1.79 Å and six bright spots at the interplanar spacings of 1.03 Å.

A crystal plane D shown in Fig. 4 is (211), which has the property of two-fold symmetry in which the patterns are matched with each other when the image is rotated by 180° while its central coordinates are fixed. The typical interplanar spacings of the bright spots are 2.92 Å, 1.53 Å, 1.79 Å, and 1.46 Å, and the bright spots at the same interplanar spacings are located at the 180°-rotated positions. The bright spot of 1.53 Å is located on the coordinate axis rotated by 58.5° from the bright spot of 2.92 Å, the bright spot of 1.79 Å is located on the coordinate axis rotated by 31.5° from the bright spot of 1.53 Å, and the bright spot of 1.46 Å is located on the same coordinate axis as that of the bright spot of 2.92 Å. It was recognized whether or not coordinates were matched with each other at eight bright spots arbitrarily selected from a total of 10 points: two bright spots at the interplanar spacings of 2.92 Å, four bright spots at the interplanar spacings of 1.53 Å, two bright spots at the interplanar spacings of 1.79 Å, and two bright spots at the interplanar spacings of 1.46 Å.

A crystal plane E shown in Fig. 4 is (411), which has the property of two-fold symmetry in which the patterns are matched with each other when the image is rotated by 180° with the central coordinates fixed. The typical interplanar spacings of the bright spots are 1.79 Å, 1.53 Å, 1.69 Å, and 0.89 Å, and the bright spots at the same interplanar spacings are located at the 180°-rotated positions. The bright spot of 1.53 Å is located on the coordinate axis rotated by 64.8° from the bright spot of 1.79 Å, the bright spot of 1.69 Å is located on the coordinate axis rotated by 25.2° from the bright spot of 1.53 Å, and the bright spot of 0.89 Å is located on the same coordinate axis as that of the bright spot of 1.79 Å. It was recognized whether or not coordinates were matched with each other at eight bright spots arbitrarily selected from a total of 10 points: two bright spots at the interplanar spacings of 1.79 Å, four bright spots at the interplanar spacings of 1.53 Å, two bright spots at the interplanar spacings of 1.69 Å, and two bright spots at the interplanar spacings of 0.89 Å.

A crystal plane F shown in Fig. 4 is (125), which has the property of two-fold symmetry in which the patterns are matched with each other when the image is rotated by 180° while its central coordinates are fixed. The typical interplanar spacings of the bright spots are 2.26 Å, 1.53 Å, 2.07 Å, and 1.38 Å, and the bright spots at the same interplanar spacings are located at the 180°-rotated positions. The bright spot of 1.53 Å is located on the coordinate axis rotated by 47.6° from the bright spot of 2.26 Å, the bright spot of 2.07 Å is located on the coordinate axis rotated by 42.4° from the bright spot of 1.53 Å, and the bright spot of 1.38 Å is located on the same coordinate axis as that of the bright spot of 2.07 Å. It was recognized whether or not coordinates were matched with each other at eight bright spots arbitrarily selected from a total of 10 points: two bright spots at the interplanar spacings of 2.26 Å, four bright spots at the interplanar spacings of 1.53 Å, two bright spots at the interplanar spacings of 2.07 Å, and two bright spots at the interplanar spacings of 1.38 Å.

A crystal plane G shown in Fig. 4 is (210), which has the property of two-fold symmetry in which the patterns are matched with each other when the image is rotated by 180° while its central coordinates are fixed. The typical interplanar spacings of the bright spots are 2.53 Å, 2.07 Å, 2.26 Å, and 1.27 Å, and the bright spots at the same interplanar spacings are located at the 180°-rotated positions. The bright spot of 2.07 Å is located on the coordinate axis rotated by 65.9° from the bright spot of 2.53 Å, the bright spot of 2.26 Å is located on the coordinate axis rotated by 24.1° from the bright spot of 2.07 Å, and the bright spot of 1.27 Å is located on the same coordinate axis as that of the bright spot of 2.53 Å. It was recognized whether or not coordinates were matched with each other at eight bright spots arbitrarily selected from a total of 10 points: two bright spots at the interplanar spacings of 2.53 Å, four bright spots at the interplanar spacings of 2.07 Å, two bright spots at the interplanar spacings of 2.26 Å, and two bright spots at the interplanar spacings of 1.27 Å.

A crystal plane H shown in Fig. 4 is (310), which has the property of two-fold symmetry in which the patterns are matched with each other when the image is rotated by 180° while its central coordinates are fixed. The typical interplanar spacings of the bright spots are 2.53 Å, 2.71 Å, 1.60 Å, and 1.27 Å, and the bright spots at the same interplanar spacings are located at the 180°-rotated positions. The bright spot of 2.71 Å is located on the coordinate axis rotated by 57.7° from the bright spot of 2.53 Å, the bright spot of 1.60 Å is located on the coordinate axis rotated by 32.3° from the bright spot of 2.71 Å, and the bright spot of 1.27 Å is located on the same coordinate axis as that of the bright spot of 2.53 Å. It was recognized whether or not coordinates were matched with each other at eight bright spots arbitrarily selected from a total of 10 points: two bright spots at the interplanar spacings of 2.53 Å, four bright spots at the interplanar spacings of 2.71 Å, two bright spots at the interplanar spacings of 1.60 Å, and two bright spots at the interplanar spacings of 1.27 Å.

A crystal plane I shown in Fig. 4 is (320), which has the property of two-fold symmetry in which the patterns are matched with each other when the image is rotated by 180° while its central coordinates are fixed. The typical interplanar spacings of the bright spots are 2.53 Å, 2.16 Å, and 2.71 Å, and the bright spots at the same interplanar spacings are located at the 180°-rotated positions. The bright spot of 2.16 Å is located on the coordinate axis rotated by 50.2° from the bright spot of 2.53 Å, and the bright spot of 2.71 Å is located on the coordinate axis rotated by 24.3° from the bright spot of 2.16 Å. It was recognized whether or not coordinates were matched with each other at eight bright spots arbitrarily selected from a total of 10 points: two bright spots at the interplanar spacings of 2.53 Å, four bright spots at the interplanar spacings of 2.16 Å, and four bright spots at the interplanar spacings of 2.71 Å.

In the case of "two-layer crystal" in which the state of two-layer crystallization of the oxide thin film in the thickness direction was recognized in the cross-sectional TEM image, the largest region that did not include the state of two-layer crystallization in the thickness direction was extracted, and whether or not the region was a FFT specific plane orientation was evaluated in the same manner as described above.

The FFT images in the ten extracted fields of view were compared to the patterns (patterns A to I) of the simulation, and the number of fields of view determined to be a FFT specific plane orientation was divided by the total number of fields of view observed (ten fields of view) ((the number of fields of view exhibiting FFT specific plane orientation)/(the total number of fields of view)) to calculate the FFT specific plane orientation percentage (%).

(d) Average of ε (Lattice Distortion)

The average of ε (lattice distortion) was calculated from the lattice constants obtained by analyzing the FFT images of the cross-sectional TEM image.

ε (lattice distortion) was calculated from the lattice constants obtained by analyzing each of FFT images in each of the fields of view determined to correspond to a FFT specific plane orientation among the 10 fields of view extracted in the section "(c) FFT Specific Plane Orientation Percentage".

Each of the fields of view was observed under the condition that the angular difference between the corresponding plane orientation and the axis of the observation direction was 1° or less.

The lattice constant was calculated from the FFT image obtained from the TEM image of the lattice image observed at an observation magnification of 1,000,000 times (see Fig. 5).

A TEM image, which included a layer in contact with the crystalline oxide thin film, and in which a direction parallel to the interface on the alkali-free glass substrate (support) side of the crystalline oxide thin film (i.e., a direction parallel to the principal surface of the crystalline oxide thin film; hereinafter referred to as "plane direction") and a direction perpendicular to the interface on the alkali-free glass substrate (support) side of the crystalline oxide thin film (i.e., a direction normal to the principal surface of the crystalline oxide thin film; hereinafter referred to as "normal direction") were able to be clearly specified, was adopted.

In the TEM image, a FFT image was acquired by performing two-dimensional Fourier transform processing on a region having a number of pixels of 512 pixels×512 pixels or more and an area of 10 nm×10 nm or more, which did not include crystal grain boundaries of the crystalline oxide thin film or adjacent layers.

Noise was removed by smoothing the resultant FFT image with a Gaussian filter, and the vertex coordinates with the highest brightness among each of the bright spots were extracted and used as the coordinates of reciprocal lattice points.

Specifically, the vertex coordinates exhibiting the highest brightness among the bright spots located on the coordinate axis extending in the normal direction from the central coordinates of the FFT image were defined as a reciprocal lattice point P1. In addition, the vertex coordinates exhibiting the highest brightness among the bright spots located on the coordinate axis extending in the plane direction from the central coordinates of the FFT image were defined as a reciprocal lattice point P2. In addition, the sizes of frequency regions (distances from the central coordinates of the FFT image) corresponding to those reciprocal lattice points P1 and P2 (vertex coordinates) were each defined as an interplanar spacing d1 and an interplanar spacing d2. The interplanar spacing was determined by converting the size of the frequency region to the length of a real space.

Then, the reciprocal lattice simulation of the bixbyite structure of $In_2O_3$ was performed in the same manner as described in the section "(c) FFT Specific Plane Orientation Percentage", and the results of the simulation of the resultant reciprocal lattice pattern (see Fig. 6; a pattern corresponding to any one of the patterns A to I and Miller indices of each of the bright spots) were compared to the pattern of the FFT image to be analyzed to specify Miller indices $(h_1, k_1, l_1)$ of the reciprocal lattice point P1 and Miller indices $(h_2, k_2, l_2)$ of the reciprocal lattice point P2. The Miller indices of each of the bright spots can be specified in the reciprocal lattice simulation, and hence the Miller indices of each of the bright spots in the FFT image to be analyzed can also be specified by comparison to the FFT image. Although each of the bright spots in the FFT image has a bright spot having the same interplanar spacing and Miller indices of an opposite sign at the position rotated by 180° when seen from the central coordinates, the Miller indices of any of positive or negative signs may be adopted because the Miller indices do not influence the calculation results of the lattice constant.

The lattice constant "a" in the normal direction was calculated by the following formula (1) from the interplanar spacing d1 and Miller indices $(h_1, k_1, l_1)$ of the reciprocal lattice point P1.

In addition, the lattice constant "b" in the plane direction was calculated by the following formula (2) from the interplanar spacing d2 and the Miller indices $(h_2, k_2, l_2)$ of the reciprocal lattice point P2.

$$\text{Lattice constant "a" in normal direction} = \sqrt{(h_1{}^2+k_1{}^2+h_1{}^2)} \times d1 \cdots \text{(Formula (1))}$$

$$\text{Lattice constant "b" in plane direction} = \sqrt{(h_2{}^2+k_2{}^2+h_2{}^2)} \times d2 \cdots \text{(Formula (2))}$$

As the reciprocal lattice point P1, specifically, a bright spot exhibiting the highest brightness at an angle closer to the substrate normal was selected from the bright spots which were present on the coordinate axis extending from the central coordinates of the FFT image, the coordinate axis forming an angle within the range of $\pm 30°$ with respect to the normal direction, and in which the interplanar spacing d1 fell within the range of from 0.8 to 2.0 Å.

In addition, as the reciprocal lattice point P2, specifically, a bright spot exhibiting the highest brightness at an angle closer to the substrate plane was selected from the bright spots which were present on the coordinate axis extending from the central coordinates of the FFT image, the coordinate axis forming an angle within the range of $\pm 30°$ with respect to the plane direction, and in which the interplanar spacing d2 fell within the range of from 0.8 to 2.0 Å.

In addition, as the reciprocal lattice point P1 and the reciprocal lattice point P2, bright spots of P1 and P2 were selected so that an angle $\alpha$ formed by the coordinate axis on which the reciprocal lattice point P1 was present and the coordinate axis on which the reciprocal lattice point P2 was present fell within the range of $70° < \alpha < 110°$.

The lattice distortion $\varepsilon$ was calculated by the following formula (3) from the lattice constant "a" in the normal direction and the lattice constant "b" in the plane direction.

$$\varepsilon = \frac{b}{a} \qquad \cdots \quad (3)$$

The average $\varepsilon_{aver}$ of $\varepsilon$ (lattice distortion) calculated for each of the fields of view was calculated by arithmetic averaging.

(C) Evaluation regarding TFT Performance

The resultant TFT was measured with a semiconductor parameter analyzer ("B1500" manufactured by Agilent) at room temperature under a light-shielding environment (inside a shield box). A drain voltage (Vd) of 20 V was applied. A current value Id was measured at a gate voltage (Vg) of from -5 V to 20 V in increments of 0.1 V for the Vd application.

Thus, Id-Vg characteristics were obtained.

Various parameters calculated from the Id-Vg characteristics are shown in Tables 20 to 31. A calculation method for each parameter is as described below.

(a) Maximum Value of Saturation Mobility

The saturation mobility ($\mu$sat) was determined from Id-Vg characteristics at the time of the application of a Vd of 20 V.

For the maximum value of the saturation mobility at the time of the application of a Vd of 20 V, a graph of Id-Vg characteristics was created, a transconductance (Gm) at each Vg was calculated, and the saturation mobility ($\mu$sat) was drawn with the formula of a saturation region. Specifically, the Gm was calculated by the following numerical formula (c1).

$$Gm = \partial \left( \sqrt{Id} \right) / \partial (Vg) \qquad (c1)$$

Further, the $\mu$sat was calculated by the following formula (c) of the saturation region.

$$\mu sat = (2 \cdot Gm \cdot L)/(W \cdot Ci) \cdots (c)$$

In the formula (c), L represents the channel length (L length) and W represents the channel width (W length).

Further, the maximum value of $\mu$sat at a Vg of from 0 to 20 V was calculated from the graph of each Vg-$\mu$sat.

(b) S Value and Vth

The S value and the threshold voltage (Vth) were evaluated from each graph of Id-Vg characteristics. Specifically, in a region at a current value Id of from $10^{-11}$ to $10^{-10}$ [A], a value determined by the following formula (d) was calculated as the S value. Further, a value of Vg at a current value Id of $10^{-8}$ [A] was calculated as the threshold voltage (Vth).

$$S = \frac{\Delta Vg}{\Delta(\log Id)} \qquad (d)$$

(c) Leakage Current

A leakage current was evaluated from each graph of Id-Vg characteristics. The leakage current was defined as a value of the Id measured when the Vg was set to -5 V.

(d) Self-Aligned Small TFT Reliability

The reliability of the TFT was evaluated by stress tests. The following three kinds of tests were performed: a positive bias temperature stress test (PBTS); a negative bias temperature stress test (NBTS); and a constant current stress test (CCS).

In the PBTS, a Vg of +20 V was applied at 50°C. The threshold voltage (Vth) after the elapse of 10,000 seconds was compared to that before the test, and the difference therebetween was represented by $\Delta$Vth.

In the NBTS, a Vg of -20 V was applied at 50°C. The threshold voltage (Vth) after the elapse of 10,000 seconds was compared to that before the test, and the difference therebetween was represented by $\Delta$Vth.

In the CCS, a Vg of 10 V and a Vd of 20 V were applied at room temperature, and a current was allowed to continuously flow by controlling the Vg so that the current value Id having flowed before the application of a stress was kept constant. The threshold voltage (Vth) after the elapse of 10,000 seconds was compared to that before the test, and the difference therebetween was represented by $\Delta$Vth.

Table 20

| | | | Example 1 | Example 2 | Example 3 | Example 4 | Example 5 | Example 8 |
|---|---|---|---|---|---|---|---|---|
| Evaluation of channel layer after production of TFT | Cross-sectional TEM | Average spacing D between crystal grain boundaries [μm] | 0.70 | 0.87 | 0.96 | 0.92 | 0.86 | 0.91 |
| | | FFT specific plane orientation ratio [%] | 80 | 100 | 100 | 70 | 100 | 100 |
| | | Average of ε | 1.03 | 1.03 | 1.03 | 1.02 | 1.04 | 1.01 |
| | | Crystal state | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 31 | 33 | 34 | 31 | 35 | 25 |
| | | S value [V/decade] | 0.22 | 0.27 | 0.24 | 0.30 | 0.25 | 0.27 |
| | | Vth [V] | 0.8 | 0.4 | 0.2 | 0.6 | 0.1 | -0.2 |
| | | Leakage current [A] | < 1E-13 | < 1E-13 | < 1E-13 | < 1E-13 | < 1E-13 | < 1E-13 |
| | Reliability of TFT | PBTS ΔVth [V] | 0.6 | 0.8 | 0.3 | 0.4 | 0.9 | 0.7 |
| | | NBTS ΔVth [V] | -0.7 | -0.6 | -0.8 | -0.9 | -1.1 | -1.1 |
| | | Constant current stress ΔVth [V] | 0.2 | 0.4 | 0.3 | 0.9 | 0.3 | 0.5 |

EP 4 418 309 A1

| | | | Example 7 | Example 8 | Example 9 | Example 10 | Example 11 |
|---|---|---|---|---|---|---|---|
| Evaluation of channel layer after production of TFT | Cross-sectional TEM | Average spacing D between crystal grain boundaries [μm] | 0.60 | 0.39 | 1.3 | 1.4 | 1.2 |
| | | FFT specific plane orientation ratio [%] | 90 | 80 | 100 | 50 | 80 |
| | | Average of ε | 1.01 | 100 | 1.04 | 1.03 | 1.02 |
| | | Crystal state | Columnar crystal | Columnar crystal | Columnar crystal | Columnar crystal | Columnar crystal |
| Performance of TFT | Characteristics of TFT | Saturation mobility [cm$^2$/Vs] | 30 | 20 | 31 | 29 | 22 |
| | | S value [V/decade] | 0.32 | 1.1 | 0.36 | 0.38 | 0.39 |
| | | Vth [V] | -0.6 | 1.0 | -0.4 | -0.2 | -1.2 |
| | | Leakage current [A] | < 1E-13 | < 1E-12 | < 1E-13 | < 1E-13 | < 1E-13 |
| | Reliability of TFT | PBTS ΔVth [V] | 0.7 | 0.6 | 0.9 | 1.0 | 1.1 |
| | | NBTS ΔVth [V] | -1.1 | 0.6 | -0.8 | -1.2 | -2.8 |
| | | Constant current stress ΔVth [V] | 0.8 | 0.8 | 0.6 | 0.9 | 0.8 |

Table 21

| | | | Example 12 | Example 13 | Example 14 | Example 15 | Example 16 | Example 17 |
|---|---|---|---|---|---|---|---|---|
| Evaluation of channel layer after production of TFT | Cross-sectional TEM | Average spacing D between crystal grain boundaries [$\mu$m] | 1.9 | 1.9 | 1.8 | 1.7 | 1.9 | 1.9 |
| | | FFT specific plane orientation ratio [%] | 100 | 100 | 100 | 80 | 100 | 70 |
| | | Average of $\varepsilon$ | 1.05 | 1.05 | 1.04 | 1.06 | 1.06 | 101 |
| | | Crystal state | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 52 | 54 | 50 | 58 | 55 | 48 |
| | | S value [V/decade] | 0.32 | 0.25 | 0.87 | 0.20 | 0.48 | 0.42 |
| | | Vth [V] | -1.8 | 0.4 | -4.8 | -0.2 | -4.5 | -3.8 |
| | | Leakage current [A] | < 1E-13 | < 1E-13 | < 1E-13 | < 1E-13 | < 1E-13 | < 1E-13 |
| | Reliability of TFT | PBTS $\triangle$Vth [V] | 0.9 | 0.5 | 1.2 | 0.7 | 32 | 1.2 |
| | | NBTS $\triangle$Vth [V] | -0.9 | -0.7 | -2.6 | -0.8 | -4.1 | -2.1 |
| | | Constant current stress $\triangle$Vth [V] | 0.8 | 0.4 | 1.0 | 0.6 | 0.9 | 1.2 |

| | | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|
| Evaluation of channel layer after production of TFT | Cross-sectional TEM | Average spacing D between crystal grain boundaries [μm] | Unmeasurable | 2.5 | Unmeasurable | Unmeasurable | 0.08 | 1.10 | 0.93 | Unmeasurable |
| | | FFT specific plane orientation ratio [%] | 30 | 40 | 20 | 30 | 20 | 30 | 40 | 0 |
| | | Average of ε | 0.99 | 100 | 111 | 112 | 0.98 | 0.98 | 1.02 | Unmeasurable |
| | | Crystal state | Two-layer crystal | Columnar crystal | Columnar crystal | Columnar crystal | Columnar crystal | Columnar crystal | Columnar crystal | Amorphous |
| Performance of TFT | Characteristics of TFT | Saturation mobility [cm²/Vs] | 15 | 25 | Crack, peeling | Crack, peeling | 4 | 10 | 9 | 5 |
| | | S value [V/decade] | Unmeasurable | 0.39 | | | 1.9 | 0.8 | 32 | 2.4 |
| | | Vth [V] | -5 or less | 0.5 | | | -3.8 | -0.5 | -3.0 | 1.2 |
| | | Leakage current [A] | < 1E-8 | < 1E-13 | | | < 1E-13 | < 1E-13 | < 1E-13 | < 1E-13 |
| | Reliability of TFT | PBTS ΔVth [V] | 5 or more | 1.1 | | | 0.6 | 0.7 | 0.7 | 0.5 |
| | | NBTS ΔVth [V] | -5 or less | -2.8 | | | -5 or less | -5 or less | -5 or less | -5 or less |
| | | Constant current stress ΔVth [V] | 5 or more | 5 or more | | | 5 or more | 5 or more | 5 or more | 5 or more |

Table 22

| | | | Example 18 | Example 19 | Example 20 | Comparative Example 9 |
|---|---|---|---|---|---|---|
| Evaluation of channel layer after production of TFT | Cross-sectional TEM image | Average spacing D between crystal grain boundaries [μm] | 2.0 | 1.6 | 1.4 | Unmeasurable |
| | | FFT specific plane orientation ratio [%] | 80 | 70 | 100 | 40 |
| | | Average of ε | 103 | 1.05 | 1.05 | 100 |
| | | Crystal state | Columnar crystal | Columnar crystal | Columnar crystal | Two-layer crystal |
| Performance of TFT | Characteristics of TFT | Saturation mobility [cm$^2$/Vs] | 33 | 33 | 37 | ON/OFF absent leakage current present |
| | | S value [V/decade] | 0.4 | 0.4 | 0.4 | |
| | | Vth [V] | -0.2 | -0.5 | -0.2 | |
| | | Leakage current [A] | < 1E-13 | < 1E-13 | < 1E-13 | |
| | Reliability of TFT | PBTS ΔVth [V] | 0.4 | 1.2 | 1.1 | ON/OFF absent |
| | | NBTS ΔVth [V] | -1.2 | -2.9 | -2.4 | |
| | | Constant current stress ΔVth [V] | 0.9 | 0.6 | 1.0 | |

| | | | Example 21 | Example 22 | Example 23 | Example 24 | Example 25 | Example 26 | Example 27 | Example 28 |
|---|---|---|---|---|---|---|---|---|---|---|
| Evaluation of channel layer after production of TFT | Cross-sectional TEM image | Average spacing D between crystal grain boundaries [μm] | 0.7 | 1.4 | 0.2 | 1.7 | 2 | 1.3 | 1.1 | 1.9 |
| | | FFT specific plane orientation ratio [%] | 70 | 70 | 60 | 70 | 60 | 80 | 70 | 100 |
| | | Averaae of ε | 102 | 104 | 102 | 101 | 104 | 1.05 | 101 | 102 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm2/Vs] | 37 | 36 | 31 | 30 | 30 | 37 | 36 | 31 |
| | | S value [V/decade] | 0.4 | 0.4 | 0.4 | 0.6 | 0.4 | 0.4 | 0.5 | 0.5 |
| | | Vth [V] | 1.1 | 1.2 | 0.8 | 0.2 | 0.7 | -0.4 | -0.4 | 0.5 |
| | | Leakaae current [A] | < 1E-13 | < 1E-13 | < 1E-13 | < 1E-13 | < 1E-13 | < 1E-13 | < 1E-13 | < 1E-13 |
| | Reliability of TFT | PBTS ΔVth [V] | 1.5 | 1.0 | 1.1 | 1.2 | 0.8 | 0.8 | 0.6 | 1.0 |
| | | NBTS ΔVth [V] | -1.4 | -1.5 | -1.6 | -2.4 | -1.4 | -1.6 | -1.0 | -1.3 |
| | | Constant current stress ΔVth [V] | 0.4 | 0.5 | 0.8 | 0.5 | 0.6 | 0.2 | 0.9 | 0.8 |

| | | | Example 29 | Example 30 | Example 31 | Example 32 | Example 33 | Example 34 | Example 35 | Example 36 |
|---|---|---|---|---|---|---|---|---|---|---|
| Evaluation of channel layer after production of TFT | Cross-sectional TEM image | Average spacing D between crystal grain boundaries [$\mu$m] | 1.1 | 0.1 | 1.7 | 2 | 0.8 | 1.6 | 1.5 | 1 |
| | | FFT specific plane orientation ratio [%] | 90 | 100 | 70 | 90 | 90 | 70 | 100 | 80 |
| | | Average of $\varepsilon$ | 104 | 1.06 | 1.06 | 103 | 103 | 101 | 104 | 102 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 37 | 34 | 31 | 37 | 30 | 32 | 34 | 34 |
| | | S value [V/decade] | 0.6 | 0.4 | 0.5 | 0.4 | 0.6 | 0.4 | 0.5 | 0.5 |
| | | Vth [V] | -0.8 | -0.1 | -0.9 | 1.1 | 0.2 | 1.0 | -0.6 | -0.3 |
| | | Leakage current [A] | < 1E-13 | < 1E-13 | < 1E-13 | < 1E-13 | < 1E-13 | < 1E-13 | < 1E-13 | < 1E-13 |
| | Reliability of TFT | PBTS $\Delta$Vth [V] | 0.6 | 1.5 | 0.6 | 1.3 | 0.6 | 0.4 | 1.2 | 1.2 |
| | | NBTS $\Delta$Vth [V] | -1.9 | -2.6 | -1.7 | -1.6 | -1.8 | -2.4 | -2.3 | -1.9 |
| | | Constant current stress $\Delta$Vth [V] | 0.6 | 1.0 | 0.3 | 0.6 | 0.7 | 0.8 | 0.9 | 0.2 |

Table 23

| | | | Example 37 | Example 38 | Example 39 | Example 40 | Example 41 | Example 42 | Example 43 | Example 44 |
|---|---|---|---|---|---|---|---|---|---|---|
| Evaluation of channel layer after production of TFT | Cross-sectional TEM image | Average spacing D between crystal grain boundaries [μm] | 0.7 | 1.3 | 0.5 | 1.3 | 1 | 0.4 | 0.1 | 0.6 |
| | | FFT specific plane orientation ratio [%] | 90 | 90 | 60 | 80 | 100 | 60 | 80 | 80 |
| | | Average of ε | 104 | 104 | 1.06 | 102 | 1.05 | 103 | 102 | 1.05 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 34 | 32 | 36 | 32 | 32 | 32 | 37 | 35 |
| | | S value [V/decade] | 0.4 | 0.6 | 0.4 | 0.6 | 0.5 | 0.6 | 0.6 | 0.6 |
| | | Vth [V] | 0.7 | -0.4 | -0.2 | 0.7 | 0.3 | 0.1 | -0.7 | -0.6 |
| | | Leakage current [A] | < 1E-13 | < 1E-13 | < 1E-13 | < 1E-13 | < 1E-13 | < 1E-13 | < 1E-13 | < 1E-13 |
| | Reliability of TFT | PBTS ΔVth [V] | 1.2 | 1.1 | 1.3 | 1.5 | 0.9 | 0.8 | 1.2 | 1.3 |
| | | NBTS ΔVth [V] | -2.5 | -2.8 | -1.4 | -1.4 | -2.5 | -1.8 | -2.6 | -2.8 |
| | | Constant current stress ΔVth [V] | 0.5 | 0.4 | 1.0 | 0.7 | 0.7 | 0.8 | 0.8 | 0.2 |

| | | | Example 45 | Example 46 | Example 47 | Example 48 | Example 49 | Example 50 | Example 51 | Example 52 |
|---|---|---|---|---|---|---|---|---|---|---|
| Evaluation of channel layer after production of TFT | Cross-sectional TEM image | Average spacing D between crystal grain boundaries [$\mu$m] | 0.4 | 0.7 | 0.1 | 12 | 0.1 | 0.8 | 1.3 | 1.8 |
| | | FFT specific plane orientation ratio [%] | 70 | 90 | 90 | 80 | 80 | 70 | 100 | 90 |
| | | Average of $\varepsilon$ | 1.06 | 106 | 102 | 104 | 1.06 | 105 | 103 | 1.06 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 36 | 35 | 33 | 36 | 32 | 32 | 34 | 35 |
| | | S value [V/decade] | 0.6 | 0.4 | 0.4 | 0.4 | 0.6 | 0.6 | 0.4 | 0.5 |
| | | Vth [V] | 1.3 | 0.3 | 0.8 | 0.9 | 0.9 | 0.4 | -1.0 | -0.9 |
| | | Leakage current [A] | < 1E-13 | < 1E-13 | < 1E-13 | < 1E-13 | < 1E-13 | < 1E-13 | < 1E-13 | < 1E-13 |
| | Reliability of TFT | PBTS $\Delta$Vth [V] | 1.2 | 0.4 | 0.8 | 0.9 | 0.4 | 1.0 | 0.5 | 1.2 |
| | | NBTS $\Delta$Vth [V] | -2.9 | -2.6 | -2.8 | -2.7 | -2.6 | -1.9 | -2.7 | -1.3 |
| | | Constant current stress $\Delta$Vth [V] | 10 | 0.5 | 0.7 | 0.5 | 0.5 | 0.5 | 0.7 | 0.2 |

| | | | Example 53 | Example 54 | Example 55 | Example 56 | Example 57 | Example 58 | Example 59 | Example 60 |
|---|---|---|---|---|---|---|---|---|---|---|
| Evaluation of channel layer after production of TFT | Cross-sectional TEM image | Average spacing D between crystal grain boundaries [μm] | 0.8 | 0.5 | 2 | 1.3 | 0.6 | 1 | 2 | 0.4 |
| | | FFT specific plane orientation ratio [%] | 90 | 90 | 90 | 60 | 80 | 70 | 70 | 60 |
| | | Average of ε | 101 | 103 | 104 | 101 | 1.05 | 102 | 104 | 1.05 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm²/Vs] | 32 | 33 | 35 | 30 | 30 | 30 | 35 | 34 |
| | | S value [V/decade] | 0.5 | 0.4 | 0.5 | 0.6 | 0.5 | 0.4 | 0.4 | 0.5 |
| | | Vth [V] | 0.2 | -0.2 | 0.7 | 1.1 | 1.1 | 1.2 | 1.1 | 0.9 |
| | | Leakage current [A] | < 1E-13 | < 1E-13 | < 1E-13 | < 1E-13 | < 1E-13 | < 1E-13 | < 1E-13 | < 1E-13 |
| | Reliability of TFT | PBTS ΔVth [V] | 0.5 | 0.9 | 1.4 | 0.5 | 1.1 | 1.0 | 1.5 | 0.9 |
| | | NBTS ΔVth [V] | -1.5 | -2.1 | -1.6 | -1.3 | -1.1 | -1.1 | -1.2 | -1.6 |
| | | Constant current stress ΔVth [V] | 0.7 | 0.7 | 0.2 | 0.3 | 0.5 | 0.3 | 0.9 | 0.7 |

Table 24

| | | | Example 61 | Example 62 | Example 83 | Example 84 | Example 85 | Example 66 | Example 87 | Example 88 |
|---|---|---|---|---|---|---|---|---|---|---|
| Evaluation of channel layer after production of TFT | Cross-sectional TEM image | Average spacing D between crystal grain boundaries [μm] | 1.7 | 0.1 | 1.5 | 1.7 | 0.8 | 0.9 | 0.6 | 1.4 |
| | | FFT specific plane orientation ratio [%] | 60 | 100 | 90 | 60 | 100 | 60 | 80 | 90 |
| | | Average of $\varepsilon$ | 1.05 | 1.04 | 1.06 | 1.03 | 1.05 | 1.03 | 1.06 | 1.06 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 36 | 32 | 33 | 35 | 31 | 31 | 36 | 34 |
| | | S value [V/decade] | 0.4 | 0.5 | 0.6 | 0.5 | 0.6 | 0.4 | 0.4 | 0.4 |
| | | Vth [V] | 0.3 | 0.2 | 0.8 | 0.4 | 0.6 | 0.9 | -0.5 | 0.3 |
| | | Leakage current [A] | < 1E-13 | < 1E-13 | < 1E-13 | < 1E-13 | < 1E-13 | < 1E-13 | < 1E-13 | < 1E-13 |
| | Reliability of TFT | PBTS $\Delta$Vth [V] | 0.5 | 0.6 | 0.5 | 0.4 | 1.0 | 0.4 | 1.0 | 0.7 |
| | | NBTS $\Delta$Vth [V] | -2.9 | -2.3 | -1.8 | -1.4 | -2.1 | -1.7 | -1.5 | -2.6 |
| | | Constant current stress $\Delta$Vth [V] | 0.8 | 0.4 | 0.2 | 1.0 | 0.4 | 0.6 | 0.8 | 0.6 |

(continued)

| | | | Example 89 | E>amole 70 | Example 71 | Example 72 | Example 73 | Example 74 | Example 75 | Example 76 |
|---|---|---|---|---|---|---|---|---|---|---|
| Evaluation of channel layer after production ofTFT | Cross-sectional TEM image | Average spacing D between crystal grain boundaries [$\mu$m] | 110 | 0.80 | 1.90 | 0.60 | 1.10 | 0.20 | 0.90 | 0.70 |
| | | FFT specific plane orientation ratio [%] | 80 | 90 | 80 | 80 | 70 | 100 | 100 | 90 |
| | | Average of $\varepsilon$ | 1.01 | 1.02 | 1.05 | 1.01 | 1.01 | 1.03 | 1.02 | 1.05 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 34 | 34 | 32 | 30 | 29 | 33 | 35 | 34 |
| | | S value [V/decade] | 0.5 | 0.4 | 0.4 | 0.4 | 0.5 | 0.5 | 0.4 | 0.6 |
| | | Vth [V] | -0.9 | 0.6 | 1 | -0.4 | 0.2 | -0.7 | 0 | 0 |
| | | Leakage current [A] | < 1E-13 | < 1E-13 | < 1E-13 | < 1E-13 | < 1E-13 | < 1E-13 | < 1E-13 | < 1E-13 |
| | Reliability of TFT | PBTS $\Delta$Vth [V] | 0.9 | 0.6 | 1.5 | 1.2 | 1.2 | 0.9 | 0.5 | 1.4 |
| | | NBTS $\Delta$Vth [V] | -1.0 | -1.5 | -1.0 | -1.8 | -2.5 | -2.6 | -2.5 | -1.0 |
| | | Constant current stress $\Delta$Vth [V] | 0.2 | 0.6 | 0.4 | 0.6 | 0.6 | 0.9 | 0.9 | 0.9 |

| | | | Example 77 | Example 78 | Example 79 | Example 80 | Example 81 | Example 82 | Example 83 | Example 84 |
|---|---|---|---|---|---|---|---|---|---|---|
| Evaluation of channel layer after production of TFT | Cross-sectional TEM image | Average spacing D between crystal grain boundaries [$\mu$m] | 200 | 1.1 | 0.3 | 1.0 | 0.8 | 1.6 | 0.7 | 0.7 |
| | | FFT specific plane orientation ratio [%] | 90 | 90 | 100 | 80 | 90 | 80 | 80 | 80 |
| | | Average of $\varepsilon$ | 1.06 | 1.03 | 1.06 | 1.04 | 1.04 | 1.06 | 1.03 | 1.05 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 35 | 36 | 35 | 36 | 31 | 35 | 35 | 31 |
| | | S value [V/decade] | 0.4 | 0.6 | 0.4 | 0.4 | 0.4 | 0.5 | 0.4 | 0.5 |
| | | Vth [V] | -0.4 | -0.25 | -0.9 | -0.85 | 1.45 | 0.3 | 0.5 | -0.8 |
| | | Leakage current [A] | < 1E-13 | < 1E-13 | < 1E-13 | < 1E-13 | < 1E-13 | < 1E-13 | < 1E-13 | < 1E-13 |
| | Reliability of TFT | PBTS $\Delta$Vth [V] | 1.0 | 1.0 | 1.3 | 1.5 | 1.5 | 0.6 | 1.2 | 1.4 |
| | | NBTS $\Delta$Vth [V] | -1.0 | -2.8 | -2.2 | -2.0 | -2.2 | -2.4 | -1.9 | -2.4 |
| | | Constant current stress $\Delta$Vth [V] | 0.8 | 0.6 | 0.9 | 0.7 | 0.2 | 0.5 | 0.8 | 0.8 |

Table 25

| | | | Example 85 | Example 86 | Example 87 | Example 88 | Example 89 | Example 90 | Example 91 | Example 92 |
|---|---|---|---|---|---|---|---|---|---|---|
| Evaluation of channel layer after production of TFT | Cross-sectional TEM image | Average spacing D between crystal grain boundaries [$\mu$m] | 0.4 | 0.4 | 0.6 | 0.3 | 0.3 | 0.2 | 1.1 | 0.2 |
| | | FFT specific plane orientation ratio [%] | 90 | 100 | 70 | 70 | 60 | 70 | 100 | 60 |
| | | Average of $\varepsilon$ | 1.05 | 1.02 | 1.03 | 1.04 | 1.05 | 1.05 | 101 | 1.05 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 35 | 31 | 37 | 29 | 37 | 28 | 31 | 33 |
| | | S value [V/decade] | 0.4 | 0.6 | 0.5 | 0.4 | 0.4 | 0.5 | 0.6 | 0.6 |
| | | Vth [V] | 0.2 | 0.3 | -0.9 | -0.5 | 0.2 | 0.5 | 1.4 | -0.4 |
| | | Leakage current ΓA1 | < 1E-13 | < 1E-13 | < 1E-13 | < 1E-13 | < 1E-13 | < 1E-13 | < 1E-13 | < 1E-13 |
| | Reliability of TFT | PBTS ΔVth [V] | 0.4 | 0.7 | 0.9 | 0.9 | 0.6 | 0.4 | 1.3 | 0.4 |
| | | NBTS ΔVth [V] | -2.7 | -2.0 | -1.3 | -2.8 | -1.9 | -2.0 | -2.4 | -1.2 |
| | | Constant current stress ΔVth [V] | 0.2 | 0.9 | 0.7 | 0.2 | 0.8 | 0.2 | 1.0 | 0.5 |

(continued)

|  |  |  | Example 93 | Example 94 | Example 95 | Example 96 | Example 97 | Example 98 | Example 99 | Example 100 |
|---|---|---|---|---|---|---|---|---|---|---|
| Evaluation of channel layer after production of TFT | Cross-sectional TEM image | Average spacing D between crystal grain boundaries [μm] | 1 | 1.2 | 0.4 | 0.2 | 0.5 | 0.9 | 0.7 | 1.1 |
|  |  | FFTspecific plane orientation ratio [%] | 60 | 90 | 90 | 80 | 70 | 70 | 80 | 100 |
|  |  | Average of ε | 1.06 | 1.02 | 1.04 | 1.03 | 1.06 | 1.01 | 1.04 | 1.01 |
|  |  | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 33 | 31 | 37 | 34 | 37 | 30 | 34 | 31 |
|  |  | S value [V/decade] | 0.5 | 0.6 | 0.6 | 0.5 | 0.5 | 0.5 | 0.4 | 0.5 |
|  |  | Vth [V] | -0.6 | 1.5 | 1.3 | 1.1 | 0.5 | 1.1 | 0.2 | 1.0 |
|  |  | Leakage current [A1] | < 1E-13 | < 1E-13 | < 1E-13 | < 1E-13 | < 1E-13 | < 1E-13 | < 1E-13 | < 1E-13 |
|  | Reliability of TFT | PBTS ΔVth [V] | 1.3 | 1.0 | 0.5 | 0.6 | 0.7 | 1.4 | 1.3 | 1.3 |
|  |  | NBTS ΔVth [V] | -1.6 | -1.8 | -1.0 | -3.0 | -2.2 | -1.5 | -2.5 | -1.3 |
|  |  | Constant current stress ΔVth [V] | 0.2 | 1.0 | 0.8 | 0.3 | 0.2 | 0.3 | 0.7 | 0.4 |

| | | | Example 101 | Example 102 | Example 103 | Example 104 | Example 105 | Example 106 | Example 107 | Example 108 |
|---|---|---|---|---|---|---|---|---|---|---|
| Evaluation of channel layer after production of TFT | Cross-sectional TEM image | Average spacing D between crystal grain boundaries [μm] | 1.2 | 1.9 | 2 | 0.8 | 0.1 | 1.3 | 0.4 | 0.5 |
| | | FFTspecific plane orientation ratio [%] | 70 | 70 | 80 | 60 | 80 | 90 | 90 | 80 |
| | | Average of ε | 1.04 | 1.03 | 1.04 | 1.04 | 1.04 | 1.02 | 1.03 | 1.05 |
| | | Crystal state | Columnar crystal | Columnar crystal | Columnar crystal | Columnar crystal | Columnar crystal | Columnar crystal | Columnar crystal | Columnar crystal |
| Performance ofTFT | Characteristics of TFT | Saturation mobility [cm²/Vs] | 33 | 31 | 31 | 35 | 35 | 31 | 33 | 36 |
| | | S value [V/decade] | 0.5 | 0.4 | 0.4 | 0.4 | 0.5 | 0.6 | 0.6 | 0.4 |
| | | Vth [V] | -0.3 | -0.4 | 0.1 | 0.6 | 0.2 | 0.8 | 0.8 | 0.2 |
| | | Leakage current ΓA1 | < 1E-13 | < 1E-13 | < 1E-13 | < 1E-13 | < 1E-13 | < 1E-13 | < 1E-13 | < 1E-13 |
| | Reliability of TFT | PBTS ΔVth [V] | 1.3 | 1.1 | 0.4 | 0.9 | 0.6 | 1.2 | 0.5 | 0.4 |
| | | NBTS ΔVth [V] | -2.7 | -1.8 | -1.3 | -2.9 | -2.5 | -1.5 | -2.4 | -2.9 |
| | | Constant current stress ΔVth [V] | 0.3 | 0.2 | 0.6 | 0.2 | 0.4 | 0.3 | 0.2 | 0.3 |

Table 26

| | | | Example 109 | Example 110 | Example 111 | Example 112 | Example 113 | Example 114 | Example 115 | Example 116 |
|---|---|---|---|---|---|---|---|---|---|---|
| Evaluation of channel layer after production of TFT | Cross-sectional TEM image | Average spacing D between crystal grain boundaries [μm] | 1.9 | 1.7 | 1.6 | 1.9 | 2 | 0.7 | 1.7 | 1.6 |
| | | FFT specific plane orientation ratio [%] | 100 | 80 | 90 | 100 | 90 | 70 | 80 | 70 |
| | | Average of ε | 1.01 | 1.02 | 1.01 | 1.03 | 1.05 | 1.05 | 1.03 | 1.06 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm²/Vs] | 32 | 34 | 36 | 32 | 33 | 32 | 30 | 29 |
| | | S value [V/decade] | 0.6 | 0.6 | 0.5 | 0.5 | 0.5 | 0.4 | 0.6 | 0.4 |
| | | Vth [V] | 0.7 | 0.9 | 0.6 | 0.7 | 0.8 | 1.5 | 1.2 | -0.1 |
| | | Leakage current ΓA1 | < 1E-13 | < 1E-13 | < 1E-13 | < 1E-13 | < 1E-13 | < 1E-13 | < 1E-13 | < 1E-13 |
| | Reliability ofTFT | PBTS ΔVth [V] | 1.0 | 1.5 | 1.0 | 1.5 | 1.2 | 1.2 | 0.7 | 1.4 |
| | | NBTS ΔVth [V] | -2.8 | -3.0 | -1.3 | -3.0 | -2.4 | -1.5 | -2.2 | -2.7 |
| | | Constant current stress ΔVth [V] | 0.8 | 0.6 | 1.0 | 0.6 | 0.2 | 0.7 | 0.5 | 0.7 |

(continued)

| | | | Example 117 | Example 118 | Example 119 | Example 120 | Example 121 | Example 122 | Example 123 | Example 124 |
|---|---|---|---|---|---|---|---|---|---|---|
| Evaluation of channel layer after production of TFT | Cross-sectional TEM image | Average spacing D between crystal grain boundaries [$\mu$m] | 0.8 | 0.6 | 0.2 | 0.3 | 0.7 | 2 | 0.8 | 1.4 |
| | | FFT specific plane orientation ratio [%] | 60 | 60 | 90 | 80 | 70 | 90 | 100 | 80 |
| | | Average of $\varepsilon$ | 1.02 | 1.03 | 1.02 | 1.06 | 1.02 | 1.01 | 1.05 | 1.05 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 35 | 37 | 30 | 32 | 31 | 35 | 32 | 34 |
| | | S value [V/decade] | 0.5 | 0.4 | 0.4 | 0.5 | 0.4 | 0.6 | 0.4 | 0.5 |
| | | Vth [V] | 1.0 | 0.9 | -0.1 | 0.1 | 1.0 | 0.8 | 0.9 | -0.8 |
| | | Leakage current [A] | < 1E-13 | < 1E-13 | < 1E-13 | < 1E-13 | < 1E-13 | < 1E-13 | < 1E-13 | < 1E-13 |
| | Reliability of TFT | PBTS $\Delta$Vth [V] | 0.5 | 0.4 | 0.5 | 1.3 | 1.3 | 0.9 | 0.8 | 0.7 |
| | | NBTS $\Delta$Vth [V] | -2.0 | -2.1 | -2.3 | -1.5 | -2.9 | -2.5 | -2.2 | -1.1 |
| | | Constant current stress $\Delta$Vth [V] | 0.5 | 0.4 | 0.9 | 0.4 | 0.6 | 1.0 | 0.8 | 0.4 |

| | | | Example 125 | Example 126 | Example 127 | Example 128 | Example 129 | Example 130 | Example 131 | Example 132 |
|---|---|---|---|---|---|---|---|---|---|---|
| Evaluation of channel layer after production of TFT | Cross-sectional TEM image | Average spacing D between crystal grain boundaries [μm] | 0.9 | 1.8 | 0.7 | 1.6 | 0.1 | 1.5 | 1.5 | 1.7 |
| | | FFT specific plane orientation ratio [%] | 100 | 100 | 80 | 90 | 100 | 70 | 100 | 70 |
| | | Average of ε | 1.02 | 1.06 | 1.04 | 1.05 | 1.03 | 1.04 | 1.05 | 1.04 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility [cm$^2$/Vs] | 33 | 33 | 31 | 37 | 35 | 34 | 33 | 34 |
| | | S value [V/decade] | 0.4 | 0.6 | 0.6 | 0.4 | 0.5 | 0.5 | 0.5 | 0.4 |
| | | Vth [V] | 0.8 | 1.1 | -0.2 | 1.2 | -0.1 | 1.5 | 1.6 | -0.9 |
| | | Leakage current ΓA1 | < 1E-13 | < 1E-13 | < 1E-13 | < 1E-13 | < 1E-13 | < 1E-13 | < 1E-13 | < 1E-13 |
| | Reliability of TFT | PBTS ΔVth [V] | 1.3 | 0.9 | 0.4 | 1.4 | 0.9 | 1.5 | 0.4 | 0.5 |
| | | NBTS ΔVth [V] | -1.9 | -2.6 | -1.8 | -1.1 | -1.7 | -2.2 | -2.9 | -2.9 |
| | | Constant current stress ΔVth [V] | 0.5 | 0.9 | 1.0 | 0.5 | 0.2 | 0.2 | 0.7 | 0.3 |

Table 27

| | | | Example 133 | Example 134 | Example 135 |
|---|---|---|---|---|---|
| Evaluation of channel layer after production of TFT | Cross-sectional TEM image | Average spacing D between crystal grain boundaries [μm] | 2 | 0.7 | 0.9 |
| | | FFT specific plane orientation ratio [%] | 90 | 80 | 100 |
| | | Average of ε | 1.01 | 1.01 | 1.04 |
| | | Crystal state | Columnar crystal | Columnar crystal | Columnar crystal |
| Performance ofTFT | Characteristics of TFT | Saturation mobility [cm$^2$/Vs] | 37 | 35 | 33 |
| | | S value [V/decade] | 0.4 | 0.4 | 0.6 |
| | | Vth [V] | -0.3 | 0.5 | 0.7 |
| | | Leakage current [A] | < 1E-13 | < 1E-13 | < 1E-13 |
| | Reliability of TFT | PBTS ΔVth [V] | 0.9 | 1.0 | 1.1 |
| | | NBTS ΔVth [V] | -2.3 | -1.1 | -2.7 |
| | | Constant current stress ΔVth [V] | 0.2 | 0.4 | 0.3 |

Table 28

| | | | Example 136 | Example 137 | Example 138 | Example 139 | Example 140 | Example 141 | Example 142 | Example 143 |
|---|---|---|---|---|---|---|---|---|---|---|
| Evaluation of channel layer after production of TFT | Cross-sectional TEM image | Average spacing D between crystal grain boundaries [μm] | 1.9 | 1.3 | 0.3 | 0.6 | 1.2 | 1.7 | 2 | 0.3 |
| | | FFT specific plane orientation ratio (%) | 80 | 80 | 80 | 70 | 90 | 80 | 80 | 100 |
| | | Average of ε | 1.01 | 1.03 | 1.04 | 1.06 | 1.02 | 1.05 | 1.04 | 1.05 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility (cm²/Vs) | 30 | 30 | 30 | 36 | 33 | 36 | 37 | 32 |
| | | S value (V/decade) | 0.6 | 0.4 | 0.5 | 0.6 | 0.6 | 0.4 | 0.5 | 0.6 |
| | | Vth (V) | 1.1 | -1.0 | 0.6 | 1.2 | -0.4 | 0.2 | 0.5 | 0.5 |
| | | Leakage current (A) | < 1E-13 | < 1E-13 | < 1E-13 | < 1E-13 | < 1E-13 | < 1E-13 | < 1E-13 | < 1E-13 |
| | Reliability of TFT | PBTS ΔVth (V) | 1.2 | 1.5 | 1.2 | 1.5 | 1.5 | 1.4 | 0.7 | 1.4 |
| | | NBTS ΔVth (V) | -1.4 | -2.5 | -2.9 | -2.7 | -1.8 | -1.8 | -2.3 | -2.0 |
| | | Constant current stress ΔVth (V) | 0.7 | 0.2 | 0.6 | 0.2 | 0.6 | 0.9 | 0.4 | 0.3 |

(continued)

| | | | Example 144 | Example 145 | Example 146 | Example 147 | Example 148 | Example 149 | Example 150 | Example 151 |
|---|---|---|---|---|---|---|---|---|---|---|
| Evaluation of channel layer after production of TFT | Cross-sectional TEM image | Average spacing D between crystal grain boundaries [$\mu$m] | 1.2 | 1.2 | 1.7 | 1.7 | 0.6 | 1.3 | 0.4 | 0.9 |
| | | FFTspecific plane orientation ratio (%) | 100 | 70 | 90 | 80 | 90 | 90 | 80 | 70 |
| | | Average of $\varepsilon$ | 1.02 | 1.05 | 1.04 | 1.01 | 1.04 | 1.02 | 1.03 | 1.06 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility (cm$^2$/Vs) | 30 | 30 | 34 | 38 | 38 | 31 | 35 | 30 |
| | | S value (V/decade) | 0.6 | 0.4 | 0.4 | 0.4 | 0.5 | 0.5 | 0.5 | 0.6 |
| | | Vth (V) | 1.4 | 1.1 | 0.5 | -0.3 | 0.2 | 0.1 | -0.4 | 1.0 |
| | | Leakage current (A) | < 1E-13 | < 1E-13 | < 1E-13 | < 1E-13 | < 1E-13 | < 1E-13 | < 1E-13 | < 1E-13 |
| | Reliability of TFT | PBTS $\Delta$Vth (V) | 0.9 | 1.1 | 0.6 | 0.5 | 1.5 | 1.0 | 1.0 | 0.8 |
| | | NBTS $\Delta$Vth (V) | -3.0 | -2.3 | -2.2 | -1.8 | -1.1 | -1.6 | -1.3 | -1.4 |
| | | Constant current stress $\Delta$Vth (V) | 0.4 | 0.9 | 0.9 | 0.9 | 1.0 | 0.3 | 0.2 | 0.9 |

(continued)

| | | | Example 152 | Example 153 | Example 154 | Example 155 | Example 156 | Example 157 | Example 158 | Example 159 |
|---|---|---|---|---|---|---|---|---|---|---|
| Evaluation of channel layer after production of TFT | Cross-sectional TEM image | Average spacing D between crystal grain boundaries [$\mu$m] | 0.5 | 0.6 | 1.2 | 0.7 | 1.4 | 1.3 | 1.2 | 2 |
| | | FFTspecific plane orientation ratio (%) | 80 | 80 | 90 | 90 | 90 | 90 | 90 | 70 |
| | | Average of $\varepsilon$ | 1.01 | 1.04 | 1.01 | 1.03 | 1.06 | 1.02 | 1.04 | 1.04 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility (cm$^2$A/s) | 35 | 30 | 35 | 35 | 33 | 37 | 31 | 34 |
| | | S value (V/decade) | 0.4 | 0.5 | 0.5 | 0.5 | 0.5 | 0.6 | 0.5 | 0.6 |
| | | Vth (V) | -0.1 | -0.9 | 1.4 | -0.2 | 0.1 | -0.7 | -0.8 | 0.6 |
| | | Leakage current (A) | < 1E-13 | < 1E-13 | < 1E-13 | < 1E-13 | < 1E-13 | < 1E-13 | < 1E-13 | < 1E-13 |
| | Reliability of TFT | PBTS $\Delta$Vth (V) | 1.4 | 0.6 | 0.8 | 1.0 | 1.1 | 1.0 | 0.4 | 0.7 |
| | | NBTS $\Delta$Vth (V) | -1.8 | -3.0 | -2.7 | -2.2 | -2.4 | -3.0 | -2.5 | -2.5 |
| | | Constant current stress $\Delta$Vth (V) | 0.8 | 0.8 | 0.9 | 0.6 | 0.2 | 0.6 | 0.2 | 0.7 |

Table 29

| | | | Example 160 | Example 161 | Example 162 | Example 163 | Example 164 | Example 165 | Example 166 | Example 167 |
|---|---|---|---|---|---|---|---|---|---|---|
| Evaluation of channel layer after production of TFT | Cross-sectional TEM image | Average spacing D between crystal grain boundaries [μm] | 1.6 | 1.8 | 0.9 | 1.1 | 0.5 | 1.3 | 0.2 | 0.1 |
| | | FFT specific plane orientation ratio (%) | 80 | 80 | 70 | 70 | 80 | 90 | 100 | 80 |
| | | Average of ε | 101 | 101 | 102 | 1.05 | 1.05 | 103 | 101 | 1.04 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility (cm²/Vs) | 32 | 34 | 31 | 37 | 31 | 30 | 36 | 35 |
| | | S value (V/decade) | 0.6 | 0.5 | 0.5 | 0.6 | 0.4 | 0.4 | 0.5 | 0.5 |
| | | Vth (V) | -0.5 | -0.2 | 0.9 | -0.9 | -0.6 | 1.1 | -0.9 | 1.1 |
| | | Leakage current (A) | < 1E-13 | < 1E-13 | < 1E-13 | < 1E-13 | < 1E-13 | <1E-13 | < 1E-13 | < 1E-13 |
| | Reliability of TFT | PBTS ΔVth (V) | 0.8 | 0.4 | 0.8 | 1.2 | 1.5 | 1.0 | 0.6 | 0.5 |
| | | NBTS ΔVth (V) | -1.3 | -2.7 | -1.9 | -2.6 | -1.9 | -2.0 | -1.9 | -1.0 |
| | | Constant current stress ΔVth (V) | 0.5 | 0.5 | 0.5 | 0.8 | 1.0 | 0.7 | 0.6 | 0.5 |

| | | | Example 168 | Example 169 | Example 170 | Example 171 | Example 172 | Example 173 | Example 174 | Example 175 |
|---|---|---|---|---|---|---|---|---|---|---|
| Evaluation of channel layer after production of TFT | Cross-sectional TEM image | Average spacing D between crystal grain boundaries [$\mu$m] | 2 | 2 | 0.1 | 1 | 1.8 | 1.2 | 1.2 | 1.6 |
| | | FFT specific plane orientation ratio (%) | 60 | 90 | 90 | 90 | 80 | 70 | 70 | 70 |
| | | Average of $\varepsilon$ | 104 | 103 | 102 | 104 | 102 | 102 | 103 | 102 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility (cm$^2$/Vs) | 32 | 37 | 31 | 32 | 36 | 36 | 35 | 30 |
| | | S value (V/decade) | 0.6 | 0.6 | 0.4 | 0.6 | 0.4 | 0.6 | 0.6 | 0.5 |
| | | Vth (V) | -0.7 | 1.4 | 0.9 | 1.3 | 0.6 | 1.1 | 1.3 | 0.9 |
| | | Leakage current (A) | < 1E-13 | < 1E-13 | < 1E-13 | < 1E-13 | < 1E-13 | <1E-13 | < 1E-13 | < 1E-13 |
| | Reliability of TFT | PBTS $\Delta$Vth (V) | 0.8 | 1.1 | 0.8 | 1.2 | 0.6 | 1.5 | 0.7 | 1.4 |
| | | NBTS $\Delta$Vth (V) | -1.3 | -12 | -2.5 | -2.5 | -2.5 | -1.8 | -2.8 | -1.3 |
| | | Constant current stress $\Delta$Vth (V) | 0.2 | 0.9 | 0.7 | 0.9 | 0.9 | 0.4 | 0.9 | 0.5 |

|  |  |  | Example 176 | Example 177 | Example 178 | Example 179 | Example 180 | Example 181 |
|---|---|---|---|---|---|---|---|---|
| Evaluation of channel layer after production of TFT | Cross-sectional TEM image | Average spacing D between crystal grain boundaries [$\mu$m] | 1.9 | 1.6 | 1.5 | 1 | 1.8 | 1.3 |
|  |  | FFT specific plane orientation ratio (%) | 90 | 90 | 60 | 80 | 100 | 80 |
|  |  | Average of $\varepsilon$ | 1.06 | 1.06 | 102 | 102 | 103 | 1.06 |
|  |  | Crystal state | Columnar crystal | Columnar crystal | Columnar crystal | Columnar crystal | Columnar crystal | Columnar crystal |
| Performance of TFT | Characteristics of TFT | Saturation mobility (cm$^2$/Vs) | 36 | 34 | 33 | 30 | 35 | 37 |
|  |  | S value (V/decade) | 0.6 | 0.6 | 0.5 | 0.4 | 0.4 | 0.5 |
|  |  | Vth (V) | -0.1 | 0.2 | 10 | 0.7 | -0.8 | 0.3 |
|  |  | Leakage current (A) | < 1E-13 | < 1E-13 | < 1E-13 | < 1E-13 | < 1E-13 | < 1E-13 |
|  | Reliability of TFT | PBTS $\Delta$Vth (V) | 1.4 | 1.4 | 0.9 | 0.7 | 0.7 | 0.7 |
|  |  | NBTS $\Delta$Vth (V) | -2.9 | -2.1 | -2.9 | -2.0 | -3.0 | -2.4 |
|  |  | Constant current stress $\Delta$Vth (V) | 0.6 | 0.2 | 0.8 | 0.9 | 0.8 | 1.0 |

Table 30

| | | | Example 182 | Example 183 | Example 184 | Example 185 | Example 186 | Example 187 | Example 188 | Example 189 |
|---|---|---|---|---|---|---|---|---|---|---|
| Evaluation of channel layer after production of TFT | Cross-sectional TEM image | Average spacing D between crystal grain boundaries [$\mu$m] | 1.8 | 1 | 0.1 | 0.4 | 1.9 | 1.8 | 1.8 | 0.3 |
| | | FFT specific plane orientation ratio (%) | 100 | 90 | 60 | 70 | 60 | 60 | 80 | 90 |
| | | Average of $\varepsilon$ | 1.03 | 1.06 | 1.06 | 1.06 | 1.02 | 1.04 | 1.06 | 1.05 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility (cm$^2$/Vs) | 34 | 30 | 31 | 33 | 31 | 33 | 32 | 36 |
| | | S value (V/decade) | 0.6 | 0.6 | 0.4 | 0.5 | 0.5 | 0.6 | 0.6 | 0.5 |
| | | Vth (V) | -0.3 | 1.4 | 1.0 | 0.9 | -0.1 | -0.4 | -0.9 | -1.0 |
| | | Leakage current (A) | < 1E-13 | < 1E-13 | < 1E-13 | < 1E-13 | < 1E-13 | < 1E-13 | < 1E-13 | < 1E-13 |
| | Reliability of TFT | PBTS $\Delta$Vth (V) | 1.1 | 0.4 | 0.4 | 1.0 | 0.9 | 1.1 | 1.1 | 1.0 |
| | | NBTS $\Delta$Vth (V) | -2.5 | -3.0 | -1.5 | -2.1 | -1.6 | -2.2 | -2.7 | -2.5 |
| | | Constant current stress $\Delta$Vth (V) | 1.0 | 0.8 | 0.5 | 0.4 | 0.6 | 0.3 | 0.4 | 0.9 |

| | | | Example 190 | Example 191 | Example 192 | Example 193 | Example 194 | Example 195 | Example 196 | Example 197 |
|---|---|---|---|---|---|---|---|---|---|---|
| Evaluation of channel layer after production of TFT | Cross-sectional TEM image | Average spacing D between crystal grain boundaries [$\mu$m] | 0.5 | 0.7 | 1.5 | 1.5 | 1 | 0.9 | 0.9 | 0.3 |
| | | FFT specific plane orientation ratio (%) | 70 | 90 | 70 | 70 | 90 | 100 | 100 | 80 |
| | | Average of $\varepsilon$ | 1.01 | 1.04 | 1.02 | 1.04 | 1.06 | 1.03 | 1.03 | 1.06 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility (cm$^2$/Vs) | 33 | 37 | 33 | 38 | 29 | 33 | 35 | 36 |
| | | S value (V/decade) | 0.6 | 0.4 | 0.5 | 0.4 | 0.4 | 0.6 | 0.4 | 0.5 |
| | | Vth (V) | -0.4 | -0.8 | -0.7 | -0.9 | 0.2 | 1.2 | 0.6 | 1.1 |
| | | Leakage current (A) | < 1E-13 | < 1E-13 | < 1E-13 | < 1E-13 | < 1E-13 | < 1E-13 | < 1E-13 | < 1E-13 |
| | Reliability of TFT | PBTS $\Delta$Vth (V) | 1.4 | 0.4 | 1.3 | 1.3 | 0.4 | 0.5 | 1.5 | 1.5 |
| | | NBTS $\Delta$Vth (V) | -2.1 | -1.1 | -2.7 | -1.1 | -1.7 | -2.4 | -2.5 | -1.3 |
| | | Constant current stress $\Delta$Vth (V) | 0.6 | 0.6 | 0.3 | 0.2 | 0.9 | 0.6 | 0.7 | 0.4 |

| | | | Example 198 | Example 199 | Example 200 | Example 201 | Example 202 | Example 203 | Example 204 | Example 205 |
|---|---|---|---|---|---|---|---|---|---|---|
| Evaluation of channel layer after production of TFT | Cross-sectional TEM image | Average spacing D between crystal grain boundaries [μm] | 0.5 | 0.3 | 0.1 | 0.4 | 1.5 | 0.4 | 1 | 1.9 |
| | | FFT specific plane orientation ratio (%) | 70 | 100 | 80 | 70 | 60 | 70 | 70 | 80 |
| | | Average of ε | 1.04 | 1.04 | 1.01 | 1.02 | 1.05 | 1.03 | 1.06 | 1.01 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility (cm$^2$/Vs) | 37 | 32 | 38 | 34 | 37 | 30 | 30 | 34 |
| | | S value (V/decade) | 0.6 | 0.5 | 0.4 | 0.4 | 0.5 | 0.5 | 0.4 | 0.5 |
| | | Vth (V) | 0.7 | 1.5 | -0.9 | 0.5 | 1.1 | 0.3 | 0.9 | -0.3 |
| | | Leakage current (A) | < 1E-13 | < 1E-13 | < 1E-13 | < 1E-13 | < 1E-13 | < 1E-13 | < 1E-13 | < 1E-13 |
| | Reliability of TFT | PBTS ΔVth (V) | 0.5 | 1.0 | 0.9 | 1.5 | 1.2 | 0.5 | 1.1 | 1.2 |
| | | NBTS ΔVth (V) | -2.8 | -2.1 | -2.5 | -3.0 | -1.6 | -2.7 | -2.2 | -2.7 |
| | | Constant current stress ΔVth (V) | 0.6 | 0.7 | 0.9 | 0.4 | 0.9 | 0.4 | 1.0 | 0.3 |

EP 4 418 309 A1

Table 31

| | | | Example 206 | Example 207 | Example 208 | Example 209 | Example 210 | Example 211 | Example 212 | Example 213 |
|---|---|---|---|---|---|---|---|---|---|---|
| Evaluation of channel layer after production of TFT | Cross-sectional TEM image | Average spacing D between crystal grain boundaries [μm] | 0.3 | 1.7 | 1.7 | 1 | 1.1 | 0.9 | 1.5 | 0.8 |
| | | FFT specific plane orientation ratio (%) | 70 | 90 | 60 | 80 | 70 | 90 | 70 | 90 |
| | | Average of ε | 1.01 | 1.04 | 1.03 | 1.03 | 1.01 | 1.03 | 1.02 | 1.02 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility (cm$^2$/Vs) | 35 | 35 | 37 | 30 | 29 | 37 | 31 | 37 |
| | | S value (V/decade) | 0.6 | 0.5 | 0.4 | 0.5 | 0.5 | 0.4 | 0.4 | 0.6 |
| | | Vth (V) | -0.9 | -0.7 | 1.3 | 1.6 | -0.6 | 1.6 | 0.9 | 1.0 |
| | | Leakage current (A) | < 1E-13 | < 1E-13 | < 1E-13 | < 1E-13 | < 1E-13 | < 1E-13 | < 1E-13 | < 1E-13 |
| | Reliability of TFT | PBTS ΔVth (V) | 0.8 | 1.1 | 1.3 | 0.9 | 0.4 | 0.6 | 0.5 | 0.9 |
| | | NBTS ΔVth (V) | -2.5 | -1.0 | 3.0 | -1.5 | -1.3 | -2.3 | -2.0 | -2.5 |
| | | Constant current stress ΔVth (V) | 0.7 | 0.9 | 0.7 | 0.7 | 0.8 | 0.5 | 0.6 | 0.9 |

EP 4 418 309 A1

118

| | | | Example 214 | Example 215 | Example 216 | Example 217 | Example 218 | Example 219 | Example 220 | Example 221 |
|---|---|---|---|---|---|---|---|---|---|---|
| Evaluation of channel layer after production of TFT | Cross-sectional TEM image | Average spacing D between crystal grain boundaries [μm] | 0.2 | 0.1 | 0.5 | 0.6 | 1.1 | 0.4 | 0.4 | 0.1 |
| | | FFT specific plane orientation ratio (%) | 90 | 70 | 70 | 70 | 70 | 80 | 70 | 90 |
| | | Average of ε | 1.05 | 1.01 | 1.01 | 1.04 | 1.05 | 1.05 | 1.05 | 1.06 |
| | | Crystal state | Columnar crystal | Columnar crystal | Columnar crystal | Columnar crystal | Columnar crystal | Columnar crystal | Columnar crystal | Columnar crystal |
| Performance of TFT | Characteristics of TFT | Saturation mobility (cm²/Vs) | 31 | 31 | 33 | 35 | 32 | 30 | 36 | 32 |
| | | S value (V/decade) | 0.5 | 0.4 | 0.4 | 0.4 | 0.4 | 0.6 | 0.5 | 0.6 |
| | | Vth (V) | 1.5 | 1.6 | 1.2 | -0.7 | -0.8 | -0.7 | 1.5 | 0.3 |
| | | Leakage current (A) | < 1E-13 | < 1E-13 | < 1E-13 | < 1E-13 | < 1E-13 | < 1E-13 | < 1E-13 | < 1E-13 |
| | Reliability of TFT | PBTS ΔVth (V) | 0.4 | 0.4 | 1.4 | 1.5 | 1.5 | 1.0 | 0.5 | 1.3 |
| | | NBTS ΔVth (V) | -2.3 | -1.7 | -2.6 | -1.9 | -1.1 | -2.0 | -1.6 | -2.2 |
| | | Constant current stress ΔVth (V) | 0.6 | 0.4 | 0.9 | 0.9 | 0.5 | 0.5 | 0.5 | 0.5 |

| | | | Example 222 | Example 223 | Example 224 | Example 225 |
|---|---|---|---|---|---|---|
| Evaluation of channel layer after production of TFT | Cross-sectional TEM image | Average spacing D between crystal grain boundaries [$\mu$m] | 1.8 | 0.9 | 1.4 | 0.1 |
| | | FFT specific plane orientation ratio (%) | 70 | 100 | 70 | 70 |
| | | Average of $\varepsilon$ | 1.02 | 1.06 | 1.04 | 1.05 |
| | | Crystal state | Columnar crystal | Columnar crystal | Columnar crystal | Columnar crystal |
| Performance ofTFT | Characteristics of TFT | Saturation mobility (cm$^2$/Vs) | 31 | 31 | 30 | 32 |
| | | S value (V/decade) | 0.4 | 0.4 | 0.6 | 0.6 |
| | | Vth (V) | 0.5 | 0.4 | -0.1 | 1.5 |
| | | Leakage current (A) | < 1E-13 | < 1E-13 | < 1E-13 | < 1E-13 |
| | Reliability of TFT | PBTS $\Delta$Vth (V) | 0.8 | 0.9 | 0.8 | 1.0 |
| | | NBTS $\Delta$Vth (V) | -1.1 | -1.3 | -2.4 | -2.9 |
| | | Constant current stress $\Delta$Vth (V) | 0.8 | 1.0 | 0.6 | 0.7 |

of a thin film transistor, for example, a channel layer. In addition, the thin film transistor of the present invention can be used in an electric circuit to be used in electric equipment, electronic equipment, a vehicle, or a power engine.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification and the specification of Japanese applications) on the basis of which the present application claims Paris convention priority are incorporated herein by reference in its entirety.

**Claims**

**1.** A crystalline oxide thin film, comprising In as a main component,
wherein 50% or more of Fourier transform images obtained by subjecting each of lattice images in a plurality of image regions extracted from a transmission electron microscope (TEM) image of a cross-section of the crystalline oxide thin film to two-dimensional Fourier transform (FFT) processing exhibit any one of plane orientations selected from (100), (110), (111), (211), (411), (125), (210), (310), and (320).

**2.** The crystalline oxide thin film according to claim 1,

wherein, in each of the Fourier transform images exhibiting any one of the plane orientations selected from (100), (110), (111), (211), (411), (125), (210), (310), and (320) acquired in the plurality of image regions,
when a size of a frequency region from central coordinates of the Fourier transform image of a reciprocal lattice point P1 selected from bright spots located on a coordinate axis extending from the central coordinates in a normal direction with respect to a principal surface of the crystalline oxide thin film is represented by an interplanar spacing d1 in the normal direction,
when a size of a frequency region from the central coordinates of the Fourier transform image of a reciprocal lattice point P2 selected from bright spots located on a coordinate axis extending from the central coordinates in a direction parallel to the principal surface of the crystalline oxide thin film is represented by an interplanar spacing d2 in a plane direction, and

when Miller indices of the reciprocal lattice point P1 are represented by $(h_1, k_1, l_1)$ and Miller indices of the reciprocal lattice point P2 are represented by $(h_2, k_2, l_2)$,

an average $\varepsilon_{aver}$ of each of lattice distortions $\varepsilon$ in the plurality of image regions calculated by the following formula (3) from a lattice constant "a" in the normal direction calculated by the following formula (1) and a lattice constant "b" in the plane direction calculated by the following formula (2) satisfies $1.0 < \varepsilon_{aver} < 1.1$.

$$\text{Lattice constant "a" in normal direction} = \sqrt{(h_1^2 + k_1^2 + h_1^2)} \times d1 \cdots \text{(Formula (1))}$$

$$\text{Lattice constant "b" in plane direction} = \sqrt{(h_2^2 + k_2^2 + h_2^2)} \times d2 \cdots \text{(Formula (2))}$$

$$\varepsilon = \frac{b}{a} \qquad \cdots \quad \text{(Formula (3))}$$

3. The crystalline oxide thin film according to claim 1 or 2, wherein the crystalline oxide thin film has a thickness of 3 nm or more and less than 50 nm.

4. The crystalline oxide thin film according to any one of claims 1 to 3, wherein the crystalline oxide thin film has a short-side length of less than 50 $\mu$m.

5. The crystalline oxide thin film according to any one of claims 1 to 4, wherein the crystalline oxide thin film has an average spacing D between crystal grain boundaries of 0.01 $\mu$m or more and 2 $\mu$m or less.

6. The crystalline oxide thin film according to any one of claims 1 to 5, wherein the crystalline oxide thin film comprises In in an amount of 62 at% or more.

7. The crystalline oxide thin film according to any one of claims 1 to 6, which further comprises one or more kinds of elements selected from the group consisting of H, B, C, N, O, F, Mg, Al, Si, O, S, Cl, Ar, Ca, Sc, Ti, V, Cr, Mn, Fe, Co, Ni, Cu, Zn, Ga, Ge, Y, Zr, Nb, Mo, Tc, Ru, Rh, Pd, Ag, Cd, Sn, Sb, Cs, Ba, Ln, Hf, Ta, W, Re, Os, Ir, Pt, Au, Pb, and Bi.

8. A method for producing the crystalline oxide thin film according to any one of claims 1 to 7, comprising subjecting an oxide thin film formed on a support to annealing treatment at a temperature of more than 300°C under an atmospheric atmosphere.

9. The method for producing the crystalline oxide thin film according to claim 8, wherein the oxide thin film subjected to the annealing treatment has a thickness of 3 nm or more and less than 50 nm.

10. The method for producing the crystalline oxide thin film according to claim 8 or 9, wherein the oxide thin film subjected to the annealing treatment has a short-side length of less than 50 $\mu$m.

11. A thin film transistor, comprising the crystalline oxide thin film according to any one of claims 1 to 7.

12. The thin film transistor according to claim 11,

wherein the thin film transistor comprises a buffer layer, and
a channel layer,
wherein the channel layer is the crystalline oxide thin film, and
wherein the thin film transistor comprises a gate insulating film and a gate electrode on a side opposite to the buffer layer when seen from the channel layer in this order from the channel layer side.

13. A method for producing the thin film transistor according to claim 11 or 12, comprising the steps of:

forming an oxide thin film on a substrate;

subjecting the oxide thin film to annealing treatment at a temperature of more than 300°C under an atmospheric atmosphere to form a crystalline oxide thin film; and

forming a gate insulating film and a gate electrode on the crystalline oxide thin film in this order.

14. The method for producing the thin film transistor according to claim 13, wherein the method comprises forming a buffer layer on the substrate, followed by formation of the oxide thin film on the buffer layer.

15. A method for producing the thin film transistor according to claim 11 or 12, comprising the steps of:

forming an oxide thin film on a substrate;
subjecting the oxide thin film to annealing treatment at a temperature of more than 300°C under an atmospheric atmosphere to form a crystalline oxide thin film; and
forming an interlayer insulating film on the crystalline oxide thin film in this order.

16. The method for producing the thin film transistor according to claim 15, wherein the method comprises forming a gate electrode and a gate insulating film on the substrate in this order, followed by formation of the oxide thin film on the gate insulating film.

Fig. 1

Fig. 2

Fig. 3

Fig. 4

Fig. 5

Fig. 6

**INTERNATIONAL SEARCH REPORT**

International application No.

**PCT/JP2022/038044**

### A. CLASSIFICATION OF SUBJECT MATTER

*H01L 21/363*(2006.01)i; *C23C 14/08*(2006.01)i; *H01L 21/20*(2006.01)i; *H01L 21/336*(2006.01)i; *H01L 21/66*(2006.01)i; *H01L 29/786*(2006.01)i
FI: H01L21/363; H01L29/78 627F; H01L21/20; C23C14/08 D; H01L29/78 620; H01L21/66 N; H01L29/78 618B

According to International Patent Classification (IPC) or to both national classification and IPC

### B. FIELDS SEARCHED

Minimum documentation searched (classification system followed by classification symbols)

H01L21/363; C23C14/08; H01L21/20; H01L21/336; H01L21/66; H01L29/786

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | KR 10-2021-0027580 A (IUCF HYU) 11 March 2021 (2021-03-11) paragraphs [0016]-[0032], fig. 1-3 | 1, 3-16 |
| A | | 2 |
| A | JP 2013-201211 A (SONY CORPORATION) 03 October 2013 (2013-10-03) | 1-16 |
| A | JP 09-282945 A (IDEMITSU KOSAN CO LTD) 31 October 1997 (1997-10-31) | 1-16 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 November 2022** | **22 November 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

<table>
<tr><td colspan="2" align="center">INTERNATIONAL SEARCH REPORT<br>Information on patent family members</td><td align="center">International application No.<br><br>**PCT/JP2022/038044**</td></tr>
</table>

| Patent document cited in search report | Publication date (day/month/year) | Patent family member(s) | Publication date (day/month/year) |
|---|---|---|---|
| KR 10-2021-0027580 A | 11 March 2021 | US 2021/0408290 A1 paragraphs [0029]-[0045], fig. 1-3 WO 2021/040183 A1 | |
| JP 2013-201211 A | 03 October 2013 | US 2013/0248852 A1 KR 10-2013-0108133 A CN 103325817 A TW 201340334 A | |
| JP 09-282945 A | 31 October 1997 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5491258 B
- JP 6853421 B